(19) Europäisches Patentamt
European Patent Office
Office européen des brevets

(11) EP 4 357 300 A1

(12) EUROPEAN PATENT APPLICATION
published in accordance with Art. 153(4) EPC

(43) Date of publication:
24.04.2024 Bulletin 2024/17

(21) Application number: 22824992.6

(22) Date of filing: 14.06.2022

(51) International Patent Classification (IPC):
*C01B 32/05* (2017.01)

(52) Cooperative Patent Classification (CPC):
C01B 32/05

(86) International application number:
PCT/JP2022/023764

(87) International publication number:
WO 2022/265004 (22.12.2022 Gazette 2022/51)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 14.06.2021 JP 2021098383

(71) Applicants:
- Nagoya Denki Educational Foundation
Aichi 464-8540 (JP)
- Atsumitec Co., Ltd.
Hamamatsu-shi, Shizuoka 433-8118 (JP)

(72) Inventors:
- ITOI, Hiroyuki
Toyota-shi, Aichi 470-0392 (JP)
- UCHIYAMA, Naoki
Hamamatsu-shi, Shizuoka 433-8118 (JP)

(74) Representative: Hoffmann Eitle
Patent- und Rechtsanwälte PartmbB
Arabellastraße 30
81925 München (DE)

# (54) METHOD FOR PRODUCING ZEOLITE-TEMPLATED CARBON MATERIAL USING CARBON PRECURSOR, PELLET COMPRISING SAME, AND METHOD FOR PRODUCING SAME

(57) Provided are: a method for easily producing a ZTC material, wherein in place of raw materials of conventional carbon materials, sugars such as glucose, and crosslinkable hydrocarbons such as DVB are used as a carbon source material; a pellet comprising a ZTC; and a method for producing the same. This method for producing a zeolite-templated carbon material is used, wherein the method involves introducing sugars or the like into a surface and pores of zeolite, and heating the same to carbonize the sugars, and then dissolving and removing the zeolite.

FIG. 17

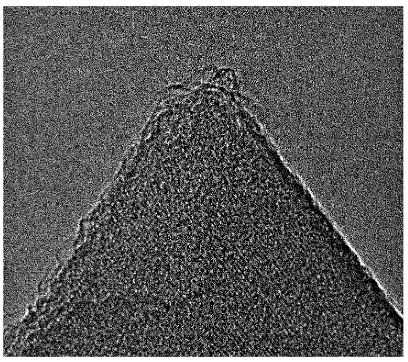



Processed by Luminess, 75001 PARIS (FR)

**Description**

TECHNICAL FIELD

The present invention relates to a novel method for producing a zeolite-templated carbon (hereinafter, abbreviated as "ZTC" in some cases) material having pores thereinside and a molecular-level three-dimensional structural regularity. More specifically, the present invention relates to a method for producing a ZTC having a high specific surface area from a material as a carbon source e.g. sugars such as glucose and crosslinkable hydrocarbons such as divinylbenzene (hereinafter, referred to as "DVB" in some cases) by a practical process, as well as a pellet containing this ZTC, and a method for producing the pellet.

BACKGROUND ART

The ZTC produced using zeolite as a template can be used for various applications because of its high specific surface area. In this circumstance, first, KNOX et al. have synthesized a carbon filler for chromatography using a template procedure with a porous glass or silica gel (e.g. see Patent Literature 1).

After that, various materials have also been investigated, and there have been attempts to produce porous carbon materials using Y type zeolite as a template (e.g. see Patent Literature 2 and Non-Patent Literature 1).

Patent Literature 2 discloses that a porous carbon material having a three-dimensional long-periodic structural regularity in nano-order was synthesized using Na-Y type zeolite.

As a synthesis method thereof, a dry Na-Y type zeolite powder was impregnated with a furfuryl alcohol, which was heated at 150°C to polymerize the furfuryl alcohol that had infiltrated into the pores of the zeolite. A resulting zeolite-furfuryl alcohol polymer composite was carbonized. Then, propylene was caused to flow through a reaction tube using $N_2$ gas as a carrier gas, which was subjected to a vapor phase carbonization at 700°C for 4 hours so that carbon was deposited in the pores of the zeolite-furfuryl alcohol carbide composite, which was heated under $N_2$ gas stream to obtain a zeolite-carbon composite. Furthermore, the produced zeolite-carbon composite was treated with hydrofluoric acid and hydrochloric acid to dissolve and remove zeolite, and only carbon was extracted.

In this method, any diffraction was not found from a 002 plane where 2$\theta$ particular to carbon was at around 25° (CuK$\alpha$) in a measurement using a powder X-ray diffractometer, instead, a sharp peak was observed at around 6°C, a peak at around 10 to 50 ppm indicating the presence of a chain shape carbon compound was not observed in a 13C-solid-NMR, and the carbon material was proven to have no two-dimensional structural regularity. When the pores of the obtained carbon material were examined, a Brunauer-Emmett-Teller (BET) specific surface area was 3600 $m^2$/g, a volume occupied by micropores was 1. 52 $cm^3$/g, and a volume occupied by mesopores was 0. 05 $cm^3$/g.

Non-Patent Document 1 discloses the following steps.

1) To prepare a polyfurfuryl alcohol (PFA)/zeolite composite, Y type zeolite was dried, the zeolite is impregnated with furfuryl alcohol and washed with mesitylene, and then the furfuryl alcohol is polymerized.
2) To prepare a carbon/zeolite composite, PFA is carbonized at 700°C, through which propylene is caused to flow at 700°C, which is heated.
3) To prepare a ZTC, the carbon/zeolite composite is treated with hydrogen fluoride (HF) to dissolve the zeolite, then filtered and washed, and vacuum-dried.

These methods are considered to be standard methods as ZTC synthesis methods, but the methods have the following problems to be improved.

(1) Although the zeolite powder was impregnated with furfuryl alcohol and the furfuryl alcohol was polymerized, a more practical material is desired in view of economical efficiency of furfuryl alcohol.
(2) It is not practical that the zeolite powder is impregnated with furfuryl alcohol and then washed with expensive mesitylene, and a more practical method is desired.
(3) When the zeolite powder is impregnated with furfuryl alcohol and washed with mesitylene, mesitylene as well as the remaining furfuryl alcohol become waste liquids. A large number of steps and a high cost are required for discarding the waste liquids.
(4) At least two polymerization reactions are required because, after the carbonization of the PFA/zeolite composite, a polymerizable monomer such as propylene is caused to flow through the composite and then heated to obtain the carbon/zeolite composite. Furthermore, it is necessary to control each of the steps described above because the carbon/zeolite composite must be treated with HF to dissolve the zeolite.

Thus, in the conventional methods aforementioned as examples, it is needed to reduce the cost of materials

and the cost of waste liquid discard, or the like, and therefore demands of practical ZTS synthesis steps and practical raw materials are increasing.

CITATION LIST

Patent Literature

Patent Literature 1: US Patent No. 4263268
Patent Literature 2: Japanese Patent Laid-Open No. 2003-206112

Non-Patent Literature

Non -Patent Literature 1: Takashi Kyotani et al., "Synthesis of Nano-Carbons by Using the Template Method", TANSO, 2008, No. 2351, pp. 307-315

DISCLOSURE OF INVENTION

PROBLEMS TO BE SOLVED BY THE INVENTION

An object of the present invention is to provide a method for producing a zeolite-templated carbon (ZTC) material by a practical process, as well as a pellet containing this ZTC, and a method for producing the pellet. More specifically, an object of the present invention is to provide a method for easily producing a ZTC material using sugars such as glucose as conventional raw materials of carbon materials, and a crosslinkable hydrocarbon such as DVB as carbon source materials, as well as a pellet containing the ZTC and a method for producing the pellet.

MEANS FOR SOLVING THE PROBLEMS

As intensive studies on optimal synthesis conditions for a porous carbon material in view of the above circumstances, the present inventors have found the followings.

(1) A conventionally used zeolite is used as a template.
(2) As the first treatment, an organic matter (sugar) such as glucose is introduced and adsorbed to a surface of zeolite and the inside of pores of zeolite, the resulting zeolite is heated to carbonize the organic matter.
(3) If necessary, propylene is caused to flow through a carbon/zeolite composite 1 having the carbonized organic matter, the composite is heated to obtain a carbon/zeolite composite 2.
(4) Subsequently, as the next treatment, the zeolite as the template is removed while maintaining the structure of the carbonized organic matter to produce a zeolite-templated carbon (ZTC) material that has a nano-level structural regularity reflecting a shape of the pores of the zeolite to be used as the template, and pores reflecting the shape of the zeolite, and does not have any two-dimensional lamination regularity of carbon.
(5) When the carbon/zeolite composite 1 is obtained, a crosslinkable hydrocarbon such as DVB is used as a carbon source instead of the sugar, and then the carbon/zeolite composite 2 is obtained, so that a zeolite-templated carbon (ZTC) material can be eventually produced.

The above findings have completed the present invention.
That is, the present invention relates to the following aspects.

[1] A method for producing a zeolite-templated carbon material, in which a sugar is introduced onto a surface of and into pores of a zeolite, the resulting zeolite is heated to carbonize the sugar, and then the zeolite is dissolved and removed.
[2] A method for producing a zeolite-templated carbon material, in which a crosslinkable hydrocarbon is introduced onto a surface of and into pores of a zeolite and polymerized, and then the zeolite is dissolved and removed.
[3] The method according to [1], in which the sugar is a monosaccharide, a disaccharide, or a polysaccharide.
[4] The method according to [1], in which the sugar is glucose, xylose, fructose, sucrose, cellulose, or starch.
[5] The method according to [1], in which the zeolite is Y type zeolite or X type zeolite.
[6] The method according to [1], in which the zeolite is dissolved with an acid.
[7] The method according to [1], in which the sugar is introduced onto the surface of and into the pores of the zeolite

as a template, the resulting zeolite is heated to carbonize the sugar, to which an unsaturated hydrocarbon is introduced to cause vapor phase carbonization of the sugar, and the zeolite is dissolved and removed.

[8] The method according to [2], in which a crosslinkable hydrocarbon is introduced onto the surface of and into the pores of the zeolite as the template, to which the unsaturated hydrocarbon is introduced and polymerized, and then the zeolite is dissolved and removed.

[9] The method according to [1], in which the zeolite is put into a container and then dried, the sugar is added to the container to introduce the sugar onto the surface of and into the pores of the dried zeolite.

[10] The method according to [1], in which the sugar is carbonized by heating the zeolite at 80°C to 200°C.

[11] The method according to [1], in which a polymerizable hydrocarbon is introduced to the zeolite having the carbonized sugar to cause vapor phase carbonization of the sugar at 600°C to 900°C.

[12] The method according to [1], in which an acid is added to the carbonized sugar and the zeolite as the template to dissolve and remove the zeolite.

[13] The method according to [1], in which the polymerizable hydrocarbon is introduced to the zeolite having the carbonized sugar, and an acid is added to the vapor phase-carbonized product and the zeolite as the template to dissolve and remove the zeolite.

[14] A pellet containing a zeolite-templated carbon material, which is obtained by a process in which a sugar is introduced onto a surface of and into pores of a zeolite, the resulting zeolite is heated to carbonize the sugar, then the zeolite is dissolved and removed, and the sugar is dried and then pressurized to pelletize the sugar.

[15] A pellet containing a zeolite-templated carbon material, which is obtained by a process in which a crosslinkable hydrocarbon is introduced onto a surface of and into pores of a zeolite and polymerized, then the zeolite is dissolved and removed, the hydrocarbon is dried and then pressurized to pelletize the hydrocarbon.

[16] A method for producing the pellet containing the zeolite-templated carbon material according to [14], in which a sugar is introduced onto a surface of and into pores of a zeolite, the resulting zeolite is heated to carbonize the sugar, then the zeolite is dissolved and removed, and the sugar is dried and then pressurized to pelletize the sugar.

[17] A method for producing a pellet containing a zeolite-templated carbon material, in which a crosslinkable hydrocarbon is introduced onto a surface of and into pores of a zeolite and polymerized, then the zeolite is dissolved and removed, the hydrocarbon is dried and then pressurized to pelletize the hydrocarbon.

The present invention will be explained below in more detail.

<Method for Producing Zeolite-Templated Carbon Material>

The present invention relates to a method for producing a zeolite-templated carbon material, in which a sugar is introduced onto a surface of and into pores of a zeolite, the resulting zeolite is heated to carbonize the sugar, then the zeolite is dissolved and removed.

Furthermore, the present invention relates to a method for producing a zeolite-templated carbon material, in which the sugar is a monosaccharide, a disaccharide, or a polysaccharide.

Examples of the sugar used in the production method according to the present invention include monosaccharides, disaccharides, oligosaccharides such as tri- or more saccharides, and polysaccharides. Hereinafter, oligosaccharides and polysaccharides are collectively referred to as polysaccharides in some cases.

Regarding the number of carbon atoms constituting the sugar, triose, tetraose, pentose, hexose, and heptose are used, and above all, hexose is preferable.

The present invention relates to a method for producing a zeolite-templated carbon material, in which the sugar introduced onto the surface of and into the pores of the zeolite is a monosaccharide.

Among the sugars used in the production method according to the present invention, various monosaccharides as presented in the following structures can be used.

[Formula 1]

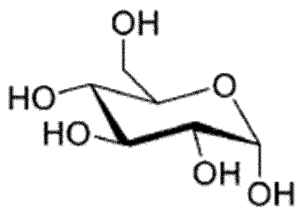

β-D-glucose

[Formula 2]

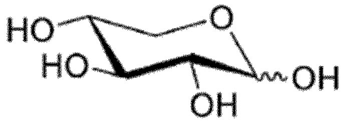

D-(+)-xylose

[Formula 3]

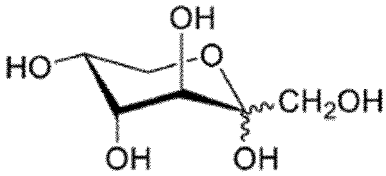

D-(-)-fructose

Specific examples of the hexose include psicose (allulose), fructose, sorbose, tagatose, allose, altrose, glucose, mannose, gulose, idose, galactose, talose, xylose, N-acetylglucosamine, glucosamine, and glucosamine hydrochloride. Above all, fructose, glucose and xylose are preferably used. When, among these monosaccharides, glucose is taken as an example, even glucose having a different structure such as an α-D-glucose and a β-D-glucose can be used.

The present invention relates to the method for producing the zeolite-templated carbon material, in which the sugar to be introduced onto the surface of and into the pores of the zeolite is a disaccharide.

Among the sugars used in the production method according to the present invention, various disaccharides as presented in the following structure can be used.

[Formula 4]

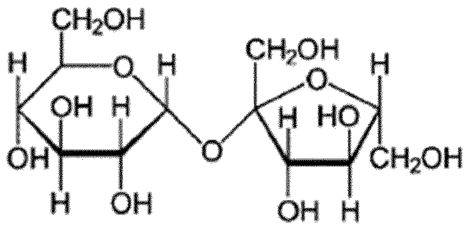

D-sucrose

Examples of the disaccharides include sucrose, lactose, maltose, trehalose, turanose, and cellobiose. Above all, sucrose is preferably used.

The present invention relates to the method for producing the zeolite-templated carbon material, in which the polysaccharide is starch or cellulose.

Among the sugars used in the production method according to the present invention, various polysaccharides as presented in the following structures can be used.

[Formula 5]

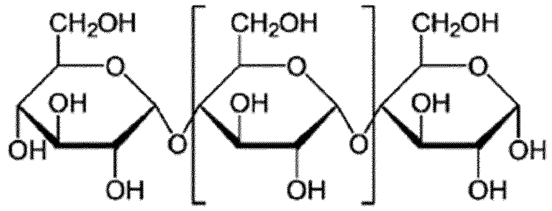

starch

[Formula 6]

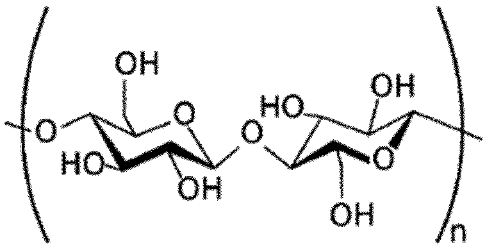

cellulose

Specific examples of the trisaccharide include raffinose, melezitose, and maltotriose. Specific examples of the tetrasaccharide include acarbose and stachyose. Specific examples of other oligosaccharides include fructooligosaccharide (FOS), galactooligosaccharide (GOS), mannan-oligosaccharide (MOS), and lactosucrose. Specific examples of the polysaccharide include glucose-derived glycogen, starch (amylose-amylopectin), cellulose, dextrin, glucan ($\beta$1,3-glucan), fructose-derived fructan (inulin-levan $\beta 2 \rightarrow 6$), N-acetylglucosamine-derived chitin, and chitosan. Above all, starch and cellulose are preferably used.

Also, the present invention relates to the method for producing the zeolite-templated carbon material, in which a crosslinkable hydrocarbon is introduced onto a surface of and into pores of a zeolite and polymerized, and then the zeolite is dissolved and removed.

Herein, the crosslinkable hydrocarbon is a compound having a plurality of polymerizable groups such as carbon-carbon double bonds (C=C), e.g. an aromatic hydrocarbon such as divinylbenzene (DVB), and an acyclic hydrocarbon having 4 to 20 carbon atoms such as 1,3-butadiene (C=C-C=C).

The present invention relates to the method for producing the zeolite-templated carbon material, in which the zeolite is a Y type zeolite or an X type zeolite.

The zeolite used in the production method according to the present invention may be either a synthetic zeolite or a natural zeolite, and above all, a zeolite having a large pore diameter is preferably used.

Specific examples of the synthetic zeolite include Y type zeolite, X type zeolite, A type zeolite, $\beta$ (beta) type zeolite, ZSM-5, ferrierite, mordenite, and L type zeolite. Above all, Y type zeolite and X type zeolite that have a large pore diameter are preferably used. Examples of positive ions in these zeolites include K (potassium), Na (sodium), Ca (calcium), Li (lithium), hydrogen, and ammonium. Above all, Na (sodium) is preferably used as the positive ions (exchanger cations).

A natural zeolite can also be used without particular limitation, but a natural zeolite having a large pore diameter is preferably used like the synthetic zeolite.

The present invention relates to the method for producing the zeolite-templated carbon material, in which the zeolite is dissolved with an acid or an alkali.

As an agent for dissolving the zeolite used in the production method according to the present invention, both acids and alkalis can be used without limitation. Among them, it is preferable to use an acid, and more preferable to use hydrochloric acid and hydrogen fluoride. Particularly, hydrogen fluoride is preferable.

The present invention relates to the method for producing the zeolite-templated carbon material, in which a sugar is introduced onto the surface of and into the pores of the zeolite as a template, the resulting zeolite is heated to carbonize the sugar, to which a polymerizable hydrocarbon is introduced to cause vapor phase carbonization of the sugar, and the zeolite is dissolved and removed.

The unsaturated hydrocarbon used in the production method according to the present invention is not particularly limited as long as it is a compound that has one or a plurality of carbon-carbon double bonds (C=C) between carbons and can be vapor phase-polymerized, such as ethylene, propylene, acetylene, and divinylbenzene. Above all, propylene

is preferably used.

In the production method according to the present invention, as the first treatment, a carbon material such as a sugar (hereinafter, also referred to as "sugar or the like" in some cases) is introduced into pores of a zeolite, the zeolite is heated e.g. at 80°C to 200°C, preferably 100°C to 150°C to carbonize the introduced sugar or the like through polymerization or decomposition. Then, an acid or the like is added to the zeolite containing the carbonized sugar to dissolve the zeolite, so that a ZTC can be obtained from the remaining carbides.

If necessary, as the next treatment after the carbonization of the sugar or the like through polymerization or decomposition, a gaseous polymerizable hydrocarbon is introduced to the zeolite and heated to e.g. 600°C to 900°C, preferably 650°C to 800°C to cause vapor phase carbonization of the sugar or the like, to which an acid or the like is added to dissolve the zeolite, so that a ZTC can be obtained from the remaining carbides.

The present invention relates to the method for producing the zeolite-templated carbon material, in which a zeolite is put into a container and then dried, a sugar or the like are added to the container to introduce the sugar or the like onto the surface of and into the pores of the dried zeolite.

In the production method according to the present invention, first, a zeolite is dried in a container, a sugar or the like such as glucose is added to the container containing the dried zeolite, which is heated at a predetermined temperature to carbonize the sugar or the like.

Herein, the reason why the zeolite is dried is because a large amount of water is adsorbed to an untreated zeolite, particularly in its pores, which may affect the production method according to the present invention, and therefore the zeolite should be dried to remove or minimize water. The drying method is not particularly limited, and it is preferable that the zeolite is introduced into a sealable container, then, if necessary, heated at 80°C to 200°C, preferably 100°C to 150°C, and dried under reduced pressure preferably close to vacuum.

In the case of vacuum drying or reduced-pressure drying, the container for containing the zeolite is preferably a sealable container. In producing the ZTC, it is preferable that the container is not molten or destroyed in a series of steps from charging of the materials, through drying, heating, decomposition or polymerization of the sugar, carbonization, and dissolution with an acid, to washing. If necessary, for each step, or for a step requiring a container, a container suitable for the step should be used. Examples of the container include a glass container and a glass-lined container.

In the production method according to the present invention, although the amount of the sugar or the like to be used cannot be commonly determined because the sugar amount varies depending on an amount of the ZTC to be finally produced, the sugar amount may be 0.5 time to 100 times by weight, more preferably 1 time (equivalent amount) to 20 times by weight, particularly preferably 1.5 time to 10 times by weight, based on the amount of the zeolite to be used.

The present invention relates to the method for producing the zeolite-templated carbon material, in which the sugar or the like is carbonized by heating at 80°C to 200°C.

As a first treatment, a sugar or the like is introduced into the zeolite pores, and the zeolite is heated e.g. at 80°C to 200°C, preferably 100°C to 150°C to carbonize the introduced sugar or the like through polymerization or decomposition.

In the production method according to the present invention, although a duration of carbonization of the sugar through polymerization or decomposition cannot be commonly determined because the duration varies depending on the heating temperature, the duration of carbonization may be e.g. 1 hour to 10 days, preferably 10 hours to 5 days, more preferably 20 hours to 2 days.

The present invention relates to the method for producing the zeolite-templated carbon material, in which a polymerizable hydrocarbon is introduced to the zeolite having the carbonized sugar or the like to cause vapor phase carbonization of the sugar at 600°C to 900°C.

In the production method according to the present invention, the sugar or the like is carbonized through polymerization or decomposition, then a gaseous polymerizable hydrocarbon is introduced to the zeolite, the zeolite is heated to e.g. 600°C to 900°C, preferably 650°C to 800°C to cause vapor phase carbonization of the sugar or the like, to which an acid or the like is added to dissolve the zeolite, so that a ZTC can be obtained from the remaining carbides.

A duration of the vapor phase carbonization may be 30 minutes to 1 day, preferably 1 hour to 10 hours, more preferably 2 hours to 5 hours.

The present invention relates to the method for producing the zeolite-templated carbon material, in which an acid or an alkali is added to the carbonized sugar or the like and the zeolite as the template to dissolve and remove the zeolite.

In the production method according to the present invention, only the zeolite is removed from the carbonized sugar or the like and the zeolite as the template, so that a desired ZTC can be obtained.

To a container containing the carbonized sugar or the like and the zeolite as the template, an acid or an alkali capable of dissolving the zeolite, preferably an acid such as hydrochloric acid and hydrogen fluoride is added to dissolve the zeolite, which is subjected to solid-liquid separation such as filtration and centrifugation to obtain a solid carbonized sugar i.e. a ZTC. If necessary, the resulting ZTC can be washed and dried by a generally known method.

The present invention relates to the method for producing the zeolite-templated carbon material, in which a

polymerizable hydrocarbon is introduced to the zeolite having the carbonized sugar or the like, and an acid is added to the vapor phase-carbonized product and the zeolite as the template to dissolve and remove the zeolite.

In the production method according to the present invention, a polymerizable hydrocarbon is introduced to the zeolite having the carbonized sugar or the like to remove only the zeolite from the vapor phase-carbonized product and the zeolite as the template, so that a desired ZTC can be obtained.

A polymerizable hydrocarbon is introduced to the zeolite having the carbonized sugar or the like, and an acid or an alkali capable of dissolving the zeolite, preferably an acid such as hydrochloric acid and hydrogen fluoride is added to a container containing the vapor phase-carbonized product and the zeolite as the template to dissolve the zeolite, which is subjected to solid-liquid separation such as filtration and centrifugation to obtain a solid carbonized sugar or the like i.e. a ZTC. If necessary, the resulting ZTC can be washed and dried by a generally known method.

The present invention relates to a zeolite-templated carbon material, which is obtained by a process in which a sugar or the like is introduced onto a surface of and into pores of a zeolite, the resulting zeolite is heated to carbonize the sugar or the like, and then the zeolite is dissolved and removed.

The present invention relates to a method for producing a zeolite-templated carbon (ZTC) material by a novel and practical process, in which the carbon material is obtained not by a process of polymerizing a polymerizable compound (monomer) conventionally used, but by a process of adsorbing, to a zeolite, a sugar or the like as a base that is a raw material not conventionally known, and heating the zeolite.

Herein, when using a material made of a raw material completely different from that of the conventional material, the obtained carbon material shows the same characteristic as of the conventional material, e.g. the same measurement result of an X-ray diffraction method (XRD) but shows a structure in which many carbons are connected, and therefore it is not easy to substantially grasp a fine environment.

Thus, as described above, it is practical that the raw material and the production process are predetermined to define the carbon material to be obtained.

Also, the present invention relates to a zeolite-templated carbon material obtained by a process in which a crosslinkable hydrocarbon is introduced onto the surface of and into the pores of the zeolite and polymerized, and then the zeolite is dissolved and removed.

The present invention relates to a method for producing a zeolite-templated carbon (ZTC) material by using not only the sugar but also a crosslinkable hydrocarbon such as divinylbenzene. The obtained carbon material is substantially the same as the material obtained with the sugar in that both of them are carbon materials obtained using the zeolite as the template. For analysis and the like of the material, a conventionally known method can be used as described above.

The present invention relates to a pellet containing a zeolite-templated carbon material, which is obtained by a process in which a sugar or the like is introduced onto a surface of and into pores of a zeolite, the resulting zeolite is heated to carbonize the sugar or the like, then the zeolite is dissolved and removed, the sugar or the like is dried and then pressurized to pelletize the sugar or the like.

The present invention is expected to be used for applications different from powders, e.g. a hydrogen storage carrier, a battery material, and a catalyst, by a novel and practical method in which a zeolite-templated carbon (ZTC) material as a base is pressurized so as to be pelletized.

The present invention relates to the pellet containing the zeolite-templated carbon material, which is obtained by a process in which a crosslinkable hydrocarbon is introduced onto the surface of and into the pores of the zeolite and polymerized, then the zeolite is dissolved and removed, and the crosslinkable hydrocarbon is dried and then pressurized to pelletize the crosslinkable hydrocarbon.

The present invention is expected to be used for applications different from powders, e.g. a hydrogen storage carrier, a battery material, and a catalyst, by a process in which, besides the sugar, a crosslinkable hydrocarbon such as divinylbenzene is used to produce a zeolite-templated carbon (ZTC) material, the ZTC material is pressurized to so as to be pelletized in the same manner as for the sugar as the raw material.

The present invention relates to a method for producing a pellet containing a zeolite-templated carbon material, in which a sugar or the like is introduced onto a surface of and into pores of a zeolite, the resulting zeolite is heated to carbonize the sugar, then the zeolite is dissolved and removed, and the sugar is dried and then pressurized to pelletize the sugar.

The present invention relates to the method for producing the pellet containing a zeolite-templated carbon material, in which a crosslinkable hydrocarbon is introduced onto the surface of and into the pores of the zeolite and polymerized, then the zeolite is dissolved and removed, and the crosslinkable hydrocarbon is dried and then pressurized to pelletize the crosslinkable hydrocarbon.

In this way, the present invention provides a novel and practical method, in which a zeolite-templated carbon (ZTC) material as a base is pressurized to pelletize the ZTC material.

As the pelletizing method, the ZTC material is pelletized by applying a pressure of 50 kN (Newton, 377 MPa) to 100 kN (Newton, 753 MPa), preferably 50 kN to 70 kN to the ZTC material using a tabletting machine described in

Examples below. Other examples of the method include a method in which a binder and a granulation aid are added to a powder as necessary, the mixture is sufficiently kneaded and then molded using a granulator or the like, i.e. rolling granulation, extrusion granulation, spray granulation, flow granulation, and compression granulation.

A size and shape of the pellet may be appropriately selected depending on an intended purpose. For example, in a case of pelletizing with a tableting machine, the pellet may have a volume of about 0. 05 $cm^3$ to 10 $cm^3$, more preferably about 0. 1 $cm^3$ to 1 $cm^3$, and a thickness of about 0. 1 mm to 10 mm, more preferably about 0. 2 mm to 5 mm. In a case of granulation, for example, the pellet may have a particle diameter of preferably about 0. 1 mm to 5 mm, more preferably about 0. 5 mm to 2 mm.

EFFECT OF THE INVENTION

The method for producing the ZTC material according to the present invention makes it possible to provide a novel three-dimensional ZTC material having a nano-level structural regularity reflecting the shape of the pores of the ZTC material used as a template and pores reflecting the shape of the porous material.

The carbon material having both the nano-level structural regularity and the porosity is expected to be applied to: an electrode material of a capacitor or a lithium ion battery as a device for converting electric energy into chemical energy and storing the chemical energy; a material for storing a high-value-added gas represented by hydrogen, methane, or the like; as well as a matrix of a novel composite material; an electroconductive material; a carbon film; and the like.

It is advantageous that such a ZTC material can be simply synthesized using a sugar or the like as a raw material in that the range of selection of various industrial materials can be expanded and performance of a product may be dramatically improved.

BRIEF DESCRIPTION OF DRAWINGS

FIG. 1 is a diagram illustrating an example of a device for polymerizing a monomer on Na-Y type zeolite by a heat treatment of propylene chemical vapor deposition (CVD).

FIG. 2 is a diagram presenting an example of a temperature management program in a HF treatment.

FIG. 3 is a diagram presenting a result of an X-ray diffraction (XRD) device measurement of ZTC samples obtained varying a polymerization duration of divinylbenzene (DVB), in which the abscissa (X-axis) indicates a diffraction angle 2$\theta$ (unit: ° (degree)) of CuK$\alpha$ ray, and the ordinate (Y-axis) indicates an intensity (unit: optional).

FIG. 4 is a diagram presenting a result of an XRD device measurement of ZTC samples obtained varying an adsorption duration of DVB onto Na-Y type zeolite, in which the abscissa (X-axis) indicates a diffraction angle 2$\theta$ (unit: ° (degree)) of CuK$\alpha$ ray, and the ordinate (Y-axis) indicates an intensity (unit: optional).

FIG. 5 is a diagram presenting a result of an XRD device measurement of ZTC samples obtained with small times the amount of DVB, in which the abscissa (X-axis) indicates a diffraction angle 2$\theta$ (unit: ° (degree)) of CuK$\alpha$ ray, and the ordinate (Y-axis) indicates an intensity (unit: optional).

FIG. 6 is a diagram presenting a result of an XRD device measurement of ZTC samples obtained with large times the amount of DVB, in which the abscissa (X-axis) indicates a diffraction angle 2$\theta$ (unit: ° (degree)) of CuK$\alpha$ ray, and the ordinate (Y-axis) indicates an intensity (unit: optional).

FIG. 7 is a diagram illustrating an example of a device for vacuum heat drying of Na-Y type zeolite in an oil bath.

FIG. 8 is a diagram presenting a result of an XRD device measurement of ZTC samples obtained varying a polymerization temperature, in which the abscissa (X-axis) indicates a diffraction angle 2$\theta$ (unit: ° (degree)) of CuK$\alpha$ ray, and the ordinate (Y-axis) indicates an intensity (unit: optional). An enlarged measurement data is presented on the upper side in each measurement data, and the lowermost measurement data is measurement data with Na-Y type zeolite as a control.

FIG. 9 is a diagram presenting a result of a nitrogen adsorption/desorption isothermal line measurement of ZTC samples obtained varying a polymerization temperature, in which the abscissa (X-axis) indicates a relative pressure (P/PO), and the ordinate (Y-axis) indicates a volume adsorbed (unit: $cm^3$ (standard temperature and pressure: STP)/g).

FIG. 10 is a diagram presenting a result of a pore diameter distribution measurement of ZTC samples obtained varying a polymerization temperature according to Density Functional Theory (DFT) method, in which the abscissa (X-axis) indicates a pore diameter (unit: nm), and the ordinate (Y-axis) indicates an incremental pore volume (unit: $cm^3$/g).

FIG. 11 is a diagram presenting a result of an XRD device measurement of ZTC samples obtained varying mixing conditions of $\alpha$-D-glucose and a heat treatment (polymerization) temperature, in which the abscissa (X-axis) indicates a diffraction angle 2$\theta$ (unit: ° (degree)) of CuK$\alpha$ ray, and the ordinate (Y-axis) indicates an intensity (unit: optional).

An enlarged measurement data is presented on the upper side in each measurement data, and the lowermost measurement data is measurement data with NaY type zeolite as a control.

FIG. 12 is a diagram presenting a result of an XRD device measurement of ZTC samples obtained varying mixing conditions of α-D-glucose and a heat treatment (polymerization) temperature, in which the abscissa (X-axis) indicates a diffraction angle 2θ (unit: ° (degree)) of CuKα ray, and the ordinate (Y-axis) indicates an intensity (unit: optional). The upper measurement data is an enlarged measurement data.

FIG. 13 is a diagram presenting a result of an XRD device measurement of ZTC samples obtained varying an amount (low multiplying amount) of α-D-glucose, in which the abscissa (X-axis) indicates a diffraction angle 2θ (unit: ° (degree)) of CuKα ray, and the ordinate (Y-axis) indicates an intensity (unit: optional).

FIG. 14 is a diagram presenting a result of an XRD device measurement of ZTC samples obtained varying the amount (high multiplying amount) of α-D-glucose, in which the abscissa (X-axis) indicates a diffraction angle 2θ (unit: ° (degree)) of CuKα ray, and the ordinate (Y-axis) indicates an intensity (unit: optional).

FIG. 15 is a diagram presenting a result of an XRD device measurement of ZTC samples obtained varying the amount (high multiplying amount) of α-D-glucose, in which the abscissa (X-axis) indicates a diffraction angle 2θ (unit: ° (degree)) of CuKα ray, and the ordinate (Y-axis) indicates an intensity (unit: optional). The upper measurement data is an enlarged measurement data.

FIG. 16 is a SEM (scanning electron microscope) photograph of No. 7 (a sample obtained by a process in which α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours).

FIG. 17 shows a transmission electron microscope (TEM) photograph of No. 7 (a sample obtained by a process in which α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours).

FIG. 18 is a diagram presenting a result of a thermo-gravimetry (TG) measurement of a mixed powder of sample No. 30, in which the abscissa (X-axis) indicates time (unit: minutes (min)), the left side of the ordinate (Y-axis) indicates temperature (unit: °C), and the right side of the ordinate (Y-axis) indicates weight (unit: wt%).

FIG. 19 is a diagram presenting a result of an XRD device measurement of ZTC samples obtained with 1.0 time the amount of β-D-Glc, cellulose, sucrose, and fructose, in which the abscissa (X-axis) indicates a diffraction angle 2θ (unit: ° (degree)) of CuKα ray, and the ordinate (Y-axis) indicates an intensity (unit: optional).

FIG. 20 is a diagram presenting a result of an XRD device measurement of ZTC samples obtained with 1.0 time the amount of β-D-Glc, cellulose, sucrose, and fructose, in which the abscissa (X-axis) indicates a diffraction angle 2θ (unit: ° (degree)) of CuKα ray, and the ordinate (Y-axis) indicates an intensity (unit: optional).

FIG. 21 is a diagram presenting a result of an XRD device measurement of ZTC samples obtained with 1.0 time the amount of β-D-Glc, cellulose, sucrose, and fructose, in which the abscissa (X-axis) indicates a diffraction angle 2θ (unit: ° (degree)) of CuKα ray, and the ordinate (Y-axis) indicates an intensity (unit: optional).

FIG. 22 is a diagram presenting a result of an XRD device measurement of ZTC samples obtained with 1.0 time and 1.5 time the amount of β-D-Glc, in which the abscissa (X-axis) indicates a diffraction angle 2θ (unit: ° (degree)) of CuKα ray, and the ordinate (Y-axis) indicates an intensity (unit: optional).

FIG. 23 is a diagram presenting a result of an XRD device measurement of ZTC samples obtained with 1.0 time and 1.5 time the amount of β-D-Glc, in which the abscissa (X-axis) indicates a diffraction angle 2θ (unit: ° (degree)) of CuKα ray, and the ordinate (Y-axis) indicates an intensity (unit: optional).

FIG. 24 is a diagram presenting a result of an XRD device measurement of ZTC samples obtained with 1.0 time and 1.5 time the amount of β-D-Glc, in which the abscissa (X-axis) indicates a diffraction angle 2θ (unit: ° (degree)) of CuKα ray, and the ordinate (Y-axis) indicates an intensity (unit: optional).

FIG. 25 is a diagram presenting a result of an XRD device measurement of ZTC samples obtained with 1.0 time and 1.5 time the amount of cellulose, in which the abscissa (X-axis) indicates a diffraction angle 2θ (unit: ° (degree)) of CuKα ray, and the ordinate (Y-axis) indicates an intensity (unit: optional).

FIG. 26 is a diagram presenting a result of an XRD device measurement of ZTC samples obtained with 1.0 time and 1.5 time the amount of cellulose, in which the abscissa (X-axis) indicates a diffraction angle 2θ (unit: ° (degree)) of CuKα ray, and the ordinate (Y-axis) indicates an intensity (unit: optional).

FIG. 27 is a diagram presenting a result of an XRD device measurement of ZTC samples obtained with 1.0 time and 1.5 time the amount of cellulose, in which the abscissa (X-axis) indicates a diffraction angle 2θ (unit: ° (degree)) of CuKα ray, and the ordinate (Y-axis) indicates an intensity (unit: optional).

FIG. 28 is a diagram presenting a result of an XRD device measurement of ZTC samples obtained with 1.0 time and 1.5 time the amount of D-(+)-sucrose, in which the abscissa (X-axis) indicates a diffraction angle 2θ (unit: ° (degree)) of CuKα ray, and the ordinate (Y-axis) indicates an intensity (unit: optional).

FIG. 29 is a diagram presenting a result of an XRD device measurement of ZTC samples obtained with 1.0 time and 1.5 time the amount of D-(+)-sucrose, in which the abscissa (X-axis) indicates a diffraction angle 2θ (unit: ° (degree)) of CuKα ray, and the ordinate (Y-axis) indicates an intensity (unit: optional).

FIG. 30 is a diagram presenting a result of an XRD device measurement of ZTC samples obtained with 1.0 time and 1.5 time the amount of D-(+)-sucrose, in which the abscissa (X-axis) indicates a diffraction angle 2θ (unit: ° (degree)) of CuKα ray, and the ordinate (Y-axis) indicates an intensity (unit: optional).

FIG. 31 is a diagram presenting a result of an XRD device measurement of ZTC samples obtained with 1.0 time and 1.5 time the amount of fructose, in which the abscissa (X-axis) indicates a diffraction angle 2θ (unit: ° (degree)) of CuKα ray, and the ordinate (Y-axis) indicates an intensity (unit: optional).

FIG. 32 is a diagram presenting a result of an XRD device measurement of ZTC samples obtained with 1.0 time and 1.5 time the amount of fructose, in which the abscissa (X-axis) indicates a diffraction angle 2θ (unit: ° (degree)) of CuKα ray, and the ordinate (Y-axis) indicates an intensity (unit: optional).

FIG. 33 is a diagram presenting a result of an XRD device measurement of ZTC samples obtained with 1.0 time and 1.5 time the amount of fructose, in which the abscissa (X-axis) indicates a diffraction angle 2θ (unit: ° (degree)) of CuKα ray, and the ordinate (Y-axis) indicates an intensity (unit: optional).

FIG. 34 is a diagram illustrating a condition (program) for vacuum heat drying of Na-Y type zeolite in ZTC synthesis using starch.

FIG. 35 is a diagram presenting a result of an XRD device measurement of ZTC samples obtained with 1.0 time, 1.5 time, and 2.0 times the amount of starch, in which the abscissa (X-axis) indicates a diffraction angle 2θ (unit: ° (degree)) of CuKα ray, and the ordinate (Y-axis) indicates an intensity (unit: optional).

FIG. 36 is a diagram illustrating an example of a tabletting machine for preparing pellets.

FIG. 37 is a diagram presenting transitions in water content in each step of pellet preparation, in which the abscissa (X-axis) indicates each step and the ordinate (Y-axis) indicates the water content (unit: mg).

FIG. 38 is a diagram presenting a result of an XRD device measurement of various samples as pellets treated with HF, in which the abscissa (X-axis) indicates a diffraction angle 2θ (unit: ° (degree)) of CuKα ray, and the ordinate (Y-axis) indicates an intensity (unit: optional).

FIG. 39 is a diagram presenting a result of an XRD device measurement of various samples as pellets treated with HF, in which the abscissa (X-axis) indicates a diffraction angle 2θ (unit: ° (degree)) of CuKα ray, and the ordinate (Y-axis) indicates an intensity (unit: optional).

FIG. 40 is a diagram presenting a result of an XRD device measurement of various samples as pellets treated with HF, in which the abscissa (X-axis) indicates a diffraction angle 2θ (unit: ° (degree)) of CuKα ray, and the ordinate (Y-axis) indicates an intensity (unit: optional).

FIG. 41 is a diagram presenting a result of an XRD device measurement of various samples as pellets treated with HF, in which the abscissa (X-axis) indicates a diffraction angle 2θ (unit: ° (degree)) of CuKα ray, and the ordinate (Y-axis) indicates an intensity (unit: optional).

FIG. 42 is a diagram presenting a result of an XRD device measurement of various samples as pellets treated with HF, in which the abscissa (X-axis) indicates a diffraction angle 2θ (unit: ° (degree)) of CuKα ray, and the ordinate (Y-axis) indicates an intensity (unit: optional).

FIG. 43 is a diagram presenting a result of an XRD device measurement of various samples as pellets treated with HF, in which the abscissa (X-axis) indicates a diffraction angle 2θ (unit: ° (degree)) of CuKα ray, and the ordinate (Y-axis) indicates an intensity (unit: optional).

FIG. 44 is a diagram presenting a result of an XRD device measurement of ZTC samples obtained varying an amount (multiplying amount) of α-D-glucose relative to an amount of Na-Y type zeolite, in which the abscissa (X-axis) indicates a diffraction angle 2θ (unit: ° (degree)) of CuKα ray, and the ordinate (Y-axis) indicates an intensity (unit: optional).

FIG. 45 is an enlarged view of FIG. 44, showing a measurement result at a diffraction angle 2θ of around 6.4°.

FIG. 46 is a diagram presenting a result of a nitrogen adsorption/desorption isothermal line measurement of ZTC samples, in which the abscissa (X-axis) indicates P/PO, and the ordinate (Y-axis) indicates a volume adsorbed (unit: $cm^3$ (STP)/g).

FIG. 47 is a diagram presenting a result of a pore diameter distribution measurement of ZTC samples according to DFT method, in which the abscissa (X-axis) indicates a pore diameter (unit: nm), and the ordinate (Y-axis) indicates an incremental pore volume (unit: $cm^3/g$).

FIG. 48 is a diagram presenting a result of a nitrogen adsorption/desorption measurement (BET surface area) of ZTC samples and a result of a TG measurement of a zeolite/carbon composite, in which the abscissa (X-axis) indicates an amount of α-D-glucose, and the left side of the ordinate (Y-axis) indicates a carbon fraction (unit: g/gNaY), and the right side of the ordinate (Y-axis) indicates a BET surface area (unit: m2/g).

FIG. 49-1 is a TEM photograph of a ZTC sample with α-Glu (1.0)-P (1.0 time the amount of α-D-glucose was used).

FIG. 49-2 is a TEM photograph of a ZTC sample with α-Glu (1.4)-P (1.4 time the amount of α-D-glucose was used).

FIG. 50 is a diagram illustrating a presumed ZTC formation mechanism.

FIG. 51 is a diagram presenting a result of an XRD device measurement of ZTC samples obtained varying an amount (multiplying amount) of β-D-glucose relative to an amount of Na-Y type zeolite on the left side of the diagram,

in which the abscissa (X-axis) indicates a diffraction angle 2θ (unit: ° (degree)) of CuKα ray, and the ordinate (Y-axis) indicates an intensity (unit: optional). The right side of the diagram is an enlarged graph showing a measurement result at a diffraction angle 2θ of around 6.4°.

FIG. 52 is a diagram presenting a result of an XRD device measurement of ZTC samples obtained varying an amount (multiplying amount) of D-xylose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of the diagram is an enlarged graph showing a measurement result at a diffraction angle 2θ of around 6.4°.

FIG. 53 is a diagram presenting a result of an XRD device measurement of ZTC samples obtained varying an amount (multiplying amount) of pulverized D-fructose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of the diagram is an enlarged graph showing a measurement result at a diffraction angle 2θ of around 6.4°.

FIG. 54 is a diagram presenting a result of an XRD device measurement of ZTC samples obtained varying an amount (multiplying amount) of pulverized D-sucrose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of the diagram is an enlarged graph showing a measurement result at a diffraction angle 2θ of around 6.4°.

FIG. 55 is a diagram presenting a result of a nitrogen adsorption/desorption isothermal line measurement of ZTC samples obtained using various sugars presented in the diagram, in which the abscissa (X-axis) indicates P/PO, and the ordinate (Y-axis) indicates a volume adsorbed (unit: $cm^3$ (STP)/g).

FIG. 56 is a diagram presenting a result of a pore diameter distribution measurement of ZTC samples obtained using various sugars presented in the diagram according to DFT method, in which the abscissa (X-axis) indicates a pore diameter (unit: nm), and the ordinate (Y-axis) indicates an incremental pore volume (unit: $cm^3$/g).

FIG. 57-1 is a SEM photograph of a sample with α-D-glucose.

FIG. 57-2 is a SEM photograph of a sample with β-D-glucose.

FIG. 57-3 is a SEM photograph of a sample with D-xylose.

FIG. 57-4 is a SEM photograph of a sample with D-fructose.

FIG. 57-5 is a SEM photograph of a sample with pulverized D-fructose.

FIG. 57-6 is an SEM photograph of a sample with D-sucrose.

FIG. 57-7 is an SEM photograph of a sample with pulverized D-sucrose.

FIG. 58 is a diagram presenting a result of Raman spectroscopy analysis of ZTC samples synthesized using α-D-glucose, in which the abscissa (X-axis) indicates Raman shift (unit: $cm^{-1}$), and the ordinate (Y-axis) indicates an intensity (unit: optional).

FIG. 59 is a diagram presenting a result of Raman spectroscopy analysis of ZTC samples synthesized using 1.0 time the amount of sugars presented in the diagram, in which the abscissa (X-axis) indicates Raman shift (unit: $cm^{-1}$), and the ordinate (Y-axis) indicates an intensity (unit: optional).

FIG. 60-1 is a diagram presenting a result of an XRD device measurement of ZTC samples obtained varying an amount (multiplying amount) of pre-pulverization D-fructose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of the diagram is an enlarged graph showing a measurement result at a diffraction angle 2θ of around 6.4°.

FIG. 60-2 is a diagram presenting a result of an XRD device measurement of ZTC samples obtained using previously-pulverized D-fructose on the left side of the diagram, in which the abscissa (X-axis) indicates a diffraction angle 2θ (unit: ° (degree)) of CuKα ray, and the ordinate (Y-axis) indicates an intensity (unit: optional). The right side of the diagram is an enlarged graph showing a measurement result at a diffraction angle 2θ of around 6.4°.

FIG. 61-1 is a diagram presenting a result of an XRD device measurement of ZTC samples obtained varying an amount (multiplying amount) of pre-pulverization D-sucrose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional); The right side of the diagram is an enlarged graph showing a measurement result at a diffraction angle 2θ of around 6.4°.

FIG. 61-2 is a diagram presenting a result of an XRD device measurement of ZTC samples obtained using previously-pulverized D-sucrose on the left side of the diagram, in which the abscissa (X-axis) indicates a diffraction angle 2θ (unit: ° (degree)) of CuKα ray, and the ordinate (Y-axis) indicates an intensity (unit: optional). The right side of the diagram is an enlarged graph showing a measurement result at a diffraction angle 2θ of around 6.4°.

FIG. 62 is a diagram presenting a result of a nitrogen adsorption/desorption isothermal line measurement of ZTC samples obtained by using pulverized fructose (denoted as "After pulverization") and non-pulverized fructose (denoted as "No pulverization") on Na-Y type zeolite, in which the abscissa (X-axis) indicates P/PO and the ordinate

(Y-axis) indicates a volume adsorbed (unit: $cm^3$ (STP)/g).

FIG. 63 is a diagram presenting a result of a pore diameter distribution measurement of ZTC samples obtained by using pulverized fructose (denoted as "After pulverization") and non-pulverized fructose (denoted as "No pulverization") on Na-Y type zeolite according to DFT method, in which the abscissa (X-axis) indicates a pore diameter (unit: nm) and the ordinate (Y-axis) indicates an incremental pore volume (unit: $cm^3/g$).

FIG. 64 is a diagram presenting a result of a nitrogen adsorption/desorption isothermal line measurement of ZTC samples obtained varying amounts of pulverized D-sucrose (denoted as "After pulverization") and non-pulverized D-sucrose (denoted as "No pulverization") relative to an amount of Na-Y type zeolite, in which the abscissa (X-axis) indicates P/PO and the ordinate (Y-axis) indicates a volume adsorbed (unit: $cm^3$ (STP)/g).

FIG. 65 is a diagram presenting a result of a pore diameter distribution measurement of ZTC samples obtained varying amounts of pulverized D-sucrose (denoted as "After pulverization") and non-pulverized D-sucrose (denoted as "No pulverization") relative to an amount of Na-Y type zeolite according to DFT method, in which the abscissa (X-axis) indicates a pore diameter (unit: nm) and the ordinate (Y-axis) indicates an incremental pore volume (unit: $cm^3/g$).

FIG. 66 is a diagram presenting a result of a thermo-gravimetry/differential thermal analysis (TG-DTA) simultaneous measurement of NaY zeolite and α-D-glucose, in which the abscissa (X-axis) indicates a temperature (unit: °C), the left side of the ordinate (Y-axis) indicates a DTA (unit: mV/g), and the right side indicates a weight (unit: %).

FIG. 67 is a diagram presenting a result of a TG-DTA simultaneous measurement of a mixture of NaY zeolite and α-D-glucose, in which the abscissa (X-axis) indicates a temperature (unit: °C), the left side of the ordinate (Y-axis) indicates a DTA (unit: mV/g), and the right side indicates a weight (unit: %).

FIG. 68 is a diagram presenting a result of a TG-DTA simultaneous measurement of samples, in which the abscissa (X-axis) indicates a temperature (unit: °C), the left side of the ordinate (Y-axis) indicates a DTA (unit: mV/g), and the right side indicates a weight (unit: %). The diagram presents measurement results of NaY zeolite and α-D-glucose in FIG. 66 and the mixture of NaY zeolite and α-D-glucose in FIG. 67 (amount of α-D-glucose used in the mixture is 1.0 time the amount). A Gaussian function simulating an exothermic peak that emerges when α-D-glucose is adsorbed to NaY zeolite is used. In FIG. 68, NaY type zeolite and α-D-glucose on the left side of the ordinate, the peak intensity of the Gaussian function (left side of the ordinate), and the abscissa (position) are changed to fit them (denoted as "Fitting") so that the fitted result coincides with the experimental result (denoted as "Data").

FIG. 69 is a diagram presenting a result of a nitrogen adsorption/desorption isothermal line measurement of samples obtained by treating a mixture of NaY type zeolite and α-D-glucose at 200°C, 300°C, and 400°C, in which the abscissa (X-axis) indicates P/PO and the ordinate (Y-axis) indicates a volume adsorbed (unit: $cm^3$ (STP)/g).

FIG. 70 is a diagram presenting a result of a TG-DTA simultaneous measurement of samples containing only various sugars presented in the diagram, in which the abscissa (X-axis) indicates a temperature (unit: °C), the left side of the ordinate (Y-axis) indicates a DTA (unit: mV/g), and the right side indicates a weight (unit: %).

FIG. 71 is a diagram presenting a result of a TG-DTA simultaneous measurement of NaY type zeolite, β-D-glucose, and a sample of a mixture of NaY type zeolite and β-D-glucose (amount of β-D-glucose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when β-D-glucose is adsorbed to NaY type zeolite is presented. The NaY type zeolite and β-D-glucose, the peak intensity of the Gaussian function (left side of the ordinate), and the position (abscissa) are changed to fit them (denoted as "Fit") so that the fitted result coincides with the experimental result (denoted as "Data").

FIG. 72 is a diagram presenting a result of a TG-DTA simultaneous measurement of NaY type zeolite, D-xylose, and a sample of a mixture of NaY type zeolite and D-xylose (amount of D-xylose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when D-xylose is adsorbed to NaY type zeolite is presented. The NaY type zeolite and D-xylose, the peak intensity of the Gaussian function (left side of the ordinate), and the position (abscissa) are changed to fit them (denoted as "Fit") so that the fitted result coincides with the experimental result (denoted as "Data").

FIG. 73-1 is a diagram presenting a result of a TG-DTA simultaneous measurement of NaY type zeolite, D-sucrose (non-pulverized), and a sample of a mixture of NaY type zeolite and D-sucrose (non-pulverized) (amount of D-sucrose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when D-sucrose is adsorbed to NaY type zeolite is presented. The NaY type zeolite and D-xylose, the peak intensity of the Gaussian function (left side of the ordinate), and the position (abscissa) are changed to fit them (denoted as "Fit") so that the fitted result coincides with the experimental result (denoted as "Data").

FIG. 73-2 is a diagram presenting a result of a TG-DTA simultaneous measurement of NaY type zeolite, D-sucrose

(after pulverization), and a sample of a mixture of NaY type zeolite and D-sucrose (after pulverization) (amount of D-sucrose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when D-sucrose is adsorbed to NaY type zeolite is presented. The NaY type zeolite and D-xylose, the peak intensity of the Gaussian function (left side of the ordinate), and the position (abscissa) are changed to fit them (denoted as "Fit") so that the fitted result coincides with the experimental result (denoted as "Data").

FIG. 74-1 is a diagram presenting a result of a TG-DTA simultaneous measurement of NaY type zeolite, D-fructose (before pulverization), and a sample of a mixture of NaY type zeolite and D-fructose (before pulverization) (amount of D-fructose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when D-fructose is adsorbed to NaY type zeolite is added. The NaY type zeolite and D-fructose, the peak intensity of the Gaussian function (left side of the ordinate), and the position (abscissa) are changed to fit them (denoted as "Fit") so that the fitted result coincides with the experimental result (denoted as "Data").

FIG. 74-2 is a diagram presenting a result of a TG-DTA simultaneous measurement of NaY type zeolite, D-fructose (after pulverization), and a sample of a mixture of NaY type zeolite and D-fructose (after pulverization) (amount of D-fructose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when D-fructose is adsorbed to NaY type zeolite is added. The NaY type zeolite and D-fructose, the peak intensity of the Gaussian function (left side of the ordinate), and the position (abscissa) are changed to fit them (denoted as "Fit") so that the fitted result coincides with the experimental result (denoted as "Data").

FIG. 75 is a diagram presenting a result of a nitrogen adsorption/desorption isothermal line measurement of samples obtained by heating the NaY type zeolite and various sugars presented in the diagram at 300°C, in which the abscissa (X-axis) indicates P/PO and the ordinate (Y-axis) indicates a volume adsorbed (unit: $cm^3$ (STP)/g).

FIG. 76-1 is an SEM photograph of a starch sample.

FIG. 76-2 is an SEM photograph of a starch sample.

FIG. 77-1 is an SEM photograph of a cellulose sample.

FIG. 77-2 is an SEM photograph of a cellulose sample.

FIG. 78 is a diagram presenting a result of an XRD device measurement of ZTC samples obtained varying an amount (multiplying amount) of S (sugar: starch) relative to an amount of Na-Y type zeolite, in which the abscissa (X-axis) indicates a diffraction angle 2$\theta$ (unit: ° (degree)) of CuK$\alpha$ ray, and the ordinate (Y-axis) indicates an intensity (unit: optional). FIG. 79 is an enlarged graph showing a measurement result with the diffraction angle 2$\theta$ of around 6.4°.

FIG. 79 is an enlarged graph showing a measurement result with the diffraction angle 2$\theta$ of around 6.4° in FIG. 78.

FIG. 80 is a diagram presenting a result of a nitrogen adsorption/desorption isothermal line measurement of ZTC samples obtained varying an amount (multiplying amount) of S (sugar: starch), in which the abscissa (X-axis) indicates P/PO and the ordinate (Y-axis) indicates a volume adsorbed (unit: $cm^3$ (STP)/g).

FIG. 81 is a diagram presenting a result of a pore diameter distribution measurement of ZTC samples obtained varying an amount (multiplying amount) of S (sugar: starch) according to DFT method, in which the abscissa (X-axis) indicates a pore diameter (unit: nm) and the ordinate (Y-axis) indicates an incremental pore volume (unit: $cm^3$/g).

FIG. 82 is a diagram presenting a result of an XRD device measurement of ZTC samples obtained varying an amount (multiplying amount) of C (cellulose) relative to an amount of Na-Y type zeolite, in which the abscissa (X-axis) indicates a diffraction angle 2$\theta$ (unit: ° (degree)) of CuK$\alpha$ ray, and the ordinate (Y-axis) indicates an intensity (unit: optional).

FIG. 83 is an enlarged graph showing a measurement result with the diffraction angle 2$\theta$ of around 6.4° in FIG. 82.

FIG. 84 is a diagram presenting a result of a nitrogen adsorption/desorption isothermal line measurement of ZTC samples obtained varying an amount (multiplying amount) of C (cellulose), in which the abscissa (X-axis) indicates P/PO and the ordinate (Y-axis) indicates a volume adsorbed (unit: $cm^3$ (STP)/g).

FIG. 85 is a diagram presenting a result of a pore diameter distribution measurement of ZTC samples obtained varying an amount (multiplying amount) of C (cellulose) according to DFT method, in which the abscissa (X-axis) indicates a pore diameter (unit: nm) and the ordinate (Y-axis) indicates an incremental pore volume (unit: $cm^3$/g).

FIG. 86 is a diagram presenting a result of a nitrogen adsorption/desorption measurement (BET specific surface area) of each ZTC sample and a result of a TG measurement of a zeolite/carbon composite (carbon fraction (g/g)) in a starch system, in which the abscissa (X-axis) indicates an amount of the sugar (starch), and the left side of the ordinate (Y-axis) indicates a carbon fraction (unit: g/gNaY), and the right side indicates a BET surface area (unit: $m^2$/g).

FIG. 87 is a diagram presenting a result of a nitrogen adsorption/desorption measurement (BET specific surface area) of each ZTC sample and a result of a TG measurement of a zeolite/carbon composite (carbon fraction (g/g))

in a cellulose system, in which the abscissa (X-axis) indicates an amount of the sugar (cellulose), and the left side of the ordinate (Y-axis) indicates a carbon fraction (unit: g/gNaY), and the right side indicates a BET surface area (unit: $m^2/g$).

FIG. 88-1 is a TEM photograph of a ZTC sample with cellulose (1.0)-P (1.0 time the amount of cellulose is used).

FIG. 88-2 is a TEM photograph of a ZTC sample with cellulose (1.8)-P (1.8 time the amount of cellulose is used).

FIG. 89 is a diagram presenting a result of a TG-DTA simultaneous measurement of NaY type zeolite, starch, and cellulose, in which the abscissa (X-axis) indicates a temperature (unit: °C), the left side of the ordinate (Y-axis) indicates a DTA (unit: mV/g), and the right side indicates a weight (unit: %).

FIG. 90 is a diagram presenting a result of a TG-DTA simultaneous measurement of NaY type zeolite, starch, and a sample of a mixture of NaY type zeolite and starch (amount of starch: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when the sugar produced by decomposition of starch is adsorbed to NaY type zeolite is presented. The NaY type zeolite and starch, the peak intensity of the Gaussian function (left side of the ordinate), and the position (abscissa) are changed to fit them (denoted as "Fit") so that the fitted result coincides with the experimental result (denoted as "Data").

FIG. 91 is a diagram presenting a result of a TG-DTA simultaneous measurement of NaY type zeolite, cellulose, and a sample of a mixture of NaY type zeolite and cellulose (amount of cellulose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when the sugar produced by decomposition of cellulose is adsorbed to NaY type zeolite is presented. The NaY type zeolite and starch, the peak intensity of the Gaussian function (left side of the ordinate), and the position (abscissa) are changed to fit them (denoted as "Fit") so that the fitted result coincides with the experimental result (denoted as "Data").

FIG. 92 is a diagram presenting a result of a nitrogen adsorption/desorption isothermal line measurement of samples obtained by treating a mixture of NaY type zeolite and 1.0 time the amount of S (starch) at 300°C, 350°C, and 400°C, in which the abscissa (X-axis) indicates P/PO and the ordinate (Y-axis) indicates a volume adsorbed (unit: $cm^3$ (STP)/g). As a comparative sample, a result of NaY type zeolite is also presented.

FIG. 93 is a diagram presenting a result of an XRD device measurement of ZTC samples obtained varying a drying manner of S (starch) on NaY type zeolite, in which the abscissa (X-axis) indicates a diffraction angle $2\theta$ (unit: ° (degree)) of CuK$\alpha$ ray, and the ordinate (Y-axis) indicates an intensity (unit: optional). In the diagram, the bottom line (denoted as S (1.0)-P (NaY 500 mg)) is of a ZTC synthesized by combining 1.0 time the amount of starch and propylene CVD using 500 mg of undried NaY type zeolite according to a typical operation. The second line from the bottom (denoted as S (1.0)-P (NaY is undried)) is of a ZTC synthesized by combining 1.0 time the amount of starch and propylene CVD using 15 g of undried NaY type zeolite. The third line from the bottom (denoted as S (1.0)-P (NaY is previously dried)) is of a ZTC synthesized by combining 1.0 time the amount of starch and propylene CVD using 15 g of dried NaY type zeolite. The top line (denoted as S (1.0)-P (NaY and starch are previously dried)) is of a ZTC synthesized by combining 1.0 time the amount of dried starch and propylene CVD using 15 g of undried NaY type zeolite.

FIG. 94 is an enlarged graph showing a measurement result with the diffraction angle $2\theta$ of around 6.4° in FIG. 93.

FIG. 95 is a diagram presenting a result of a TG-DTA simultaneous measurement of NaY type zeolite, starch, and cellulose, in which the abscissa (X-axis) indicates a temperature (unit: °C), the left side of the ordinate (Y-axis) indicates a DTA (unit: mV/g), and the right side indicates a weight (unit: %).

FIG. 96 is a diagram presenting a result of a TG-DTA simultaneous measurement of NaY type zeolite, starch, and a sample of a mixture of NaY type zeolite and starch (amount of starch: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when the sugar produced by decomposition of starch is adsorbed to NaY type zeolite is presented. The NaY type zeolite and starch, the peak intensity of the Gaussian function (left side of the ordinate), and the position (abscissa) are changed to fit them (denoted as "Fit") so that the fitted result coincides with the experimental result (denoted as "Data").

FIG. 97 is a diagram presenting a result of a TG-DTA simultaneous measurement of NaY type zeolite, cellulose, and a sample of a mixture of NaY type zeolite and cellulose (amount of cellulose: 1.0 time the amount), in which the abscissa (X-axis) indicates a temperature (unit: °C), the left side of the ordinate (Y-axis) indicates a DTA (unit: mV/g), and the right side indicates a weight (unit: %). In addition to this result, a Gaussian function simulating an exothermic peak that emerges when the sugar produced by decomposition of cellulose is adsorbed to NaY type zeolite is presented. The NaY type zeolite and starch, the peak intensity of the Gaussian function (left side of the ordinate), and the position (abscissa) are changed to fit them (denoted as "Fit") so that the fitted result coincides

with the experimental result (denoted as "Data").

FIG. 98 is a diagram presenting a result of a nitrogen adsorption/desorption isothermal line measurement of samples obtained by treating a mixture of NaY type zeolite and 1.0 time the amount of S (starch) at 300°C, 350°C, and 400°C, in which the abscissa (X-axis) indicates P/PO and the ordinate (Y-axis) indicates a volume adsorbed (unit: $cm^3$ (STP)/g). As a comparative sample, a result of NaY type zeolite is also presented.

FIG. 99 is a diagram presenting a result of a nitrogen adsorption/desorption isothermal line measurement of samples obtained by treating a mixture of NaY type zeolite and 1.0 time the amount of C (cellulose) at 350°C, 400°C, and 450°C, in which the abscissa (X-axis) indicates P/PO and the ordinate (Y-axis) indicates a volume adsorbed (unit: $cm^3$ (STP)/g). As a comparative sample, a result of NaY type zeolite is also presented. In the present description and figures, "sugar-(X)-P" (X indicates the amount of sugar) and the like are expressed as sample notations. Herein, "-P" expresses that propylene CVD was performed, and even if this explanation is not described in each of Examples and Figures, "-P" has the same meaning. Furthermore, in the present invention, NaY type zeolite, a sugar, and propylene are required to increase the structural regularity and the surface area of the ZTC. The sugar and propylene are carbon sources, and propylene is caused to flow through an electric furnace during CVD.

## DESCRIPTION OF EMBODIMENTS

As the specific examples of the present invention, Examples will be described below. However, the scope of the present invention is not limited to Examples in any way.

In Examples, the following appliances and methods were used.

### Example 1 <ZTC Synthesis Using Divinylbenzene>

In Examples below, a formulation of a ZTC obtained by polymerizing divinylbenzene using Na-Y type zeolite as a template and further polymerizing propylene will be described.

This formulation was appropriately applied to the method for producing the ZTC using sugars according to the present invention.

### A. Vacuum Heat Drying of Na-Y Type Zeolite

- · A total weight of a rubber stopper and a 10 ml vial equipped with the rubber stopper was measured.
- · About 500 mg of Na-Y type zeolite was weighed out as a pre-drying weight and put into the vial that had been previously weighed, which was sealed with the rubber stopper.
- · A total weight was weighed by an electronic balance.
- · Vacuum heat drying was performed.
- · The total weight after the vacuum heat drying was weighed by the electronic balance, and a dry weight of Na-Y type zeolite was calculated.

Each of the following drying methods was used depending on the number of the vials. That means, when a large amount of zeolite to be used as a template was dried at a time, a vacuum heat drying chamber was used. In these drying methods, their temperaturerising rate and temperature-retaining duration were under the same condition.

- · Vacuum heat drying using an oil bath
- · Vacuum heat drying using a vacuum drying chamber

### Vacuum Heat Drying of Na-Y Type Zeolite by Oil Bath Heating

- · A glass container equipped with a three-way cock was connected to a gas line to perform three vacuations and three $N_2$ (nitrogen gas) introductions through the gas line.
- · The glass stopper was opened under $N_2$ stream, and the vial containing Na-Y type zeolite was placed in the glass container.
- · The rubber stopper attached to the vial was removed using tweezers.
- · The glass container equipped with the three-way cock containing the vial was vacuumed to perform a vacuum heat drying using an oil bath according to the following program.

Vacuum Heat Drying of Na-Y Type Zeolite by Heating in Vacuum Drying Chamber

· The vial containing Na-Y type zeolite was uncapped and set in a drying chamber.
· A trap was attached to an oil pump such that water did not enter, and the trap was inserted into a Dewar flask.
· The vacuum drying chamber was vacuumed to perform vacuum heat drying using an oil bath according to the following program.

B. Adsorption and Polymerization of Monomer on Na-Y Type Zeolite

· The vial containing dried Na-Y type zeolite was transferred into a glass container equipped with a three-way cock under $N_2$ stream, and the rubber stopper was removed.
· Then, an appropriate amount of a monomer was weighed out and transferred to a vial containing NaY which had been dried under nitrogen stream.
· Subsequently, a rubber stopper was attached to the vial in the glass container equipped with a three-way cock under nitrogen stream, and the vial was taken out from the glass container.
· The mixture was stirred for 1 min (1 minute) using a rotating and revolving mixer under the following condition. The setting condition was a standard (STD) mode, and the stirring mode was set at a revolution speed of 2000 rpm.

Calculation of Weight of Monomer to be Put into Vial · The appropriate amount of the monomer means an amount that just fills the pore volume of Na-Y type zeolite.

$$\text{Weight (g) of 1 time the amount of the monomer relative to 1 g of Na-Y type zeolite} = 0.3642\ \text{cm}^3 \text{ x monomer density } (\text{g/cm}^3).$$

Under a condition that the amount of Na-Y type zeolite is represented by X g, X g can be calculated by the following equation.

$$\text{Weight (g) of 1 time the amount of the monomer relative to the amount X g of Na-Y type zeolite} = \text{weight (g) of Na-Y type zeolite} \times 0.3642\ \text{cm}^3 \times \text{monomer density } (\text{g/cm}^3).$$

Adsorption/Polymerization of Monomer on Na-Y Type Zeolite

- The vial containing the monomer was put into a thermostatic bath at 40°C and preserved for a predetermined time so that the monomer was adsorbed to Na-Y type zeolite.
- Subsequently, the vial was transferred to a thermostatic bath at a predetermined temperature and held for a predetermined time to polymerize the monomer in the pores of Na-Y type zeolite.

C. Heat Treatment by Propylene CVD

· Na-Y type zeolite (denoted as "NaY" in the diagram) with the polymerized monomer was placed on a quartz board illustrated in FIG. 1.
· The quartz board on which the sample had been placed was set at center of a gold horizontal furnace.
· All gas valves were opened and the system was vacuumed. Then, $N_2$ was purged.
· In FIG. 1, propylene CVD can be performed for 2 hours, e.g. under a condition of an $N_2$ flow rate of 912 cc/mm, a

propylene ($C_3H_6$) flow rate of 38 cc/mm, and a temperature of 700°C.

· Subsequently, nitrogen was allowed to flow to discharge air within the furnace. Then, CVD and heat treatment were performed under an exemplary program condition presented in FIG. 2.

· More specifically, as an exemplary condition, $N_2$ is allowed to flow through the furnace for 1 hour, and then propylene is allowed to flow through the furnace while raising the temperature to 700°C in 10 minutes and maintaining the temperature for 2 hours, followed by a heat treatment in which the temperature is raised to 900°C in about 1 hour and maintained for 3 hours, and, after the heat treatment, the heating is stopped.

D. HF Treatment

· A stirring bar and HF were put into a polytetrafluoroethylene (PTFE) beaker. Subsequently, the Na-Y type zeolite/ZTC composite was added to the beaker little by little and stirred for 5 h.

· The composite was vacuum-filtered using a plastic filtration device.

· After the filtration, the sample was transferred to a petri dish and subjected to vacuum heat drying using a vacuum drying chamber.

· For the above steps, the program in FIG. 2 can be used as an example of the temperature management.

Example 2 <Result of ZTC Synthesis Using Divinylbenzene>

Carbon yields after HF treatment are presented in Table 1 below. In Table 1, a weight percentage (wt%) of the ZTC was measured for each of samples obtained varying a polymerization duration of DVB. The weight percentage of the ZTC was calculated from a change in the weight between before and after the HF treatment.

[Table 1]

| Weight Percentage of ZTC<br>Carbon yield after HF treatment | |
|---|---|
| Sample No. | ZTC (% by weight) |
| No. 343 | 20.1 |
| No. 344 | 20.9 |
| No. 345 | 21.2 |
| No. 346 | 21.4 |

In Table 1, the treatment condition of each sample No. is as follows.

No. 343; DVB was polymerized for 1 hour, then subjected to propylene CVD at 700°C for 2 hours, and heated at 900°C for 3 hours.

No. 344; DVB was polymerized for 3 hours, then subjected to propylene CVD at 700°C for 2 hours, and heated at 900°C for 3 hours.

No. 345; DVB was polymerized for 6 hours, then subjected to propylene CVD at 700°C for 2 hours, and heated at 900°C for 3 hours.

No. 346; DVB was polymerized for 24 hours, then subjected to propylene CVD at 700°C for 2 hours, and heated at 900°C for 3 hours.

As can be seen from Table 1, there was a tendency that the longer the DVB polymerization duration was, the higher the ZTC weight percentage was. Compared to the ZTC weight percentage of 1-hour polymerization duration, the ZTC weight percentages of 6-hour and 24-hour polymerization durations showed little change, and therefore it was presumed that the polymerization reaction was substantially saturated.

XRD Measurement

The ZTC samples obtained varying the polymerization duration of DVB as described above were subjected to an XRD device measurement, and the result was presented in FIG. 3.

In FIG. 3, the treatment condition of each sample presenting XRD data is as follows.

1: No. 1 ZTC; DVB was polymerized for 24 hours, then subjected to propylene CVD at 700°C for 2 hours, and heated at 900°C for 3 hours.
2: No. 4 ZTC; DVB was polymerized for 6 hours, then subjected to propylene CVD at 700°C for 2 hours, and heated at 900°C for 3 hours.
3: No. 3 ZTC; DVB was polymerized for 3 hours, then subjected to propylene CVD at 700°C for 2 hours, and heated at 900°C for 3 hours.
4: No. 2 ZTC; DVB was polymerized for 1 hours, then subjected to propylene CVD at 700°C for 2 hours, and heated at 900°C for 3 hours.
5: No. 66-1 ZTC; DVB was polymerized for 24 hours, then subjected to propylene CVD at 700°C for 2 hours, and heated at 900°C for 3 hours.

As presented in FIG. 3, all samples i.e. samples of 1, 3, 6, and 24-hour polymerization durations showed a sharp peak (unit of the peak intensity is optional) attributed to structural transfer of Na-Y type zeolite at around 6° of XRD angle 2$\theta$ (attributed to CuK$\alpha$ ray) value. In the diagram, the chart denoted as NaY is based on Na-Y type zeolite, and a portion at around 6° is marked for referring to this characteristic peak.

Example 3 <Result of Study on Adsorption Condition for DVB>

Carbon yields after HF treatment are presented in Table 2 below. In Table 2, a weight percentage (wt%) of the ZTC was measured for each of samples obtained varying an adsorption duration of DVB. The weight percentage of the ZTC was calculated from a change in the weight between before and after the HF treatment.

[Table 2]

| Weight Percentage of ZTC | |
|---|---|
| Carbon yield after HF treatment | |
| Sample No. | ZTC (% by weight) |
| No. 13 | 22.8 |
| No. 14 | 22.2 |
| No. 15 | 22.3 |

In Table 2, the treatment condition of each sample No. is as follows.

No. 13; DVB was adsorbed to Na-Y type zeolite for 1 hour, polymerized for 3 hours, then subjected to propylene CVD at 700°C for 2 hours, and heated at 900°C for 3 hours. No. 14; DVB was adsorbed to Na-Y type zeolite for 3 hours, polymerized for 3 hours, then subjected to propylene CVD at 700°C for 2 hours, and heated at 900°C for 3 hours. No. 15; DVB was adsorbed to Na-Y type zeolite for 6 hours, polymerized for 3 hours, then subjected to propylene CVD at 700°C for 2 hours, and heated at 900°C for 3 hours.

As can be seen from Table 2, all samples of DVB adsorption durations of 1, 3, and 6 hours showed high weight percentages of the ZTC, i.e. high yields.

Study on Adsorption Duration of DVB to Na-Y Type Zeolite in XRD Measurement The ZTC samples obtained varying the adsorption duration of DVB to Na-Y type zeolite as described above were subjected to an XRD device measurement, and the result was presented in FIG. 4.

In FIG. 4, the treatment condition of each sample presenting XRD data is as follows. No. 13; DVB was adsorbed to Na-Y type zeolite for 1 hour, polymerized for 3 hours, then subjected to propylene CVD at 700°C for 2 hours, and heated at 900°C for 3 hours. No. 14; DVB was adsorbed to Na-Y type zeolite for 3 hours, polymerized for 3 hours, then subjected to propylene CVD at 700°C for 2 hours, and heated at 900°C for 3 hours. No. 15; DVB was adsorbed to Na-Y type zeolite for 6 hours, polymerized for 3 hours, then subjected to propylene CVD at 700°C for 2 hours, and heated at 900°C for 3 hours. No. 66-1 ZTC; DVB was adsorbed to Na-Y type zeolite at 150°C, polymerized for 24 hours, then subjected to propylene CVD at 700°C for 2 hours, and heated at 900°C for 3 hours.

With all of the adsorption durations, sharp peaks attributed to Na-Y type zeolite appeared at around 6°. Also, No. 13 showed a peak attributed to Na-Y type zeolite at around 10°.

Furthermore, since sharp peaks were obtained for all of the adsorption durations, 1 hour of adsorption duration is sufficient.

Example 4 <Study on Small Times the Amount of DVB>

Carbon yields after HF treatment are presented in Table 3 below. In Table 3, a weight percentage (wt%) of the ZTC was measured for each of samples obtained varying an amount of DVB. The weight percentage of the ZTC was calculated from a change in the weight between before and after the HF treatment.

[Table 3]

| Weight Percentage of ZTC | |
|---|---|
| Carbon yield after HF treatment | |
| Sample No. | ZTC (% by weight) |
| No. 13 | 22.8 |
| No. 19 | 21.7 |
| No. 24 | 20.9 |
| No. 25 | 20.5 |
| No. 26 | 17.6 |

In Table 3, the treatment condition of each sample No. is as follows.
No. 13; 1.00 time the amount of DVB was adsorbed to Na-Y type zeolite for 1 hour, polymerized for 3 hours, then subjected to propylene CVD at 700°C for 2 hours, and heated at 900°C for 3 hours.
No. 19; 0.82 time the amount of DVB was adsorbed to Na-Y type zeolite for 1 hour, polymerized for 3 hours, then subjected to propylene CVD at 700°C for 2 hours, and heated at 900°C for 3 hours.
No. 24; 0.63 time the amount of DVB was adsorbed to Na-Y type zeolite for 1 hour, polymerized for 3 hours, then subjected to propylene CVD at 700°C for 2 hours, and heated at 900°C for 3 hours.
No. 25; 0.43 time the amount of DVB was adsorbed to Na-Y type zeolite for 1 hour, polymerized for 3 hours, then subjected to propylene CVD at 700°C for 2 hours, and heated at 900°C for 3 hours.
No. 26; 0.24 time the amount of DVB was adsorbed to Na-Y type zeolite for 1 hour, polymerized for 3 hours, then subjected to propylene CVD at 700°C for 2 hours, and heated at 900°C for 3 hours.
As can be seen from Table 3, when the amount of the divinylbenzene was decreased, the amount of the ZTC obtained by using a small times the amount of divinylbenzene also decreased, but the amount of the ZTC was not so different from that with 1.0 time the amount of divinylbenzene until the divinylbenzene was decreased down to an amount of about 0.8 time.
Study on Small Times the Amount of DVB Used in XRD Measurement
As described above, the ZTC samples obtained with small times the amount of DVB were subjected to an XRD device measurement, and the result was presented in FIG. 5.
In FIG. 5, the treatment condition of each sample presenting XRD data is as follows.

1: No. 13; 1.00 time the amount of DVB was adsorbed to Na-Y type zeolite for 1 hour, polymerized for 3 hours, then subjected to propylene CVD at 700°C for 2 hours, and heated at 900°C for 3 hours.
2: No. 19; 0.82 time the amount of DVB was adsorbed to Na-Y type zeolite for 1 hour, polymerized for 3 hours, then subjected to propylene CVD at 700°C for 2 hours, and heated at 900°C for 3 hours.
3: No. 24; 0.63 time the amount of DVB was adsorbed to Na-Y type zeolite for 1 hour, polymerized for 3 hours, then subjected to propylene CVD at 700°C for 2 hours, and heated at 900°C for 3 hours.
4: No. 25; 0.43 time the amount of DVB was adsorbed to Na-Y type zeolite for 1 hour, polymerized for 3 hours, then subjected to propylene CVD at 700°C for 2 hours, and heated at 900°C for 3 hours.
5: No. 26; 0.24 time the amount of DVB was adsorbed to Na-Y type zeolite for 1 hour, polymerized for 3 hours, then subjected to propylene CVD at 700°C for 2 hours, and heated at 900°C for 3 hours.

As can be seen from FIG. 5, the peak intensities attributed to Na-Y type zeolites with 0.8 time and 0.6 time the amount of DVB were lower than that with 1.0 time the amount of DVB, but the peaks attributed to Na-Y type zeolites with 0.8 time and 0.6 time the amount of DVB were sharp. On the other hand, in the case with 0.4 time the amount of DVB, little peak was observed, and in the case with 0.2 time the amount of DVB, no peak was observed.
This suggests that 1 time the amount of DVB is sufficient.

Example 5 <Study on large times the amount of DVB>

Carbon yields after HF treatment are presented in Table 4 below. In Table 4, a weight percentage (wt%) of the ZTC was measured for each of samples obtained varying an amount of DVB. The weight percentage of the ZTC was calculated from a change in the weight between before and after the HF treatment.

[Table 4]

| Weight Percentage of ZTC | |
|---|---|
| Carbon yield after HF treatment | |
| Sample No. | ZTC (% by weight) |
| No. 13 | 22.8 |
| No. 37 | 22.8 |
| No. 38 | 22.7 |
| No. 39 | 23.7 |
| No. 40 | 26.0 |

In Table 4, the treatment condition of each sample No. is as follows.
No. 13; 1.00 time the amount of DVB was adsorbed to Na-Y type zeolite for 1 hour, polymerized for 3 hours, then subjected to propylene CVD at 700°C for 2 hours, and heated at 900°C for 3 hours.
No. 37; 1.22 time the amount of DVB was adsorbed to Na-Y type zeolite for 1 hour, polymerized for 3 hours, then subjected to propylene CVD at 700°C for 2 hours, and heated at 900°C for 3 hours.
No. 38; 1.41 time the amount of DVB was adsorbed to Na-Y type zeolite for 1 hour, polymerized for 3 hours, then subjected to propylene CVD at 700°C for 2 hours, and heated at 900°C for 3 hours.
No. 39; 1.62 time the amount of DVB was adsorbed to Na-Y type zeolite for 1 hour, polymerized for 3 hours, then subjected to propylene CVD at 700°C for 2 hours, and heated at 900°C for 3 hours.
No. 40; 1.84 time the amount of DVB was adsorbed to Na-Y type zeolite for 1 hour, polymerized for 3 hours, then subjected to propylene CVD at 700°C for 2 hours, and heated at 900°C for 3 hours.
As can be seen from Table 4, when the amount of the divinylbenzene is increased, the amount of the ZTC obtained by using a large times the amount of divinylbenzene also increases. Compared to the case with 1.00 time the amount of DVB of No. 13, the weight percentage of ZTC exceeded 23% by weight in the cases with 1.62 time the amount of DVB of No. 39 and with 1.84 time the amount of DVB of No. 40, and therefore it was considered that carbon was laminated.

Study on Large Times the Amount of DVB Used in XRD Measurement

As described above, the ZTC samples obtained with large times the amount of DVB were subjected to an XRD device measurement, and the result was presented in FIG. 6.
In FIG. 6, the treatment condition of each sample presenting XRD data is as follows.

1: No. 66-1; 1.05 time the amount of DVB was adsorbed to Na-Y type zeolite for 1 hour, polymerized for 3 hours, then subjected to propylene CVD at 700°C for 2 hours, and heated at 900°C for 3 hours.
2; No. 13; 1.00 time the amount of DVB was adsorbed to Na-Y type zeolite for 1 hour, polymerized for 3 hours, then subjected to propylene CVD at 700°C for 2 hours, and heated at 900°C for 3 hours.
3: No. 37; 1.22 time the amount of DVB was adsorbed to Na-Y type zeolite for 1 hour, polymerized for 3 hours, then subjected to propylene CVD at 700°C for 2 hours, and heated at 900°C for 3 hours.
4: No. 38; 1.41 time the amount of DVB was adsorbed to Na-Y type zeolite for 1 hour, polymerized for 3 hours, then subjected to propylene CVD at 700°C for 2 hours, and heated at 900°C for 3 hours.
5: No. 39; 1.62 time the amount of DVB was adsorbed to Na-Y type zeolite for 1 hour, polymerized for 3 hours, then subjected to propylene CVD at 700°C for 2 hours, and heated at 900°C for 3 hours.
6: No. 40; 1.84 time the amount of DVB was adsorbed to Na-Y type zeolite for 1 hour, polymerized for 3 hours, then subjected to propylene CVD at 700°C for 2 hours, and heated at 900°C for 3 hours.

As can be seen from FIG. 6, all of the ZTC samples showed a sharp peak attributed to Na-Y type zeolite at around 6°, but showed no peak at around 10°. The sample No. 39 with 1.62 time the amount of DVB and the sample

No. 40 with 1.84 time the amount of DVB showed no peak attributed to carbon. It is considered that the structural transfer can successfully occur in the case with 1.22 time the amount of DVB of No. 37 compared to the case with 1.00 time the amount of DVB of No. 13. The sample No. 38 with 1.41 time the amount of DVB, the sample No. 39 with 1.62 time the amount of DVB, and the sample No. 40 with 1.84 time the amount of DVB showed peaks equivalent to each other.

Example 6 <Study on ZTC Synthesis Using α-D-Glucose According to the Present Invention (Study on Reaction (Polymerization) Temperature)>

A. Drying of Na-Y Type Zeolite

· Na-Y type zeolite (NaY) with $Na^+$ exchange cation is dried because the pores contain a large amount of adsorbed water.
· About 500 mg of Na-Y type zeolite was weighed out into a 10 ml vial. The vial and its cap had been weighed.

1) The vial was put into an oil bath and subjected to vacuum heat drying. This installation is illustrated in FIG. 7.
2) The vial was put into a drying chamber and subjected to vacuum heat drying.

· The vacuum heat drying program is common and can be exemplified by a temperature management in which the temperature is raised to 100°C in 90 minutes, maintained for 1 hour, and then lowered.

B. Adsorption of α-D-Glucose

· The amount of α-D-Glucose added was determined by calculating a difference in weight between before and after α-D-glucose was added to the container (vial). The density of α-D-glucose was set to 1. 54 g/$cm^3$.
· The vial containing the dried Na-Y type zeolite was placed in a vacuumed glass container equipped with a three-way cock, and uncapped.
· The required minimum amount of α-D-glucose was put into a vial using a medicine packing paper under nitrogen stream.
· The vial was capped and taken out from the glass bottle, and placed in a thermostatic bath at 100°C or 150°C for 24 h to prepare a sample.

As the subsequent operation, C. propylene CVD and D. HF treatment were carried out in the same manner as for divinylbenzene (DVB) described above.

C. Heat Treatment by Propylene CVD

· Na-Y type zeolite (denoted as "NaY" in the diagram) with the polymerized monomer was placed on a quartz board illustrated in FIG. 1.
· The quartz board on which the sample had been placed was set at center of a gold horizontal furnace.
· All gas valves were opened and the system was vacuumed. Then, $N_2$ was purged.
· In FIG. 1, propylene CVD can be performed for 2 hours, e.g. under a condition of an $N_2$ flow rate of 912 cc/mm, a propylene ($C_3H_6$) flow rate of 38 cc/mm, and a temperature of 700°C.
· Subsequently, nitrogen was allowed to flow to discharge air within the furnace. Then, CVD and heat treatment were performed under the program condition presented in FIG. 2.

D. HF Treatment

· A stirring bar and HF were put into a polytetrafluoroethylene (PTFE) beaker. Subsequently, the Na-Y type zeolite/ZTC composite was added to the beaker little by little and stirred for 5 h.
· The composite was vacuum-filtered using a plastic filtration device.

· After the filtration, the sample was transferred to a petri dish and subjected to vacuum heat drying using a vacuum drying chamber.

Example 7 <Result of ZTC Synthesis Using α-D-Glucose>

Carbon yields after HF treatment are presented in Table 5 below. In Table 5, a weight percentage (wt%) of the ZTC was measured for each of samples obtained varying a polymerization duration and a heating temperature of DVB. The weight percentage of the ZTC was calculated from a change in the weight between before and after the HF treatment.

[Table 5]

| Weight Percentage of ZTC | |
|---|---|
| Carbon yield after HF treatment | |
| Sample No. | ZTC (% by weight) |
| No. 3 | 21.76 |
| No. 4 | 23.50 |

In Table 5, the treatment condition of each sample No. is as follows.

No. 3; α-D-glucose was heated at 100°C, subjected to propylene CVD at 700°C for 2 hours, and heated at 900°C for 3 hours.

No. 4; α-D-glucose was heated at 150°C, subjected to propylene CVD at 700°C for 2 hours, and heated at 900°C for 3 hours.

When α-D-glucose is heated at 100°C or 150°C, the subsequent propylene CVD can form the ZTC, and therefore, it is considered that polymerization or decomposition occurs in the heat treatment of α-D-glucose.

A too high weight percentage of the obtained ZTC suggests lamination of graphene, and it is considered that this high percentage rather decreases the surface area of the ZTC. From this viewpoint, the weight percentage is preferably about 23 wt% as shown in the results of Table 5, particularly the result of No. 4. In Example 7, α-D-glucose has a melting point of 146°C, but when the heating temperature of α-D-glucose was 100°C or 150°C, and the weight percentage values of ZTC in both cases of 100°C and 150°C were close to the weight percentage value in the case of 146°C.

XRD Measurement

The ZTC samples obtained varying the polymerization temperature as described above were subjected to an XRD device measurement, and the result was presented in FIG. 8.

In FIG. 8, the treatment condition of each sample presenting XRD data is as follows.

1: No. 4; α-D-glucose was heated at 150°C, subjected to propylene CVD at 700°C for 2 hours, and heated at 900°C for 3 hours. 1' is an enlarged graph.
2: No. 3; α-D-glucose was heated at 100°C, subjected to propylene CVD at 700°C for 2 hours, and heated at 900°C for 3 hours. 2' is an enlarged graph.
3: No. 66-1 ZTC; 1.05 time the amount of DVB was polymerized, then subjected to propylene CVD at 700°C for 2 hours, and heated at 900°C for 3 hours.

As presented in FIG. 8, also with reference to the enlarged graphs, both the sample No. 3 with the heating temperatures of 100°C and the sample No. 4 with the heating temperature 150°C clearly showed a sharp peak attributed to Na-Y type zeolite with an XRD angle 2θ (attributed to CuKα ray) value of around 6°. A peak at around 10° that was confirmed when a suitable ZTC was synthesized was also confirmed in both No. 3 and No. 4. In the diagram, the chart denoted as NaY is based on Na-Y type zeolite, and a portion at around 6° is marked for referring to this characteristic peak.

Nitrogen Adsorption/Desorption Isothermal Line

The ZTC samples obtained varying the polymerization temperature as described above were measured for a nitrogen adsorption/desorption isothermal line, and the result was presented in FIG. 9.

In FIG. 9, the treatment condition of each sample presenting the nitrogen adsorption/desorption isothermal line

is as follows.

1: No. 3; α-D-glucose was heated at 100°C, subjected to propylene CVD at 700°C for 2 hours, and heated at 900°C for 3 hours. 2' is an enlarged graph.
2: No. 66-1 ZTC; 1.05 time the amount of DVB was polymerized, then subjected to propylene CVD at 700°C for 2 hours, and heated at 900°C for 3 hours.

As can be seen from FIG. 9, the structural transfer of Na-Y type zeolite successfully occurred because little hysteresis attributed to the mesopores appeared.

Pore Diameter Distribution (DFT Method)

The ZTC samples obtained varying the polymerization temperature as described above were measured for a pore diameter distribution by DFT method, and the result was presented in FIG. 10.
In FIG. 10, the treatment condition of each sample presenting the pore diameter distribution is as follows.

1: No. 3; α-D-glucose was heated at 100°C, subjected to propylene CVD at 700°C for 2 hours, and heated at 900°C for 3 hours. 2' is an enlarged graph.
2: No. 66-1 ZTC; 1.05 time the amount of DVB was polymerized, then subjected to propylene CVD at 700°C for 2 hours, and heated at 900°C for 3 hours.

As can be seen from FIG. 10, the structural transfer of Na-Y type zeolite successfully occurred because numerous 1.2 nm pores transferred from Na-Y type zeolite are distributed.

Surface Area and Pore Volume

A surface area and a pore volume of the ZTC obtained above were measured, and the results were presented in Table 6 below.

[Table 6]

| Surface Area and Pore Volume of Sample | | | | | |
|---|---|---|---|---|---|
| Sample | | $S_{BET}$[a] ($m^2/g$) | $V_{total}$[b] ($cm^3/g$) | $V_{micro}$[c] ($cm^3/g$) | $V_{meso}$[d] ($cm^3/g$) |
| AR166-1 | No. 66-1 | 3820 | 1.70 | 1.60 | 0.10 |
| HRD3 | No. 3 | 3740 | 1.62 | 1.58 | 0.04 |

[a] calculated from $P/P_0$ = 0.01 to 0.05
[b] calculated from nitrogen adsorption amount at $P/P_0$=0.96
[c] calculated from$P/P_0$=0.001 to 0.050 by Dubinin-Radushkevieh (DR) method
[d] calculated from $V_{meso}= V_{total-} V_{micro}$

In Table 6, the treatment condition of each sample No. is as follows.
No. 66-1; DVB was adsorbed to Na-Y type zeolite for 24 hours, polymerized for 24 hours, then subjected to propylene CVD at 700°C for 2 hours, and heated at 900°C for 3 hours.
No. 3; α-D-glucose was heated at 100°C, subjected to propylene CVD at 700°C for 2 hours, and heated at 900°C for 3 hours.
As can be seen from Table 6, the sample No. 3 had a sufficient BET specific surface area of 3740 $m^2/g$ and a high micropore volume.

Example 8 <Study on ZTC Synthesis Using α-D-Glucose (without Polymerization Operation)>

Carbon Yield after HF Treatment

Carbon yields after the HF treatment are presented in Table 7 below. In Table 7, a weight percentage of the obtained ZTC was measured depending on a mixing method of α-D-glucose used and a multiplying amount of α-D-glucose relative to a reference (No. 3). The weight percentage of the ZTC was calculated from a change in the weight

between before and after the HF treatment.

In Table 7, No. 3 is a reference condition, in which the heat treatment (polymerization operation) of α-D-glucose was performed at 100°C. For No. 6 and No. 7, the mixing operation was studied. All of No. 11 to No. 14 and No. 16 to No. 19 are samples obtained by mixing operation using Awatori Rentaro® ARE-310 for 1 minute.

[Table 7]

| Weight Percentage (wt%) of ZTC | |
|---|---|
| Carbon yield after HF treatment | |
| Sample No. | ZTC (% by weight) |
| No. 3 | 21.8 |
| No. 6 | 21.3 |
| No. 7 | 21.3 |
| No. 11 | 21.4 |
| No. 12 | 19.8 |
| No. 13 | 17.4 |
| No. 14 | 13.5 |
| No. 16 | 23.4 |
| No. 17 | 22.9 |
| No. 18 | 25.3 |
| No. 19 | 25.7 |

In Table 7, the treatment condition of each sample No. is as follows.

No. 3; 1.00 time the amount of α-D-glucose was heated at 100°C, subjected to propylene CVD at 700°C for 2 hours, and heated at 900°C for 3 hours.

No. 6; α-D-glucose was mixed in a mortar for 30 minutes, 1.00 time the amount of α-D-glucose was heated at 100°C, subjected to propylene CVD at 700°C for 2 hours, and heated at 900°C for 3 hours.

No. 7; α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours.

No. 11; 0.79 time the amount of α-D-glucose was heated at 100°C, subjected to propylene CVD at 700°C for 2 hours, and heated at 900°C for 3 hours.

No. 12; 0.60 time the amount of α-D-glucose was heated at 100°C, subjected to propylene CVD at 700°C for 2 hours, and heated at 900°C for 3 hours.

No. 13; 0.41 time the amount of α-D-glucose was heated at 100°C, subjected to propylene CVD at 700°C for 2 hours, and heated at 900°C for 3 hours.

No. 14; 0.22 time the amount of α-D-glucose was heated at 100°C, subjected to propylene CVD at 700°C for 2 hours, and heated at 900°C for 3 hours.

No. 16; 1.20 time the amount of α-D-glucose was heated at 100°C, subjected to propylene CVD at 700°C for 2 hours, and heated at 900°C for 3 hours.

No. 17; 1.40 time the amount of α-D-glucose was heated at 100°C, subjected to propylene CVD at 700°C for 2 hours, and heated at 900°C for 3 hours.

No. 18; 1.60 time the amount of α-D-glucose was heated at 100°C, subjected to propylene CVD at 700°C for 2 hours, and heated at 900°C for 3 hours.

No. 19; 1.80 time the amount of α-D-glucose was heated at 100°C, subjected to propylene CVD at 700°C for 2 hours, and heated at 900°C for 3 hours.

As can be seen from No. 3, No. 6, and No. 7 in Table 7, regarding the carbon yield of the ZTC after the HF treatment, there is no significant difference in the yield of the ZTC between No. 3, No. 6, and No. 7 depending on the presence or absence of mixing and the mixing method, suggesting that ZTC was sufficiently formed.

As can be seen from No. 11 to No. 14, when the multiplying amount of α-D-glucose is decreased, the yield of the ZTC also decreases.

On the other hand, as can be seen from No. 16 to No. 19, when the multiplying amount of α-D-glucose is increased, the yield of the ZTC exceeds 23%, suggesting that graphene was laminated.

XRD Measurement

The ZTC samples obtained varying the mixing condition and the heating (polymerization) temperature of the α-D-glucose as described above were subjected to an XRD device measurement, and the result was presented in FIG. 11.
In FIG. 11, the treatment condition of each sample presenting XRD data is as follows.

1: No. 7; α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours. 1' is an enlarged graph.
2: No. 6; α-D-glucose was mixed in a mortar for 30 minutes, 1.00 time the amount of α-D-glucose was heated at 100°C, subjected to propylene CVD at 700°C for 2 hours, and heated at 900°C for 3 hours. 2' is an enlarged graph.
3: No. 4; 1.00 time the amount of α-D-glucose was heated at 150°C, subjected to propylene CVD at 700°C for 2 hours, and heated at 900°C for 3 hours. 3' is an enlarged graph.
4: No. 3; 1.00 time the amount of α-D-glucose was heated at 100°C, subjected to propylene CVD at 700°C for 2 hours, and heated at 900°C for 3 hours. 4' is an enlarged graph.
5: No. 66-1 ZTC; 1.05 time the amount of DVB was polymerized, then subjected to propylene CVD at 700°C for 2 hours, and heated at 900°C for 3 hours. 5' is an enlarged graph.

As presented in FIG. 11, also with reference to the enlarged graphs, there are sharp peaks attributed to Na-Y type zeolite with an XRD angle 2θ (attributed to CuKα ray) value of around 6°.
As in the case of the heat treatment of α-D-glucose at 100°C, a peak at around 10° that was confirmed when suitable ZTC was synthesized was also confirmed in both 4: No. 3 and 2: No. 6. In the diagram, the chart denoted as NaY is based on Na-Y type zeolite, and a portion at around 6° is marked for referring to this characteristic peak.

XRD Measurement (Study on Simplification)

The ZTC samples obtained varying the mixing condition and the heating (polymerization) temperature of the α-D-glucose as described above were subjected to an XRD device measurement, and the result was presented in FIG. 12.
In FIG. 12, the treatment condition of each sample presenting XRD data is as follows. In FIG. 12, the upper right diagram is an enlarged graph.
No. 7; α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours.
No. 6; α-D-glucose was mixed in a mortar for 30 minutes, 1.00 time the amount of α-D-glucose was heated at 100°C, subjected to propylene CVD at 700°C for 2 hours, and heated at 900°C for 3 hours.
No. 3; 1.00 time the amount of α-D-glucose was heated at 100°C, subjected to propylene CVD at 700°C for 2 hours, and heated at 900°C for 3 hours.
No. 66-1 ZTC; 1.05 time the amount of DVB was polymerized, then subjected to propylene CVD at 700°C for 2 hours, and heated at 900°C for 3 hours.
As presented in FIG. 12, also with reference to the enlarged graphs, all the XRD measurement results are overlapped, and therefore it is considered that even the samples of No. 7 and No. 6 which are just stirred have a high surface area and a high pore volume.

XRD Measurement (Study on Low Multiplying Amount)

As described above, the ZTC samples obtained varying the amount (low multiplying amount) of α-D-glucose were subjected to an XRD device measurement, and the result was presented in FIG. 13. All the samples had been stirred using Awatori Rentaro® for 1 minute before use.
In FIG. 13, the treatment condition of each sample presenting XRD data is as follows.

1: No. 11; 0.79 time the amount of α-D-glucose was heated at 100°C, subjected to propylene CVD at 700°C for 2 hours, and heated at 900°C for 3 hours.
2: No. 7; 1.00 time the amount of α-D-glucose was heated at 100°C, subjected to propylene CVD at 700°C for 2 hours, and heated at 900°C for 3 hours.
3: No. 12; 0.60 time the amount of α-D-glucose was heated at 100°C, subjected to propylene CVD at 700°C for 2 hours, and heated at 900°C for 3 hours.
4: No. 13; 0.41 time the amount of α-D-glucose was heated at 100°C, subjected to propylene CVD at 700°C for 2 hours, and heated at 900°C for 3 hours.
5: No. 14; 0.22 time the amount of α-D-glucose was heated at 100°C, subjected to propylene CVD at 700°C for 2

hours, and heated at 900°C for 3 hours.
6: No. 66-1 ZTC; 1.05 time the amount of DVB was polymerized, then subjected to propylene CVD at 700°C for 2 hours, and heated at 900°C for 3 hours.

1: When α-D-glucose of No. 11 was used in an amount of 0.79 time, No. 11 showed a sharp peak. In the other samples, especially small times the amount of samples, the intensity (sharpness) of the peaks gradually decreased.

XRD Measurement (Study on High Multiplying Amount)

As described above, the ZTC samples obtained varying the amount (high multiplying amount) of α-D-glucose were subjected to an XRD device measurement, and the result was presented in FIG. 14. All the samples had been stirred using Awatori Rentaro® for 1 minute before use.
In FIG. 14, the treatment condition of each sample No. is as follows.

1: No. 7; α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours.
2: No. 16; 1.20 time the amount of α-D-glucose was heated at 100°C, subjected to propylene CVD at 700°C for 2 hours, and heated at 900°C for 3 hours.
3: No. 17; 1.40 time the amount of α-D-glucose was heated at 100°C, subjected to propylene CVD at 700°C for 2 hours, and heated at 900°C for 3 hours.
4: No. 18; 1.60 time the amount of α-D-glucose was heated at 100°C, subjected to propylene CVD at 700°C for 2 hours, and heated at 900°C for 3 hours.
5: No. 19; 1.80 time the amount of α-D-glucose was heated at 100°C, subjected to propylene CVD at 700°C for 2 hours, and heated at 900°C for 3 hours.

As presented in FIG. 14, in the case where α-D-glucose of 3: No. 16 was used in an amount of 1.20 time, No. 16 showed a sharp peak close to that in the case where α-D-glucose of 1: No. 7 was used in an amount of 1.00 time, but α-D-glucose used in an amount of other times showed a peak intensity lower than peak intensities of 3: No. 16 and 1: No. 7.
When α-D-glucose is used in an amount of 0.8 time and 1.2 time, sufficiently sharp peaks were confirmed, and there was no significant difference from the case of 1.0 time. From this result, mass synthesis is studied in an amount of 1.0 time, and it is not necessary to consider a slight error of the amount.

XRD Measurement (Study on High Multiplying Amount)

As described above, the ZTC samples obtained varying the amount (high multiplying amount) of α-D-glucose were subjected to an XRD device measurement, and the result was presented in FIG. 15.
In FIG. 15, the treatment condition of each sample No. is as follows. In FIG. 17, the right and left graphs show the same result, and the right graph takes a wide range of the 2θ value on the abscissa.

1: No. 7; α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours.
2: No. 16; 1.20 time the amount of α-D-glucose was heated at 100°C, subjected to propylene CVD at 700°C for 2 hours, and heated at 900°C for 3 hours.

In FIG. 15, since the ZTC yield was 25.7% in 2: No. 19 (see Table. 7), it is considered that graphene was laminated. Thus, an XRD measurement was performed to confirm a peak of carbon at around 26°, but no peak appeared.

SEM and TEM of Sample No. 7

As described above, a SEM photograph in FIG. 16 and a TEM photograph in FIG. 17 of No. 7 (a sample obtained by a process in which α-D-glucose was mixed using Awatori Rentaro® for 1 minute, 1.00 time the amount of α-D-glucose was heated at 100°C, subjected to propylene CVD at 700°C for 2 hours, and heated at 900°C for 3 hours) were taken.
As can be seen from the SEM photograph in FIG. 16, a granular structure that appeared when ZTC was produced was confirmed.
As can be seen from the TEM photograph in FIG. 17, a lattice-like structure that appeared when ZTC was produced was confirmed, and the outline of the ZTC was clear because of its high crystallinity.

Example 9 <Mechanism of Glucose Adsorption into Zeolite Pore>

As described above, a surface area and a pore diameter volume of Sample No. 30 were measured and presented in Table 8.

[Table 8]

| Surface Area and Pore Volume of Sample | | | | |
|---|---|---|---|---|
| Sample | $S_{BET}$[a] ($m^2/g$) | $V_{total}$[b] ($cm^3/g$) | $V_{micro}$[c] ($cm^3/g$) | $V_{meso}$[d] ($cm^3/g$) |
| No. 30 | 460 | 0.21 | | |
| [a] calculated from $P/P_0$ = 0.01 to 0.05<br>[b] calculated from nitrogen adsorption amount at $P/P_0$=0.96<br>[c]calculated from $P/P_0$=0.001 to 0.050 by DR method<br>[d] calculated from $V_{meso}= V_{total-} V_{micro}$ | | | | |

In Table 8, the treatment conditions of the samples are as follows.

No. 30; 1.00 time the amount of α-D-glucose was mixed with Na-Y type zeolite at room temperature.

A BET surface area of only Na-Y type zeolite is calculated from the BET surface area of Na-Y type zeolite/α-D-Glc.

Assuming that adsorption occurs only by mixing Na-Y type zeolite and α-D-Glc, the BET surface area is close to zero.

From an equation: BET surface area of Na-Y type zeolite/α-D-Glc ÷ weight of Na-Y type zeolite / total weight of Na-Y type zeolite and α-D-Glc, the BET surface area was determined as 460 ÷ 0.1750 / 02738 ≈ 630 $m^2/g$.

This result was a value close to the BET surface area of 700 $m^2/g$ obtained with Na-Y type zeolite used in the present invention (manufactured by FUJIFILM Wako Pure Chemical Corporation). This suggests that little adsorption occurred.

Example 10 <Mechanism (TG) of Glucose Adsorption into Zeolite Pore>

As described above, a mixed powder in Sample No. 30 was subjected to a TG measurement, and the result is presented in FIG. 18.

In FIG. 18, the treatment condition of each sample is as follows.

No. 30; 1.00 time the amount of α-D-glucose was mixed with Na-Y type zeolite at room temperature.

The reference numerals presented in FIG. 18 are as follows.

1 represents a temperature profile (denoted as "Temperature", unit: °C).
2 represents a TGA (thermo-gravimeter) profile.
3 represents a DTA (differential thermal analysis) profile.

As presented in FIG. 18, the adsorption reaction refers to an exothermal reaction, and therefore Sample No. 30 was stirred using Awatori Rentaro for 1 min, and subjected to a TG measurement. From the result, an upward peak to be confirmed by the exothermic reaction was not confirmed in the DTA.

<Mechanism of Glucose Adsorption into Zeolite Pore (ASAP)>

A surface area and a pore diameter volume of each sample obtained by mixing α-D-glucose and zeolite were measured and presented in Table 9.

[Table 9]

| Surface Area and Pore Volume of Sample<br>Sample | $S_{BET}$[a] ($m^2/g$) | $V_{total}$[b] ($cm^3/g$) | $V_{micro}$[c] ($cm^3/g$) | $V_{meso}$[d] ($cm^3/g$) |
|---|---|---|---|---|
| No. 41 | 20 | 0.011 | 0.010 | 0.001 |
| No. 40 | 10 | 0.008 | 0.004 | 0.004 |

(continued)

| Surface Area and Pore Volume of Sample | | | | |
|---|---|---|---|---|
| Sample | $S_{BET}$[a] ($m^2/g$) | $V_{total}$[b] ($cm^3/g$) | $V_{micro}$[c] ($cm^3/g$) | $V_{meso}$[d] ($cm^3/g$) |
| No. 39 | 40 | 0.021 | 0.018 | 0.003 |
| No. 54 | 700 | 0.320 | 0.315 | 0.005 |
| No. 66 | 380 | 0.183 | 0.176 | 0.007 |

[a] calculated from $P/P_0$ = 0.01 to 0.05
[b] calculated from nitrogen adsorption amount at $P/P_0$=0.96
[c] calculated from $P/P_0$=0.001 to 0.050 by DR method
[d] calculated from $V_{meso} = V_{total} - V_{micro}$

In Table 9, the treatment conditions of the samples are as follows.

No. 41; 1.0 time the amount of α-D-glucose was mixed with Na-Y type zeolite using Awatori Rentaro for 1 minute, then heated at 10°C/min, and when the temperature reached 400°C, the heating was stopped to cool the mixture.

No. 40; 1.0 time the amount of α-D-glucose was mixed with Na-Y type zeolite using Awatori Rentaro for 1 hour, then heated at 10°C/min, and when the temperature reached 300°C, the heating was stopped to cool the mixture.

No. 39; 1.0 time the amount of α-D-glucose was mixed with Na-Y type zeolite using Awatori Rentaro for 1 hour, then heated at 10°C/min, and when the temperature reached 200°C, the heating was stopped to cool the mixture.

No. 54; Na-Y type zeolite was heated at 10°C/min, and when the temperature reached 150°C, the temperature was maintained for 6 hours, and then subjected to vacuum heat drying.

No. 66; 1.0 time the amount of α-D-glucose was mixed with Na-Y type zeolite using Awatori Rentaro for 1 minute, then heated at 10°C/min, and when the temperature reached 100°C, the temperature was maintained for 6 hours, then the mixture was placed in a thermostatic bath and dried.

In Table 9, it was found that adsorption occurred in the pores even at 200°C in spite of only raising the temperature using an electric furnace.

In addition, the BET surface area was relatively high even when the sample was held in the thermostatic bath at 100°C for 6 hours. When the surface area is calculated in terms of 1 g of Na-Y type zeolite, from an equation: BET surface area of Na-Y type zeolite/α-D-Glc ÷ weight of Na-Y type zeolite / total weight of Na-Y type zeolite and α-D-Glc, the BET surface area is determined as $380 \times (0.3920 + 0.2194) / 0.3920 \approx 590\ m^2/g$. This suggested that slight adsorption occurred even at 100°C, whereas the adsorption filled the pores of Na-Y type zeolite at between 100°C and 200°C.

From the above results, it is understood that when glucose (α-D-Glc) and zeolite (e.g. Na-Y type zeolite) are mixed and heated, almost whole glucose is adsorbed to the zeolite before the temperature reaches 200°C.

Example 11 <Study on ZTC Synthesis Using β-D-Glucose, Cellulose, Sucrose, and Fructose>

The ZTC was synthesized using the following carbon precursors.

· D-(+)-sucrose: >99.0% (manufactured by Tokyo Chemical Industry Co., Ltd.)

[Formula 7]

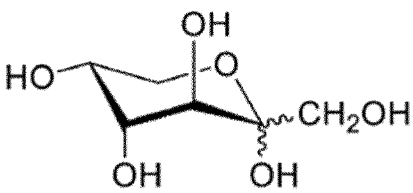

· D-(-)-fructose >99.0% (manufactured by Tokyo Chemical Industry Co., Ltd.)

[Formula 8]

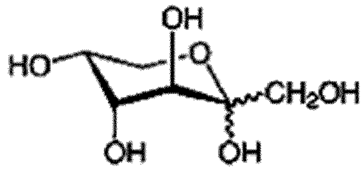

· β-D-glucose >85% (manufactured by Tokyo Chemical Industry Co., Ltd.)

[Formula 9]

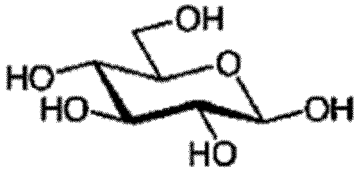

· Cellulose (manufactured by FUJIFILM Wako Pure Chemical Corporation, Powder, through 38 μm (400 mesh))

The ZTC was synthesized using the materials described above.
These materials were used in amounts of 1.0 time and 1.5 time to perform the synthesis. Weights of the materials for use are as follows.

· Calculation of a weight of a monomer to be put into the vial

Na-Y type zeolite: 1 g

· Theoretical pore volume of Na-Y type zeolite ($cm^3$) = weight of Na-Y type zeolite (g) × 0.3642 ($cm^3$/g)
· Pore volume per 1 g of Na-Y type zeolite (0.3642 $cm^3$/g)
· Weight (g) of 1 time the amount of the monomer to be added = weight (g) of NaY × pore volume ($cm^3$/g) per 1 g of Na-Y type zeolite × monomer density (g/$cm^3$)
· Volume of 1 time the amount of the monomer to be added: 0.3642 $cm^3$
· Weight (g) of 1 time the amount of the monomer to be added = weight (g) of Na-Y type zeolite × 0.3642 ($cm^3$/g) × density (g/$cm^3$) of each sample
· Density of divinylbenzene: 0.9325 (g/$cm^3$)

A density of starch was set to 1. 54 (g/$cm^3$) equal to that of α-D-glucose.

Density of β-D-glucose: 1.54 (g/$cm^3$)
Density of cellulose: 1.5 (g/$cm^3$)
Density of sucrose: 1.59 (g/$cm^3$)
Density of fructose: 1.69 (g/$cm^3$)

Carbon Yield after HF Treatment

Carbon yields of the ZTC after the HF treatment are presented in Table 10 below. In
Table 10, the weight percentage of the ZTC was calculated from a change in the weight between before and after the HF treatment.

[Table 10]

| Weight Percentage (wt%) of ZTC | |
|---|---|
| Carbon yield after HF treatment | |
| Sample No. | ZTC (% by weight) |
| No 41 | 22.2 |
| No. 45 | 20.0 |
| No. 42 | 24.0 |
| No. 46 | 24.0 |
| No. 43 | 23.3 |
| No. 47 | 26.2 |
| No. 44 | 22.2 |
| No. 48 | 26.3 |

In Table 10, the treatment conditions of the samples are as follows.

No. 41; 1.0 time the amount of α-D-glucose was mixed with Na-Y type zeolite, then subjected to propylene CVD at 700°C for 2 hours, and heated at 900°C for 3 hours.

No. 45; 1.5 time the amount of α-D-glucose was mixed with Na-Y type zeolite, then subjected to propylene CVD at 700°C for 2 hours, and heated at 900°C for 3 hours.

No. 42; 1.0 time the amount of cellulose was mixed with Na-Y type zeolite, then subjected to propylene CVD at 700°C for 2 hours, and heated at 900°C for 3 hours.

No. 46; 1.5 time the amount of cellulose was mixed with Na-Y type zeolite, then subjected to propylene CVD at 700°C for 2 hours, and heated at 900°C for 3 hours.

No. 43; 1.0 time the amount of D-(+)-sucrose was mixed with Na-Y type zeolite, then subjected to propylene CVD at 700°C for 2 hours, and heated at 900°C for 3 hours.

No. 47; 1.5 time the amount of D-(+)-sucrose was mixed with Na-Y type zeolite, then subjected to propylene CVD at 700°C for 2 hours, and heated at 900°C for 3 hours.

No. 44; 1.0 time the amount of D-(-)-fructose was mixed with Na-Y type zeolite, then subjected to propylene CVD at 700°C for 2 hours, and heated at 900°C for 3 hours.

No. 48; 1.5 time the amount of D-(-)-fructose was mixed with Na-Y type zeolite, then subjected to propylene CVD at 700°C for 2 hours, and heated at 900°C for 3 hours.

In Table 10, since a part of sample No. 45 was spilled, the amount of the ZTC was less than the original amount.

In Table 10, the ZTC yields were high in both cases of 1.0 time and 1.5 time. Above all, No. 42 and No. 46 using cellulose, No. 47 using D-(+)-sucrose, No. 48 using D-(-)-fructose may have laminated carbon, because the ZTC weight percentage exceeded 23 wt%.

XRD Measurement (1.0 Time the Amount of β-D-Glc, Cellulose, Sucrose, and Fructose)

As described above, the ZTC samples obtained using 1.0 time the amount of β-D-Glc, cellulose, sucrose, and fructose were subjected to an XRD device measurement, and the results were presented in FIG. 19 to FIG. 21. All the samples had been stirred using Awatori Rentaro® for 1 minute before use. In all of FIG. 19 to FIG. 21, the same sample was used, and scales of their XRD measurement results were merely changed.

In FIG. 19 to FIG. 21, the treatment conditions of the samples are as follows.

No. 66-1 ZTC; 1.05 time the amount of DVB was polymerized, then subjected to propylene CVD at 700°C for 2 hours, and heated at 900°C for 3 hours.

No. 41; 1.0 time the amount of α-D-glucose was mixed with Na-Y type zeolite, then subjected to propylene CVD at 700°C for 2 hours, and heated at 900°C for 3 hours. No. 42; 1.0 time the amount of cellulose was mixed with Na-Y type zeolite, then subjected to propylene CVD at 700°C for 2 hours, and heated at 900°C for 3 hours. No. 43; 1.0 time the amount of D-(+)-sucrose was mixed with Na-Y type zeolite, then subjected to propylene CVD at 700°C for 2 hours, and heated at 900°C for 3 hours. No. 44; 1.0 time the amount of D-(-)-fructose was mixed with Na-Y type zeolite, then subjected to propylene CVD at 700°C for 2 hours, and heated at 900°C for 3 hours.

In FIG. 19 to FIG. 21, a sharp peak attributed to Na-Y type zeolite was observed at around 6° in all sugars used, suggesting that the structural transfer successfully occurred. In No. 43 using D-(+)-sucrose, a broad peak attributed

to carbon was observed at around 25°. Thus, cellulose of No. 42 is considered to be superior to D-(+)-sucrose of No. 43.

XRD Measurement (1. 0 time and 1.5 time the amounts of β-D-Glc)

As described above, the ZTC samples obtained by using 1.0 time and 1.5 time the amount of β-D-Glc were subjected to an XRD device measurement, and the results were presented in FIG. 22 to FIG. 24. All the samples had been stirred using Awatori Rentaro® for 1 minute before use. In all of FIG. 22 to FIG. 24, the same sample was used, and scales of their XRD measurement results were merely changed.

In FIG. 22 to FIG. 24, the treatment conditions of the samples are as follows.

No. 66-1 ZTC; 1.05 time the amount of DVB was polymerized, then subjected to propylene CVD at 700°C for 2 hours, and heated at 900°C for 3 hours.

No. 41; 1.0 time the amount of α-D-glucose was mixed with Na-Y type zeolite, then subjected to propylene CVD at 700°C for 2 hours, and heated at 900°C for 3 hours. No. 45; 1.5 time the amount of α-D-glucose was mixed with Na-Y type zeolite, then subjected to propylene CVD at 700°C for 2 hours, and heated at 900°C for 3 hours.

In FIG. 22 to FIG. 24, a sharp peak attributed to Na-Y type zeolite was observed at around 6° even when α-D-glucose was used in a twice amount, suggesting that the structural transfer successfully occurred. When α-D- glucose was used in the amount of 1.5 time, a broad peak attributed to carbon was observed at around 25°. Thus, the amount of 1.5 time is considered to be an excessive amount.

XRD Measurement (1.0 Time and 1.5 Time the Amount of Cellulose)

As described above, the ZTC samples obtained by using 1.0 time and 1.5 time the amount of cellulose were subjected to an XRD device measurement, and the results were presented in FIG. 25 to FIG. 27. All the samples had been stirred using Awatori Rentaro® for 1 minute before use. In all of FIG. 25 to FIG. 27, the same sample was used, and scales of their XRD measurement results were merely changed.

In FIG. 25 to FIG. 27, the treatment conditions of the samples are as follows.

No. 66-1 ZTC; 1.05 time the amount of DVB was polymerized, then subjected to propylene CVD at 700°C for 2 hours, and heated at 900°C for 3 hours.

No. 42; 1.0 time the amount of cellulose was mixed with Na-Y type zeolite, then subjected to propylene CVD at 700°C for 2 hours, and heated at 900°C for 3 hours.

No. 46; 1.5 time the amount of cellulose was mixed with Na-Y type zeolite, then subjected to propylene CVD at 700°C for 2 hours, and heated at 900°C for 3 hours.

In FIG. 25 to FIG. 27, a sharp peak attributed to Na-Y type zeolite was observed at around 6° even when cellulose was used in a twice amount, suggesting that the structural transfer successfully occurred. When cellulose was used in the amount of 1.5 time, a broad peak attributed to carbon was slightly observed at around 25°. As presented in Table 10 above, No. 42 and No. 46 had the same ZTC weight percentage of 24.0, but No. 42 using 1.0 time the amount of cellulose is considered to be superior to No. 46.

XRD Measurement (1.0 Time and 1.5 Time the Amount of D-(+)-Sucrose)

As described above, the ZTC samples obtained by using 1.0 time and 1.5 time the amount of D-(+)-sucrose were subjected to an XRD device measurement, and the results were presented in FIG. 28 to FIG. 30. All the samples had been stirred using Awatori Rentaro® for 1 minute before use. In all of FIG. 28 to FIG. 30, the same sample was used, and scales of their XRD measurement results were merely changed.

In FIG. 28 to FIG. 30, the treatment conditions of the samples are as follows.

No. 66-1 ZTC; 1.05 time the amount of DVB was polymerized, then subjected to propylene CVD at 700°C for 2 hours, and heated at 900°C for 3 hours.

No. 43; 1.0 time the amount of D-(+)-sucrose was mixed with Na-Y type zeolite, then subjected to propylene CVD at 700°C for 2 hours, and heated at 900°C for 3 hours.

No. 47; 1.5 time the amount of D-(+)-sucrose was mixed with Na-Y type zeolite, then subjected to propylene CVD at 700°C for 2 hours, and heated at 900°C for 3 hours.

In FIG. 28 to FIG. 30, a sharp peak attributed to Na-Y type zeolite was observed at around 6° in all multiplying amounts of D-(+)-sucrose used, suggesting that the structural transfer successfully occurred. Both samples using 1.0 time and 1.5 time the amounts of D-(+)-sucrose showed a broad peak attributed to carbon at around 25°.

XRD Measurement (1.0 Time and 1.5 Time the Amount of Fructose)

As described above, the ZTC samples obtained by using 1.0 time and 1.5 time the amount of fructose were

subjected to an XRD device measurement, and the results were presented in FIG. 31 to FIG. 33. All the samples had been stirred using Awatori Rentaro® for 1 minute before use. In all of FIG. 31 to FIG. 33, the same sample was used, and scales of their XRD measurement results were merely changed.

In FIG. 31 to FIG. 33, the treatment conditions of the samples are as follows.

No. 66-1 ZTC; 1.05 time the amount of DVB was polymerized, then subjected to propylene CVD at 700°C for 2 hours, and heated at 900°C for 3 hours.

No. 44; 1.0 time the amount of D-(-)-fructose was mixed with Na-Y type zeolite, then subjected to propylene CVD at 700°C for 2 hours, and heated at 900°C for 3 hours. No. 48; 1.5 time the amount of D-(-)-fructose was mixed with Na-Y type zeolite, then subjected to propylene CVD at 700°C for 2 hours, and heated at 900°C for 3 hours.

In FIG. 31 to FIG. 33, a sharp peak attributed to Na-Y type zeolite was observed at around 6° in all multiplying amounts of D-(-)-fructose used, suggesting that the structural transfer successfully occurred. No. 48 using 1.5 time the amount of D-(+)-sucrose showed, at around 18°, a peak attributed to impurities that had not been completely treated with HF. Furthermore, a broad peak attributed to carbon was observed at around 25°.

Example 12 <Study on ZTC Synthesis Using Starch>

A. Vacuum Heat Drying of Na-Y Type Zeolite

- For each 10 ml vial, "rubber stopper" and "rubber stopper + vial" were weighed.
- 500 mg of Na-Y type zeolite was weighed out and transferred into the vial, and "rubber stopper + vial + Na-Y type zeolite" was weighed. A weight of Na-Y type zeolite was calculated from the difference in the weight from the "rubber stopper + vial".
- The rubber stopper of the vial was removed, the vial was placed in a vacuum drying chamber, and subjected to vacuum heat drying under a condition (program) illustrated in FIG. 34.

Mixing of Na-Y Type Zeolite and Starch (1)

- Theoretical pore volume of Na-Y type zeolite was determined from the amount of NaY type zeolite after the vacuum drying.
- As described below, a weight of starch to be added was determined from the determined pore volume.
- A glass container equipped with a three-way cock was vacuumed using a vacuum line to purge nitrogen. This operation was repeated three times.

Weights of the materials for use are as follows.

· Calculation of a weight of a monomer to be put into the vial

Na-Y type zeolite: 1 g

- Theoretical pore volume of Na-Y type zeolite ($cm^3$) = weight of Na-Y type zeolite (g) $\times$ 0.3642 ($cm^3$/g)
- Pore volume per 1 g of Na-Y type zeolite (0.3642 $cm^3$/g)
- Weight (g) of 1 time the amount of the monomer to be added = weight (g) of NaY $\times$ pore volume ($cm^3$/g) per 1 g of Na-Y type zeolite $\times$ monomer density (g/$cm^3$)
- Volume of 1 time the amount of the monomer to be added: 0.3642 $cm^3$
- Weight (g) of 1 time the amount of the monomer to be added = weight (g) of Na-Y type zeolite $\times$ 0.3642 ($cm^3$/g) $\times$ density (g/$cm^3$) of each sample
- A density of starch was calculated as 1.54 (g/$cm^3$) that is the same as of $\alpha$-D-glucose, and an amount that just fills the total pore volume was defined as an amount of 1 time.
- The vial containing the dried Na-Y type zeolite was set and the rubber stopper was removed.

Mixing of Na-Y Type Zeolite and Starch (2)

- When the sample was liquid, a syringe was wetted, and then a determined amount of sample was weighed out, and added to the set vial. In the case of starch, the sample was wrapped with a medicine packing paper, then the paper was folded into a small piece, and weighed out.
- The vial was capped with a rubber stopper, and the vial was taken out.
- The vial taken out was covered with an aluminum cap, placed in a Teflon® container, and stirred using a rotating and revolving mixer under the following condition for 1 minute.

Setting Condition
MIXING: 2000 rpm
DEFOAMING: 0 rpm

After the above mixing operation, the CVD and HF treatment operations were performed in the same manner as for divinylbenzene described above.

Carbon Yield after HF Treatment

Carbon yields of the ZTC after the HF treatment are presented in Table 11 below. In

Table 11, weight percentages of the ZTC were calculated from a change in the weight between before and after the HF treatment.

[Table 11]

| Weight Percentage (wt%) of ZTC | |
|---|---|
| Carbon yield after HF treatment | |
| Sample No. | ZTC (% by weight) |
| No. 34 | 21.7 |
| No. 35 | 22.3 |
| No. 36 | 24.8 |

In Table 11, the treatment conditions of the samples are as follows.
No. 34; 1.0 time the amount of starch was mixed with Na-Y type zeolite by stirring them using a rotating and revolving mixer for 1 minute, then subjected to propylene CVD at 700°C for 2 hours, and heated at 900°C for 3 hours.
No. 35; 1.5 time the amount of starch was mixed with Na-Y type zeolite by stirring them using a rotating and revolving mixer for 1 minute, then subjected to propylene CVD at 700°C for 2 hours, and heated at 900°C for 3 hours.
No. 36; 2.0 times the amount of starch was mixed with Na-Y type zeolite by stirring them using a rotating and revolving mixer for 1 minute, then subjected to propylene CVD at 700°C for 2 hours, and heated at 900°C for 3 hours.

XRD Measurement (Study on Amount of Starch)

As described above, ZTC samples obtained by using 1.0 time, 1.5 time, and 2.0 times the amount of starch were subjected to an XRD device measurement, and the result was presented in FIG. 35.
In FIG. 35, the treatment conditions of the samples are as follows.
No. 13; A twice amount of DVB was polymerized for 3 hours, then subjected to propylene CVD at 700°C for 2 hours, and heated at 900°C for 3 hours.
No. 34; 1.0 time the amount of starch was mixed with Na-Y type zeolite by stirring them using a rotating and revolving mixer for 1 minute, then subjected to propylene CVD at 700°C for 2 hours, and heated at 900°C for 3 hours.
No. 35; 1.5 time the amount of starch was mixed with Na-Y type zeolite by stirring them using a rotating and revolving mixer for 1 minute, then subjected to propylene CVD at 700°C for 2 hours, and heated at 900°C for 3 hours.
No. 36; 2.0 times the amount of starch was mixed with Na-Y type zeolite by stirring them using a rotating and revolving mixer for 1 minute, then subjected to propylene CVD at 700°C for 2 hours, and heated at 900°C for 3 hours.
As presented in FIG. 35, a sharp peak attributed to Na-Y type zeolite was observed at around 6° in all multiplying

amounts of starch used, suggesting that the structural transfer successfully occurred. When 2.0 time the amount of starch of No. 36 showed a yield as high as 24.8 wt% as presented in Table 11 above, there was no peak attributed to carbon at around 25°. When using 1.0 time (No. 34) or 1.5 time (No. 35) the amount of starch, there was little difference in the peak intensity therebetween. Thus, when a large amount of ZTC is synthesized using starch, starch is used preferably in an amount ranging 1.0 time to 1.5 time.

Example 13 <Preparation of Pellet, and CVD>

· An undried zeolite in an amount corresponding to 5 g of dried Na-Y type zeolite was weighed out (water content of the zeolite was about 20 wt%). Twice amount of starch that fills the pore volume (about 5.61 g) was put into a mortar and mixed using a pestle for 30 minutes. Herein, a density of starch was set to 1. 54 g/cm$^3$ equal to that of $\alpha$-D-glucose.
· An undried mixture of Na-Y type zeolite and starch was weighed out by 0.2371 g. A dry weight of the contained Na-Y type zeolite was 0. 1 g.
· A sample was put into an assembly of Stainless Used Steel (SUS) block and ring, such as a tabletting machine (manufactured by SHIMADZU CORPORATION) illustrated in FIG. 36, and pressures of 50 kN (Newton, 377 MPa), 60, 70, 80, 90, and 100 kN (Newton, 753 MPa) were applied to the sample to prepare three pellets (diameter: 13 mm) for each sample.
· A thickness of the prepared pellet was measured.
· The pellet was subjected to CVD treatment under the same condition as for DVB.
· A thickness of the prepared pellet was measured.

The weight of the sample was calculated as follows.

· Twice amount of starch that fills 5.00 g of dried Na-Y type zeolite = 2 × weight of Na-Y type zeolite × pore volume of Na-Y type zeolite × density of glucose

$$5.61\ (g) = 2 \times 5.00\ (g) \times 0.3642\ (cm^3/g) \times 1.54\ (g/cm^3)$$

· Amount of mixture used in preparing pellet based on 0.1 g of dried Na-Y type zeolite = 0.1 / (0.8 × amount of Na-Y type zeolite in preparing sample) / (total weight of sample)

$$0.2371 = 0.1\ (g) / [(0.8 \times 6.2581\ (g)) / 11.8728]$$

HF Treatment of Pellet

Sample Nos. 67 to 71

· A stirring bar was placed in a Teflon® container, an appropriate amount (10 g) of HF was added to each pellet, the container was sealed with a plastic film and a rubber band and allowed to stand for 48 hours.
· The pellet was transferred to water and allowed to stand for 24 hours.
· A thickness and a weight of the pellet were measured.
· A change in the weight of the pellet was observed by heating on a hot plate and vacuum heat drying using a mantle heater, and then an XRD measurement was performed.

Sample Nos. 73 to 77

· The pellet was pulverized, to which an appropriate amount (10 g) of HF was added, the container was sealed with a plastic film and a rubber band, and the pellet was stirred for 5 hours.

· After the HF treatment, the sample was vacuum-filtered using a plastic filtration device.
· After the filtration, the sample was transferred to a petri dish and subjected to vacuum heat drying using a vacuum drying chamber.
· An XRD measurement was performed.

Example 14 <Preparation of Pellet, and CVD>

Pellets were prepared and subjected to CVD treatment, as described above. Table 12 below presents a change between before and after CVD treatment of the pellet.

[Table 12]

| Change Between Before and After CVD of Pellet | | | | | |
|---|---|---|---|---|---|
| Sample No. | Before CVD | | | | |
| | Thickness (mm) | Weight (g) | Volume ($cm^3$) | Density ($g/cm^3$) | |
| No. 52 | 1.564 | 0.2326 | 0.2075 | 1.1210 | |
| | 1.509 | 0.2372 | 0.2002 | 1.1849 | |
| | 1.493 | 0.2361 | 0.1981 | 1.1920 | |
| No. 53 | 1.545 | 0.2369 | 0.2050 | 1.1558 | |
| | 1.462 | 0.2378 | 0.1940 | 1.2260 | |
| | 1.508 | 0.2370 | 0.2001 | 1.1847 | |
| No. 54 | 1.509 | 0.2357 | 0.2002 | 1.1774 | |
| | 1.494 | 0.2360 | 0.1982 | 1.1907 | |
| | 1.409 | 0.2364 | 0.1869 | 1.2647 | |
| No. 55 | 1.389 | 0.2359 | 0.1843 | 1.2802 | |
| | 1.391 | 0.2341 | 0.1845 | 1.2686 | |
| | 1.422 | 0.2381 | 0.1886 | 1.2621 | |
| No. 56 | 1.380 | 0.2359 | 0.1831 | 1.2885 | |
| | 1.490 | 0.2360 | 0.1977 | 1.1939 | |
| | 1.425 | 0.2372 | 0.1890 | 1.2547 | |
| No. 57 | 1.347 | 0.2367 | 0.1787 | 1.3246 | |
| | 1.434 | 0.2355 | 0.1902 | 1.2379 | |
| | 1.460 | 0.2356 | 0.1937 | 1.2164 | |
| Sample No. | After CVD | | | | Evaluation 1) |
| | Thickness (mm) | Weight (g) | Volume ($cm^3$) | Density ($g/cm^3$) | |
| No. 52 | 1.516 | 0.1242 | 0.2011 | 0.6175 | Good |
| | 1.404 | 0.1272 | 0.1863 | 0.6829 | Good |
| | 1.388 | 0.1270 | 0.1841 | 0.6897 | Good |
| No. 53 | 1.448 | 0.1271 | 0.1921 | 0.6616 | Good |
| | 1.408 | 0.1282 | 0.1868 | 0.6863 | Good |
| | 1.438 | 0.1274 | 0.1908 | 0.6678 | Good |
| No. 54 | 1.424 | 0.1271 | 0.1889 | 0.6728 | Good |
| | 1.391 | 0.1270 | 0.1845 | 0.6882 | Good |
| | 1.314 | 0.1277 | 0.1743 | 0.7326 | Good |

(continued)

| Sample No. | After CVD | | | | Evaluation 1) |
|---|---|---|---|---|---|
| | Thickness (mm) | Weight (g) | Volume ($cm^3$) | Density ($g/cm^3$) | |
| No. 55 | 1.257 | 0.1261 | 0.1668 | 0.7562 | Good |
| | 1.261 | 0.1250 | 0.1673 | 0.7472 | Good |
| | 1.307 | 0.1272 | 0.1734 | 0.7336 | Good |
| No. 56 | 1.510 | 0.1264 | 0.2003 | 0.6310 | Fair |
| | 1.469 | 0.1266 | 0.1949 | 0.6496 | Fair |
| | 1.481 | 0.1266 | 0.1965 | 0.6444 | Fair |
| No. 57 | 1.173 | 0.1264 | 0.1556 | 0.8123 | Poor |
| | 1.455 | 0.1258 | 0.1930 | 0.6517 | Poor |
| | 1.436 | 0.1265 | 0.1905 | 0.6640 | Poor |
| 1) visually evaluated as Good: No problem, Fair: Cracks on surface, Poor: Half collapse | | | | | |

In Table 12, the samples prepared as described above were treated under the following treatment conditions.

No. 52; 2.0 times the amount of starch was mixed with Na-Y type zeolite by stirring them using a rotating and revolving mixer for 1 minute, then subjected to propylene CVD at 700°C for 2 hours, and heated at 900°C for 3 hours. A pressure of 50 kN (Newton, 377 MPa) was applied to this mixture using a tabletting machine (manufactured by SHIMADZU CORPORATION) illustrated in FIG. 38 to produce three pellets (diameter: 13 mm) for each sample.

No. 53 to No. 57; A pressure of 60 kN was applied to a mixture obtained in the same manner as for No. 52 using a tabletting machine (manufactured by SHIMADZU CORPORATION) illustrated in FIG. 36 to prepare three pellets (diameter: 13 mm) for each sample.

As can be seen from Table 12, there was a great difference in the thicknesses of pellets after the CVD in the group of 50 kN to 70 kN (No. 52 to No. 54) and the group of 80 kN to 100 kN (No. 55 to No. 57), i.e. the thicknesses became thinner as a whole after CVD. Some of the group of 90 kN to 100 kN became thicker due to chipped surfaces. The weight decreased between before and after the CVD, and the reason why for this may be because a part of starch was decomposed without being adsorbed to Na-Y type zeolite. Since the pellet was broken after the CVD in the case of 90 kN or higher, it was considered that CVD was suitably performed at 80 kN or lower.

Example 15 <Study on Drying Condition for Pellet>

Pellets were prepared and dried, as described above.

Table 13 below presents weights of heated pellets, and water contents per 1 g of pellet.

[Table 13]

| Weight of Heated Pellet, and Moisture Content per 1 g of Pellet | | | | | | | | | |
|---|---|---|---|---|---|---|---|---|---|
| Process | | 0 | 1 | 2 | 3 | 4 | 5 | 6 | 7 |
| No. 67 | Weight (g) | 0.0367 | 0.0343 | 0.0340 | 0.0341 | 0.0336 | 0.0341 | 0.0340 | 0.0335 |
| | Moisture content (mg) | 95.52 | 23.88 | 14.93 | 17.91 | 2.99 | 17.91 | 14.93 | 0 |
| No. 68 | Weight (g) | 0.0372 | 0.0355 | 0.0353 | 0.0358 | 0.0352 | 0.0353 | 0.0353 | 0.0353 |
| | Moisture content (mg) | 53.82 | 5.67 | 0 | 14.16 | 2.83 | 0 | 0 | 0 |
| No. 69 | Weight (g) | 0.0331 | 0.0355 | 0.0353 | 0.0353 | 0.0346 | 0.0350 | 0.0352 | 0.0353 |
| | Moisture content (mg) | 79.32 | 5.67 | 0 | 0 | -19.83 | -8.50 | -2.83 | 0 |
| No. 70 | Weight (g) | 0.0359 | 0.0343 | 0.0348 | 0.0343 | 0.0336 | 0.0347 | 0.0341 | 0.0339 |
| | Moisture content (mg) | 53.10 | 11.80 | 26.55 | 11.80 | -8.85 | 23.60 | 5.90 | 0 |

(continued)

| Weight of Heated Pellet, and Moisture Content per 1 g of Pellet | | | | | | | | | |
|---|---|---|---|---|---|---|---|---|---|
| Process | | 0 | 1 | 2 | 3 | 4 | 5 | 6 | 7 |
| No. 72 | Weight (g) | 0.0308 | 0.0293 | 0.0293 | 0.0293 | 0.0283 | 0.0294 | 0.0286 | 0.0293 |
| | Moisture content (mg) | 51.19 | 0 | 0 | 0 | -34.13 | 3.41 | -23.89 | 0 |

In Table 13 above, each step is as follows.

Step 0: The pellet was weighed after HF treatment
Step 1: The pellet was heated to 50°C over 2 h using a hot plate
Step 2: The temperature was maintained at 50°C for 2 hours
Step 3: The temperature was raised from 50°C to 70°C at 1°C/min
Step 4: The temperature was maintained at 70°C for 3 hours
Step 5: The temperature was raised to 100°C at 1°C/min
Step 6: The temperature was maintained at 100°C for 2 hours.
Step 7: The pellet was heated to 100°C at 1°C/min by vacuum heat drying using a mantle heater, and the temperature was maintained for 6 hours

Water content (mg) per 1 g of pellet based on Step 7 = (weight of each step (g) - weight of step 7 (g)) × 1000 / weight of Step 7 (g).

[Table 14]

| Relationship between Force (kN), Pressure (MPa), and Density ($cm^3/g$) during Pellet Heating | | | | |
|---|---|---|---|---|
| Experiment No. | Force (kN) | Pressure (MPa) | Density ($cm^3/g$) after reduced-pressure heat drying | |
| | | | Result of first experiment | Result of second experiment |
| 67 | 50 | 376.7 | 0.1782 | 0.2058 |
| 68 | 60 | 452.0 | 0.2117 | 0.2162 |
| 69 | 70 | 527.4 | 0.2072 | 0.2140 |
| 70 | 80 | 602.7 | 0.2117 | 0.2068 |
| 72 | 90 | 678.1 | 0.1886 | |

Example 16 <Study on Drying Condition for Pellet>

The drying conditions for the pellets obtained above were studied, and the result was presented in FIG. 37.
For the samples, the same samples as those in Table 14 were used.
Based on the weight of Step 7, it can be seen that almost whole water was removed from Step 0 to Step 1. Also, it can be seen that, from Step 3 to Step 4, the water content became close to the water content in Step 7. Thus, it is considered that it only needs to take a time to raise the temperature for drying the pellet, and heating at a high temperature for a long period of time is not necessary.

Water content (mg) per 1 g of pellet based on Step 7 = (weight of each step (g) - weight of step 7 (g)) × 1000 / weight of Step 7 (g).

Example 17 <Study on Drying Condition for Pellet>

Pellets were prepared and dried, as described above.
Table 15 below presents thicknesses, weights, volumes, and densities of the pellets, before and after the CVD, after the HF treatment, and after the vacuum heat drying.

[Table 15]

| Thickness, Weight, Volume, and Density of Pellet Power Before and After Each Treatment | | | | |
|---|---|---|---|---|
| Sample No. | Before CVD | | | |
| | Thickness (mm) | Weight (g) | Volume ($cm^3$) | Density ($g/cm^3$) |
| No. 67 | 1.564 | 0.2326 | 0.2075 | 1.1210 |
| No. 68 | 1.545 | 0.2369 | 0.2050 | 1.1558 |
| No. 69 | 1.509 | 0.2357 | 0.2002 | 1.1774 |
| No. 70 | 1.389 | 0.2359 | 0.1843 | 1.2802 |
| No. 71 | 1.380 | 0.2359 | 0.1831 | 1.2885 |
| Sample No. | After CVD | | | |
| | Thickness (mm) | Weight (g) | Volume ($cm^3$) | Density ($g/cm^3$) |
| No. 67 | 1.516 | 0.1242 | 0.2011 | 0.6175 |
| No. 68 | 1.448 | 0.1271 | 0.1921 | 0.6616 |
| No. 69 | 1.424 | 0.1271 | 0.1889 | 0.6728 |
| No. 70 | 1.257 | 0.1261 | 0.1668 | 0.7562 |
| No. 71 | 1.510 | 0.1264 | 0.2003 | 0.6310 |
| Sample No. | After HF treatment | | | |
| | Thickness (mm) | Weight (g) | Volume ($cm^3$) | Density ($g/cm^3$) |
| No. 67 | 1.426 | 0.0367 | 0.1892 | 0.1940 |
| No. 68 | 1.260 | 0.0372 | 0.1672 | 0.2225 |
| No. 69 | 1.284 | 0.0381 | 0.1703 | 0.2237 |
| No. 70 | 1.212 | 0.0359 | 0.1608 | 0.2233 |
| No. 71 | 1.256[1)] | 0.0370, 0.0308 | 0.1666 | 0.2221 |
| 1) Pellet collapsed during HF treatment, and therefore fragments were measured. | | | | |
| Sample No. | After vacuum heat drying | | | |
| | Thickness (mm) | Weight (g) | Volume ($cm^3$) | Density ($g/cm^3$) |
| No. 67 | 1.417 | 0.0335 | 0.1880 | 0.1782 |
| No. 68 | 1.257 | 0.0353 | 0.1668 | 0.2117 |
| No. 69 | 1.284 | 0.0353 | 0.1703 | 0.2072 |
| No. 70 | 1.207 | 0.0339 | 0.1601 | 0.2117 |
| No. 71 | 1.171 | 0.0293 | 0.1554 | 0.1886 |

For the samples, the same samples as those in Table 13 were used.

Carbon Yield after HF Treatment

Table 16 presents carbon yields of the ZTC after the HF treatment. In Table 16, weight percentages of the ZTC of No. 67 to 71 were calculated from a change in the weight between before the HF treatment and after the vacuum heat drying, and weight percentages of the ZTC of No. 73 to 77 were calculated from a change in the weight between before and after the HF treatment.

[Table 16]

| Weight Percentage (wt%) of ZTC | |
|---|---|
| Carbon yield after HF treatment | |
| Sample No. | ZTC (% by weight) |
| No. 67 | 27.0 |
| No. 68 | 27.8 |
| No. 69 | 27.8 |
| No. 70 | 26.9 |
| No. 71 | - (Not measured) 1) |
| No. 73 2) | 20.9 |
| No. 74 2) | 21.9 |
| No. 75 2) | 20.5 |
| No. 76 2) | 21.8 |
| No. 77 2) | 22.1 |
| 1) Not measured because the pellet partially flaked during HF treatment, and the weight before HF treatment could not be used.<br>2) No. 73 to No. 77 were subjected to HF treatment after pulverizing the pellet. | |

As can be seen from Table 16, No. 67 to No. 71 as pellets treated with HF had higher yields than those of No. 73 to No. 77. The reason why for this may be because carbon is also contained in the bonds between the particles that form the pellets.

XRD Measurement

As described above, various samples as pellets treated with HF were subjected to an XRD device measurement, and the results were presented in FIG. 38 and FIG. 39. Among the samples, No. 67 to No. 69 were measured as pellets, and No. 73 to No. 77 were measured after the pellets were pulverized. Arai No. 66 is a powdery ZTC obtained by the initial synthesis operation using DVB, and an adsorption duration and a polymerization duration of DVB were both set to 24 hours.

In FIG. 38, the pellet samples prepared as described above were treated under the following treatment conditions.

No. 66 ZTC; 1.05 time the amount of DVB was polymerized, then subjected to propylene CVD at 700°C for 2 hours, and heated at 900°C for 3 hours.

No. 67 to No. 69; For the samples, the same samples as those in Table 15 were used.

In FIG. 39, the pellet samples prepared as described above were treated under the following treatment conditions. Note that all of the samples No. 73 to No. 77 were subjected to the XRD measurement after the pellets were pulverized and then treated with HF.

No. 66-1 ZTC; 1.05 time the amount of DVB was polymerized, then subjected to propylene CVD at 700°C for 2 hours, and heated at 900°C for 3 hours.

No. 73 to No. 77; For the samples, the same samples as those in Table 15 were used.

XRD Measurement

As described above, various samples as pellets treated with HF were subjected to an XRD device measurement, and the results were presented in FIG. 40 and FIG. 41. Among the samples, No. 67 to No. 69 were measured as pellets, and No. 73 to No. 77 were measured after the pellets were pulverized. Arai No. 66 is a powdery ZTC obtained by the initial synthesis operation using DVB, and an adsorption duration and a polymerization duration of DVB were both set to 24 hours.

In FIG. 40, the pellet samples prepared as described above were treated under the following treatment conditions.

No. 66 ZTC; 1.05 time the amount of DVB was polymerized, then subjected to propylene CVD at 700°C for 2 hours, and heated at 900°C for 3 hours.
No. 67 to No. 69; For the samples, the same samples as those in Table 15 were used.
In FIG. 41, the pellet samples prepared as described above were treated under the following treatment conditions. Note that all of the samples No. 73 to No. 77 were subjected to the XRD measurement after the pellets were pulverized and then treated with HF.
No. 66-1 ZTC; 1.05 time the amount of DVB was polymerized, then subjected to propylene CVD at 700°C for 2 hours, and heated at 900°C for 3 hours.
No. 73 to No. 77; For the samples, the same samples as those in Table 15 were used.
As can be seen from FIG. 40 and FIG. 41, there is a sharp peak attributed to Na-Y type zeolite at 2θ of 6°, suggesting that the structural transfer occurred.
The higher the pressure applied during preparation of the sample pellet is, the weaker the peak intensity is. The reason for this may be because, when the pressure is high, the particles become too dense, and carbon is not sufficiently deposited during CVD.

XRD Measurement

As described above, various samples as pellets treated with HF were subjected to an XRD device measurement, and the results were presented in FIG. 42 and FIG. 43. Among the samples, No. 67 to No. 69 were measured as pellets, and No. 73 to No. 77 were measured after the pellets were pulverized. Arai No. 66 is a powdery ZTC obtained by the initial synthesis operation using DVB, and an adsorption duration and a polymerization duration of DVB were both set to 24 hours.
In FIG. 42, the pellet samples prepared as described above were treated under the following treatment conditions.
No. 66 ZTC; 1.05 time the amount of DVB was polymerized, then subjected to propylene CVD at 700°C for 2 hours, and heated at 900°C for 3 hours.
No. 67 to No. 69; For the samples, the same samples as those in Table 15 were used.
In FIG. 43, the pellet samples prepared as described above were treated under the following treatment conditions. Note that all of the samples No. 73 to No. 77 were subjected to the XRD measurement after the pellets were pulverized and then treated with HF.
No. 66-1 ZTC; 1.05 time the amount of DVB was polymerized, then subjected to propylene CVD at 700°C for 2 hours, and heated at 900°C for 3 hours.
No. 73 to No. 77; For the samples, the same samples as those in Table 15 were used.
In FIG. 42 and FIG. 43, No. 67 to No. 69 show a broad peak at around 10° to 20° and a sharp peak at around 39° and 45°, but, No. 73 to No. 77 show no peak. Thus, these peaks are considered to be attributed to the surface of the pellet.
Faint white spots could be visually observed on the surface of the pellet after the HF treatment.
No. 73 to No. 77 show a sharp peak at around 18°, but No. 67 to No. 69 show no peak. Thus, it is found that this peak is attributed to substances different from impurities on the pellet surface.
Broad peaks at around 25° and 43° are attributed to face (002) and face (10) of carbon formed between zeolite particles.

<Result of Study on ZTC Synthesis Using Sugar, and Elucidation for Mechanism of ZTC Formation>

Examples 18 to 21

Sample Synthesis

As sugars, α-D-glucose, β-D- glucose, D-xylose, D-sucrose, and D-fructose were used. The amount of the sugar in a volume equivalent to the total pore volume (0. 32 mL) of the zeolite used was defined as an amount of 1.0 time.
The ZTC was synthesized as follows.

1. About 500 mg of NaY type zeolite was previously subjected to reduced-pressure heat drying at 150°C, and a dry weight of NaY type zeolite was measured.
2. The sugar was weighed out and mixed with NaY type zeolite at 2000 rpm for 1 minute.
3. The mixed powder of the sugar and NaY type zeolite was placed in an electric furnace, heated to 700°C at 10°C/min, then subjected to propylene CVD for 2 hours, subsequently the temperature was raised to 900°C at 5°C/min to perform a heat treatment of the powder for 3 hours.

4. The NaY-type zeolite-carbon composite was stirred in 20 g of hydrofluoric acid for 5 hours, then filtered, and subjected to reduced-pressure heat drying at 150°C for 6 hours.

The obtained ZTC synthesized product was analyzed by an XRD measurement, a nitrogen adsorption/desorption measurement, a TG-DTA simultaneous measurement, a TEM observation, and Raman spectroscopy, as described below.

Example 18

<Result of NaY/α-D-Glucose-P7 (2)-H9 (3) System>

The analysis results of synthesized samples are described below. As the synthesis history of the samples described in the results, for example, "NaY/α-D-glucose-P7 (2)-H9 (3)" means a sample obtained by a process in which Na-Y type zeolite and α-D-glucose are subjected to propylene CVD at 700°C for 2 hours and heated at 900°C for 3 hours. The same applies to the following.

In the present description, "α-Glu-(X)-P" (herein, X indicates the amount of sugar) and the like are expressed as sample notations. In the present description, regarding the sample notation, the sugar content is expressed in an abbreviation notation method in some cases.

FIG. 44 presents a result of an XRD device measurement of ZTC samples obtained varying an amount (multiplying amount) of α-D-glucose relative to an amount of Na-Y type zeolite, in which the abscissa (X-axis) indicates a diffraction angle 2θ (unit: ° (degree)) of CuKα ray, and the ordinate (Y-axis) indicates an intensity (unit: optional).

FIG. 45 is an enlarged graph showing a measurement result with the diffraction angle 2θ of around 6.4°.

From this result, the peak of face (002) could not be observed.

FIG. 46 presents a result a nitrogen adsorption/desorption isothermal line measurement of the obtained ZTC samples, in which the abscissa (X-axis) indicates P/P0, and the ordinate (Y-axis) indicates a volume adsorbed (unit: $cm^3$ (STP)/g). In FIG. 46, the samples appended with "P" were synthesized only by propylene CVD without using any α-D- glucose.

FIG. 47 presents a result of a pore diameter distribution measurement of the obtained ZTC samples according to DFT method, in which the abscissa (X-axis) indicates a pore diameter (unit: nm), and the ordinate (Y-axis) indicates an incremental pore volume (unit: $cm^3$/g).

FIG. 48 presents a result of a nitrogen adsorption/desorption measurement (BET surface area) of the obtained ZTC samples and a result of a TG measurement of a zeolite/carbon composite, in which the abscissa (X-axis) indicates an amount of α-D-glucose, and the left side of the ordinate (Y-axis) indicates a carbon fraction (unit: g/gNaY), and the right side of the ordinate (Y-axis) indicates a BET surface area (unit: $m^2$/g).

FIG. 49-1 and FIG. 49-2 present TEM photographs of ZTC samples denoted as α-Glu (1.0)-P (1.0 time the amount of α-D-glucose was used) and α-Glu (1.4)-P (1.4 time the amount of α-D-glucose was used) respectively. The white bar in the diagram indicates 20 nm length. The samples were obtained by propylene CVD, as the "-P" is appended in the sample notation.

In FIG. 49-2, no carbon was observed on the outer surface.

Surface Area and Pore Volume

A result of a nitrogen adsorption/desorption measurement of the ZTC samples obtained above, and a result of a TG measurement of the zeolite/carbon composite are presented in Table 17 below.

[Table 17]

| Result of Nitrogen Adsorption/Desorption Measurement of Each Sample, and Result of TG Measurement of Zeolite/Carbon Composite | | | | | |
|---|---|---|---|---|---|
| Sample | $S_{BET}{}^{a}$ ($m^2$/g) | $V_{total}{}^{b}$ ($cm^3$/g) | $V_{micro}{}^{c}$ ($cm^3$/g) | $V_{meso}{}^{d}$ ($cm^3$/g) | Carbon fraction[e] (g/$g_{zeolite}$) |
| α-Glu (0.6)-P | 3670 | 1.78 | 1.52 | 0.26 | 0.289 |
| α-Glu (0.8)-P | 3730 | 1.70 | 1.56 | 0.14 | 0.292 |
| α-Glu (1.0)-P | 3950 | 1.75 | 1.66 | 0.09 | 0.298 |
| α-Glu (1.2)-P | 3820 | 1.71 | 1.61 | 0.09 | 0.304 |

(continued)

| Result of Nitrogen Adsorption/Desorption Measurement of Each Sample, and Result of TG Measurement of Zeolite/ Carbon Composite | | | | | |
|---|---|---|---|---|---|
| Sample | $S_{BET}$[a] ($m^2/g$) | $V_{total}$[b] ($cm^3/g$) | $V_{micro}$[c] ($cm^3/g$) | $V_{meso}$[d] ($cm^3/g$) | Carbon fraction[e] ($g/g_{zeolite}$) |
| α-Glu (1.4)-P | 3730 | 1.63 | 1.59 | 0.04 | 0.306 |
| P (without α-D-Glu) | 2330 | 1.30 | 0.93 | 0.37 | 0.135 |
| α-Glu (1.0) (without CVD) | 1470 | 0.83 | 0.58 | 0.24 | 0.135 |
| [a]calculated from $P/P_0$ = 0.01 to 0.05<br>[b]calculated from nitrogen adsorption amount at $P/P_0$=0.96<br>[c]calculated from $P/P_0$=0.001 to 0.050 by DR method<br>[d]calculated from $V_{meso}=V_{total} - V_{micro}$<br>[e] amount of carbon per 1 g of carbon fraction: NaY type zeolite | | | | | |

As can be seen from Table 17, the samples of α-Glu (0.6)-P to α-Glu (1.4)-P had a sufficient BET specific surface area of 3670 $m^2/g$ to 3950 $m^2/g$ and a high micropore volume. In particular, the samples of α-Glu (0.8)-P to α-Glu (1.4)-P had a high BET specific surface area of 3730 $m^2/g$ or higher as a result.

From the above results, the mechanism of ZTC formation was presumed as illustrated in FIG. 50. Note that this surmise is merely an example of the present invention, and the present invention is not limited to this surmise.

Example 19

<Result of XRD Measurement of NaY/Sugar-P7 (2)-H9 (3) System>

FIG. 51 presents a result of an XRD device measurement of ZTC samples obtained varying an amount (multiplying amount) of β-D-glucose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of FIG. 51 is an enlarged graph showing a measurement result with the diffraction angle 2θ of around 6.4°. As a reference, a result with 1.0 time the amount of α-D- glucose is also presented. The samples were obtained by propylene CVD, as the "-P" is appended in the sample notation.

FIG. 52 presents a result of an XRD device measurement of ZTC samples obtained varying an amount (multiplying amount) of D-xylose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of FIG. 52 is an enlarged graph showing a measurement result with the diffraction angle 2θ of around 6.4°. As a reference, a result with 1.0 time the amount of α-D- glucose is also presented. The samples were obtained by propylene CVD, as the "-P" is appended in the sample notation.

FIG. 53 presents a result of an XRD device measurement of ZTC samples obtained varying an amount (multiplying amount) of pulverized D-fructose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of FIG. 53 is an enlarged graph showing a measurement result with the diffraction angle 2θ of around 6.4°. As a reference, a result with 1.0 time the amount of α-D- glucose is also presented. The samples were obtained by propylene CVD, as the "-P" is appended in the sample notation.

FIG. 54 presents a result of an XRD device measurement of ZTC samples obtained varying an amount (multiplying amount) of pulverized D-sucrose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of FIG. 54 is an enlarged graph showing a measurement result with the diffraction angle 2θ of around 6.4°. As a reference, a result with 1.0 time the amount of α-D- glucose is also presented. The samples were obtained by propylene CVD, as the "-P" is appended in the sample notation.

FIG. 55 presents a result of a nitrogen adsorption/desorption isothermal line measurement of ZTC samples obtained using various sugars presented in the diagram, in which the abscissa (X-axis) indicates P/P0, and the ordinate (Y-axis) indicates a volume adsorbed (unit: $cm^3$ (STP)/g). The samples were obtained by propylene CVD, as the "-P"

is appended in the sample notation.

FIG. 56 presents a result of a pore diameter distribution measurement of ZTC samples obtained using various sugars presented in the diagram according to DFT method, in which the abscissa (X-axis) indicates a pore diameter (unit: nm), and the ordinate (Y-axis) indicates an incremental pore volume (unit: $cm^3/g$).

From the above results, it was found that all of the ZTC synthesized using the sugar showed the maximum peak intensity at 6.4 degrees (°) when 1.0 time the amount of sugar was used. Also, it was found that there was little change in the peak intensity at 6.4 degrees (°) even when using more than 1.0 time the amount of sugar.

In all samples described above, a peak of face (002) could not be confirmed.

[Table 18]

| Sample | $S_{BET}{}^{a}$ ($m^2/g$) | $V_{total}{}^{b}$ ($cm^3/g$) | $V_{micro}{}^{c}$ ($cm^3/g$) | $V_{meso}{}^{d}$ ($cm^3/g$) | Carbon fraction[e] ($g/g_{zeolite}$) |
|---|---|---|---|---|---|
| β-Glu (1.0)-P | 3810 | 1.72 | 1.60 | 0.12 | 0.297 |
| Xyl (1.0)-P | 3940 | 1.60 | 1.65 | 0.02 | 0.298 |
| Fru (1.0)-P | 3740 | 1.63 | 1.57 | 0.06 | 0.289 |
| Suc (1.0)-P | 3830 | 1.71 | 1.61 | 0.10 | 0.292 |
| [a]calculated from $P/P_0$ = 0.01 to 0.05<br>[b]calculated from nitrogen adsorption amount at $P/P_0$=0.96<br>[c] calculated from $P/P_0$=0.001 to 0.050 by DR method<br>[d] calculated from $V_{meso}= V_{total} - V_{micro}$ | | | | | |

According to Table 18, it was found that a ZTC having a high surface area could be obtained by using 1.0 time the amount of sugar.

It was observed that fructose had a ZTC surface area slightly inferior to those of other sugars. The reason for this may be because fructose has a low melting point.

<SEM Photograph of Sugar>

FIG. 57-1 to 57-7 present SEM photographs of samples: α-D-glucose, β-D-glucose, D-xylose, D-fructose, pulverized D-fructose, D-sucrose, and pulverized D-sucrose. The scale bars (white bars) in the diagrams all indicate 200 nm length.

In consideration of the SEM photographs of the sugars and the results of the surface area measurement of the ZTC obtained using each sugar, the conditions for obtaining a ZTC having a high surface area exceeding 3800 $m^2/g$ are presumed as follows.

· It is considered that the sugar used for the ZTC synthesis may be carbonized before its adsorption on NaY type zeolite is completed unless the sugar is pulverized to a size of 200 μm or smaller.

· It is considered that, among the sugars used for the ZTC synthesis, fructose having a low melting point shows no or little effect even if pulverized, because fructose melts before adsorption even through sufficient pulverization.

<Result of Raman Spectroscopy Analysis of NaY/sugar-P7 (2)-H9 (3) System>

FIG. 58 presents a result of analyzing ZTC samples synthesized using α-D-glucose by Raman spectroscopy.

FIG. 59 presents a result of Raman spectroscopy analysis of ZTC samples synthesized using 1.0 time the amount of sugars presented in the diagram.

As can be seen from the results presented in FIG. 58 and FIG. 59, the α-D-glucose systems show the same G band/D band (G/D) ratio even with a small amount of the sugar or even without CVD. Thus, it can be confirmed that nanographene is produced from α-D-glucose inside the zeolite pores even without CVD treatment.

It was found that the ZTC synthesized using 1.0 time the amount of a sugar other than α-D-glucose also showed the same G/D ratio as that of α-D-Glu (1.0).

Example 20

<Comparison of Sugar between Before and After Pulverization (Result of XRD Measurement)>

FIG. 60-1 presents a result of an XRD device measurement of ZTC samples obtained varying an amount (multiplying amount) of pre-pulverization D-fructose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of FIG. 60-1 is an enlarged graph showing a measurement result with the diffraction angle 2θ of around 6.4°. As a reference, a result with 1.0 time the amount of α-D- glucose is also presented.
FIG. 60-2 presents a result of an XRD device measurement of ZTC samples obtained by previously pulverizing D-fructose on the left side of the diagram, in which the abscissa (X-axis) and the ordinate (Y-axis) are the same as those in FIG. 60-1. The right side of
FIG. 60-2 is also the same as the right side of FIG. 60-1. As a reference, a result of a sample treated with 1.0 time the amount of α-D- glucose is also presented.
FIG. 61-1 presents a result of an XRD device measurement of ZTC samples obtained varying an amount (multiplying amount) of pre-pulverization D-sucrose relative to an amount of Na-Y type zeolite on the left side of the diagram, in which the abscissa (X-axis) indicates a diffraction angle 2θ (unit: ° (degree)) of CuKα ray, and the ordinate (Y-axis) indicates an intensity (unit: optional). The right side of FIG. 60-1 is an enlarged graph showing a measurement result with the diffraction angle 2θ of around 6.4°. As a reference, a result with 1.0 time the amount of α-D- glucose is also presented.
FIG. 61-2 presents a result of an XRD device measurement of ZTC samples obtained by previously pulverizing D-sucrose on the left side of the diagram, in which the abscissa (X-axis) and the ordinate (Y-axis) are the same as those in FIG. 60-1. The right side of
FIG. 60-2 is also the same as the right side of FIG. 60-1. As a reference, a result of a sample treated with 1.0 time the amount of α-D- glucose is also presented.
As can be seen from the results presented in FIG. 60-1, FIG. 60-2, and FIG. 61-1 to FIG. 61-2, the structural regularity of the ZTC is increased by pulverizing sucrose into a size of 200 μm or smaller.
It is presumed that the surface area based on the peak intensity at 6.4 degrees (°) can be predicted by combination with other analysis data, e.g. data such as a dissolution temperature in the case of fructose.

<Comparison of Sugar between Before and After Pulverization (Result of Nitrogen Adsorption/Desorption Measurement)>

FIG. 62 presents a result of a nitrogen adsorption/desorption isothermal line measurement of ZTC samples obtained by using pulverized fructose (denoted as "After pulverization") and non-pulverized fructose (denoted as "No pulverization") on Na-Y type zeolite, in which the abscissa (X-axis) indicates P/PO and the ordinate (Y-axis) indicates a volume adsorbed (unit: $cm^3$ (STP)/g). As a reference, a result of a sample treated with 1.0 time the amount of α-D-glucose is also presented.
FIG. 63 presents a result of a pore diameter distribution measurement of ZTC samples obtained by using pulverized fructose (denoted as "After pulverization") and non-pulverized fructose (denoted as "No pulverization") on Na-Y type zeolite according to DFT method, in which the abscissa (X-axis) indicates a pore diameter (unit: nm) and the ordinate (Y-axis) indicates an incremental pore volume (unit: $cm^3/g$). As a reference, a result of a sample treated with 1.0 time the amount of α-D- glucose is also presented.
FIG. 64 presents a result of a nitrogen adsorption/desorption isothermal line measurement of ZTC samples obtained varying amounts of pulverized D-sucrose (denoted as "After pulverization") and non-pulverized D-sucrose (denoted as "No pulverization") relative to an amount of Na-Y type zeolite, in which the abscissa (X-axis) indicates P/PO and the ordinate (Y-axis) indicates a volume adsorbed (unit: $cm^3$ (STP)/g). As a reference, a result of a sample treated with 1.0 time the amount of α-D-glucose is also presented.
FIG. 65 presents a result of a pore diameter distribution measurement of ZTC samples obtained varying amounts of pulverized D-sucrose (denoted as "After pulverization") and non-pulverized D-sucrose (denoted as "No pulverization") relative to an amount of Na-Y type zeolite according to DFT method, in which the abscissa (X-axis) indicates a pore diameter (unit: nm) and the ordinate (Y-axis) indicates an incremental pore volume (unit: $cm^3/g$). As a reference, a result of a sample treated with 1.0 time the amount of α-D- glucose is also presented.
As can be seen from the results presented in FIG. 62 to FIG. 65, the effect with pulverization is low for fructose but is clearly high for sucrose.

Example 21

<Result of TG Measurement of NaY/1.0 Time Sugar Mixed Powder>

· Result of α-D-glucose system (under nitrogen atmosphere, temperature raising rate: 10°C/min )

FIG. 66 to FIG. 68 present analysis results of a TG-DTA simultaneous measurement. In
FIG. 66, NaY zeolite and α-D-glucose were used. In FIG. 67, a sample of a mixture of NaY zeolite and α-D-glucose was used. In FIG. 68, a sample of NaY zeolite and α-D-glucose was used.

In FIG. 68, the experimental result substantially coincides with the fitted result up to around 250°C, and it is considered that α-D-glucose is adsorbed to NaY zeolite at 250°C or lower.
The samples were prepared by adding 1.0 time the amount of sugar (α-D-glucose) to previously-dried NaY zeolite and stirring the mixture at 2000 rpm for 1 minute. The following samples were also regulated in the same manner as above.
Furthermore, the measurement conditions of the TG-DTA simultaneous measurement are as follows, and the same applies to the subsequent measurements.

Measurement device: DTG-60H (manufactured by SHIMADZU CORPORATION)

A nitrogen flow rate was set to 100 mL/min.
Temperature program: after maintaining room temperature for 30 minutes, the temperature is raised to 500°C at 10°C/min. When the temperature reaches 500°C, the temperature is maintained for 1 hour and then lowered to room temperature.
The analysis was performed by a method in which each of the sugar and NaY type zeolite were measured, and additionally, an exothermic peak attributed to adsorption of the sugar was created based on a Gaussian function, and the sugar, the NaY type zeolite, and the Gaussian function were fitted so as to coincide with the DTA pattern of the actual measurement result.
FIG. 69 presents a result of a nitrogen adsorption/desorption isothermal line measurement of samples obtained by treating a mixture of NaY type zeolite and α-D-glucose at 200°C, 300°C, and 400°C, in which the abscissa (X-axis) indicates P/PO and the ordinate (Y-axis) indicates a volume adsorbed (unit: $cm^3$ (STP)/g). As a reference, a result of an Na-Y type zeolite sample is also presented.

<Result of TG Measurement of Sugar Alone and NaY/1.0 Time Sugar Mixed Powder>

The sugars have the following melting points.

A-D-glucose: 153 to 156°C
B-D-glucose: 155°C
D-xylose: 151°C
D-sucrose: 187°C
D-fructose: 104°C

FIG. 70 to FIG. 74-2 present analysis results of TG-DTA. In FIG. 70, only sugar was used. In FIG. 71, NaY type zeolite, β-D-glucose, and a sample of mixture of NaY type zeolite and β-D-glucose (amount of β-D-glucose: 1.0 time) were used. In FIG. 72, NaY type zeolite, D-xylose, and a sample of a mixture of NaY type zeolite and D-xylose (amount of D-xylose: 1.0 time) were used. In FIG. 73-1, NaY type zeolite, D-sucrose (non-pulverized), and a sample of a mixture of NaY type zeolite and D-sucrose (non-pulverized) (amount of D-sucrose: 1.0 time) were used. In FIG. 73-2, NaY type zeolite, D-fructose (after pulverization), and a sample of a mixture of NaY type zeolite and D-sucrose (after pulverization) (amount of D-sucrose: 1.0 time) were used. In FIG. 74-1, NaY type zeolite, D-fructose (before pulverization), and a sample of a mixture of NaY type zeolite and D-fructose (before pulverization) (amount of D-fructose: 1.0 time) were used. In FIG. 74-2, NaY type zeolite, D-fructose (after pulverization), and a sample of a mixture of NaY type zeolite and D-fructose (after pulverization) (amount of D-fructose: 1.0 time) were used.
In FIG. 71, the experimental result substantially coincides with the fitted result up to around 250°C, and it is considered that β-D-glucose is adsorbed to NaY zeolite at 250°C or lower.
In FIG. 72, the experimental result extremely coincides with the fitted result up to around 250°C, and it is considered that D-xylose is adsorbed to NaY zeolite at 250°C or lower.
In FIG. 73-1, the experimental result insufficiently coincides with the fitted result. Since the peak intensity of

the Gaussian function is low, it is considered that D-sucrose before pulverization has a large particle diameter and is insufficiently adsorbed to zeolite. In FIG. 73-2, the experimental result substantially coincides with the fitted result, and the Gaussian function shows a sharp peak. Thus, it is considered that the particle diameter of D-sucrose became small after pulverization, and D-sucrose could be adsorbed to zeolite like α-D-glucose, β-D-glucose, and D-xylose.

In FIG. 74-1, the experimental result insufficiently coincides with the fitted result, and the peak of the Gaussian function is small, therefore it is considered that D-fructose is hardly adsorbed to NaY type zeolite because D-fructose has a large particle diameter like sucrose, or D-fructose has a low melting point. From the result of FIG. 74-2, although D-fructose was pulverized to decrease its particle diameter, a significant change was not observed. It is considered that D-fructose melted before being adsorbed to NaY-type zeolite and thereby increased in the particle diameter, and the result in FIG. 74-2 showed no significant difference from the result of D-fructose (before pulverization) in FIG. 74-1.

The results in FIG. 70 to FIG. 74-2 suggest the followings.

· Immediately after the sugar melts, adsorption of the sugar to NaY type zeolite begins. · Sucrose before pulverization is hardly adsorbed to NaY type zeolite.
· Fructose melts before adsorption due to its low melting point. Thus, even if ZTC is synthesized using pulverized fructose, the effect of the ZTC is low.
· In all cases, it is presumed that adsorption of the sugar to NaY type zeolite has been completed at 300°C or lower.

<Result of Nitrogen Adsorption/Desorption Measurement of Sample Prepared by

Heating Mixed Powder of NaY/1.0 Time the Amount of Sugar at 300°C>

The sample was prepared by a process in which 1.0 time the amount of sugar and NaY type zeolite were mixed, the mixture was heated to 300°C at 10°C/min, and then cooled.

FIG. 75 presents a result of a nitrogen adsorption/desorption isothermal line measurement of each sample obtained using, on Na-Y type zeolite, any of:

Fructose (NaY/Fru (1.0) (300°C))
Xylose (NaY/Xyl (1.0) (300°C))
α-D-Glucose (NaY/α-D-Glc (1.0) (300°C))
β-D-Glucose (NaY/β-D-Glc (1.0) (300°C))
Sucrose (NaY/Suc (1.0) (300°C))

in which the abscissa (X-axis) indicates P/PO and the ordinate (Y-axis) indicates a volume adsorbed (unit: $cm^3$ (STP)/g). All of the sugars were used after pulverization. As a reference, a result (NaY) of Na-Y type zeolite that have been heated at 150°C for 90 minutes and maintained at that temperature for 6 hours is also presented.

[Table 19]

BET Surface Area ($S_{BET}$) and Whole Pore Volume ($V_{total}$)

| Samples | $S_{BET}$ ($m^2g^{-1}$) | $V_{total}$ ($cm^3\ g^{-1}$) |
|---|---|---|
| NaY zeolite | 700 | 0.324 |
| NaY/α-Glu (1.0) | 11 | 0.01 |
| NaY/β-Glu (1.0) | 18 | 0.01 |
| NaY/Xyl (1.0) | 24 | 0.02 |
| NaY/Fru (1.0) | 49 | 0.03 |
| NaY/Suc (1.0) | 7 | 0.01 |

From the above results, assuming that no sugar is adsorbed, a theoretical surface area of the mixed powder calculated from a dry weight of Na-Y type zeolite, a weight of the mixed powder after heating, and a surface area of Na-Y type zeolite (700 $m^2$/g) is 533 to 564 $m^2$/g. Since the surface area is actually 50 $m^2$/g or lower, it is understood that the sugar is adsorbed to Na-Y type zeolite at 300°C or lower.

<Result of Study on ZTC Synthesis Using Sugar, and Elucidation for Mechanism of ZTC Formation>

The results in Examples 18 to 21 above suggest the followings.

· For all sugars used, the use of 1.0 time the amount of the sugar that fills pores of the zeolite makes it possible to obtain a ZTC having a surface area of higher than 3700 m2/g.

· When α-D-glucose, β-D-glucose, D-xylose, or D-sucrose is used, adsorption occurs simultaneously with melting of the sugar, and adsorption of the sugar is completed at 300°C or lower.

· It is considered that, unless D-sucrose is pulverized so as to have a particle diameter of 200 μm or smaller, sucrose is carbonized on the surfaces of the zeolite particles before adsorption of the sugar.

· It is considered that, since fructose having the lowest melting point of 104°C melts before adsorption to the zeolite, fructose is less affected by pulverization. However, regardless of the presence or absence of pulverization, a ZTC having a surface area of higher than 3700 $m^2/g$ was obtained. The melting point of the sugar is preferably 150°C or higher.

· It is considered that, in synthesis of the ZTC using the sugar, nanographene is produced from sugar inside the zeolite pores, and formation of ZTC is completed by extension and connection of nanographene through CVD.

Examples 22 to 25

<Results of Study on ZTC Synthesis Using Starch and Cellulose, and Elucidation for Mechanism of ZTC Formation>

The ZTC samples were synthesized as follows.

As the sugar, a polysaccharide of starch and cellulose was used.

For the sugar used, the same weight as the weight of 1.0 time the amount of α-D-glucose was defined as an amount of 1.0 time.

The synthetic formulation of the ZTC sample includes the following procedure.

1. About 500 mg of NaY type zeolite was previously subjected to reduced-pressure heat drying at 150°C, and a dry weight of NaY type zeolite was measured.
2. A sugar for use was weighed out and mixed with NaY type zeolite. The mixing was performed at 2000 rpm for 1 min.
3. The mixed powder of the sugar and NaY type zeolite was placed in an electric furnace, heated to 700°C at 10°C/min, then subjected to propylene CVD for 2 hours, subsequently the temperature was raised to 900°C at 5°C/min to perform a heat treatment of the powder for 3 hours.
4. The NaY type zeolite/carbon composite was stirred in 20 g of hydrofluoric acid for 5 hours, then filtered, and subjected to reduced-pressure heat drying at 150°C for 6 hours.

The obtained sample was analyzed by an XRD measurement, a nitrogen adsorption/desorption measurement, a TG-DTA simultaneous measurement, and an SEM observation, as described below.

<Result of SEM Observation of Starch and Cellulose>

FIG. 76-1 and FIG. 76-2 present SEM photographs of starch samples, and FIG. 77-1 and FIG. 77-2 present SEM photographs of cellulose samples. The scale bar (white bar) in the diagram indicates a length in each photograph.

As can be seen from FIG. 76-1 and FIG. 76-2, starch is in a form of fine particles of about 10 μm. As can be seen from FIG. 77-1 and FIG. 77-2, cellulose has an elongated shape with a length of about 10×200 μm.

In FIG. 78 to FIG. 85 below, a result of a ZTC synthesized using 1 time the amount of glucose by propylene CVD is also presented as a comparative sample.

Example 22

<Result of NaY/Starch-P7 (2)-H9 (3) System>

FIG. 78 presents a result of an XRD device measurement of ZTC samples obtained varying an amount (multiplying amount) of S (sugar: starch) relative to an amount of Na-Y type zeolite, in which the abscissa (X-axis) indicates a diffraction angle 2θ (unit: ° (degree)) of CuKα ray, and the ordinate (Y-axis) indicates an intensity (unit: optional).

FIG. 79 is an enlarged graph showing a measurement result with the diffraction angle 2θ of around 6.4° in FIG. 78. As a reference, a result with 1.0 time the amount of α-D-glucose is also presented.

From this result, the peak of face (002) could not be observed.

FIG. 80 presents a result of a nitrogen adsorption/desorption isothermal line measurement of ZTC samples obtained using S (sugar: starch), in which the abscissa (X-axis) indicates P/P0, and the ordinate (Y-axis) indicates a volume adsorbed (unit: $cm^3$ (STP)/g). As a reference, a result with 1.0 time the amount of α-D- glucose is also presented.

FIG. 81 presents a result of a pore diameter distribution measurement of ZTC samples obtained using S (sugar:

starch) according to DFT method, in which the abscissa (X-axis) indicates a pore diameter (unit: nm), and the ordinate (Y-axis) indicates an incremental pore volume (unit: $cm^3/g$). As a reference, a result with 1.0 time the amount of α-D-glucose is also presented.

Example 23

<Result of NaY/cellulose-P7 (2)-H9 (3) System>

FIG. 82 presents a result of an XRD device measurement of ZTC samples obtained varying an amount (multiplying amount) of C (cellulose) relative to an amount of Na-Y type zeolite, in which the abscissa (X-axis) indicates a diffraction angle 2θ (unit: ° (degree)) of CuKα ray, and the ordinate (Y-axis) indicates an intensity (unit: optional). FIG. 83 is an enlarged graph showing a measurement result with the diffraction angle 2θ of around 6.4° in FIG. 82. As a reference, a result with 1.0 time the amount of α-D-glucose is also presented.

From this result, the peak of face (002) could not be observed. In the samples with not less than 1.4 time the amount of cellulose, their peak intensities had leveled off.

FIG. 84 presents a result of a nitrogen adsorption/desorption isothermal line measurement of ZTC samples obtained using C (cellulose), in which the abscissa (X-axis) indicates P/P0, and the ordinate (Y-axis) indicates a volume adsorbed (unit: $cm^3$ (STP)/g). As a reference, a result with 1.0 time the amount of α-D- glucose is also presented.

FIG. 85 presents a result of a pore diameter distribution measurement of ZTC samples obtained using C (cellulose) according to DFT method, in which the abscissa (X-axis) indicates a pore diameter (unit: nm), and the ordinate (Y-axis) indicates an incremental pore volume (unit: $cm^3/g$). As a reference, a result with 1.0 time the amount of α-D-glucose is also presented.

In the samples with not less than 1.4 time the amount of cellulose, their peak intensities had leveled off.

Surface Area and Pore Volume

For each ZTC sample obtained above, a result of a nitrogen adsorption/desorption measurement (BET specific surface area) and a result of a TG measurement of the zeolite/carbon composite (carbon fraction (g/g)) are presented in FIG. 86 for the starch system and in FIG. 87 for the cellulose system. The abscissa (X-axis) indicates an amount of starch or cellulose, the left side of the ordinate (Y-axis) indicates a carbon fraction (unit: g/gNAY), and the right side indicates a BET surface area (unit: $m^2/g$). an incremental pore volume (unit: cm3/g).

As the synthesis conditions for the samples, an amount of starch or cellulose was varied relative to the amount of Na-Y type zeolite, starch or cellulose was subjected to propylene CVD at 700°C for 2 hours, and heated at 900°C for 3 hours to obtain the samples.

<Result of Nitrogen Adsorption/Desorption Measurement>

Surface Area and Pore Volume

A result of a nitrogen adsorption/desorption measurement of each ZTC sample obtained above, and a result of a TG measurement of the zeolite/carbon composite are presented in Table 20 below.

[Table 20]

| .Result of Nitrogen Adsorption/Desorption Measurement of Each Sample | | | | | |
|---|---|---|---|---|---|
| Sample | $S_{BET}$ [a] ($m^2/g$) | $V_{total}$[b] ($cm^3/g$) | $V_{micro}$[c] ($cm^3/g$) | $V_{meso}$[d] ($cm^3/g$) | Carbon fraction[e] ($g/g_{zeolite}$) |
| Starch | | | | | |
| S (0.6)-P | 3390 | 1.63 | 1.40 | 0.23 | 0.278 |
| S (0.8)-P | 3520 | 1.64 | 1.46 | 0.18 | 0.290 |
| S (1.0)-P | 3840 | 1.73 | 1.61 | 0.11 | 0.299 |
| S (1.2)-P | 3740 | 1.68 | 1.57 | 0.11 | 0.313 |
| S (1.4)-P | 3350 | 1.50 | 1.41 | 0.09 | 0.319 |
| Cellulose | | | | | |
| C (0.6)-P | 3200 | 1.59 | 1.31 | 0.27 | 0.285 |

(continued)

| | | | | | |
|---|---|---|---|---|---|
| Cellulose | | | | | |
| C (0.8)-P | 3300 | 1.54 | 1.35 | 0.19 | 0.303 |
| C (1.0)-P | 3500 | 1.60 | 1.45 | 0.14 | 0.313 |
| C (1.2)-P | 3440 | 1.53 | 1.43 | 0.09 | 0.329 |
| C (1.4)-P | 3390 | 1.50 | 1.42 | 0.08 | 0.342 |
| C (1.6)-P | 3200 | 1.43 | 1.34 | 0.09 | 0.356 |
| C (1.8)-P | 3150 | 1.40 | 1.33 | 0.07 | 0.374 |

[a] calculated from $P/P_0$ = 001 to 0.05
[b]calculated from nitrogen adsorption amount at $P/P_0$=0.96
[c] calculated from $P/P_0$=0.001 to 0.050 by DR method
[d] calculated from $V_{meso}$= $V_{total}$ - $V_{micro}$
[e]amount of carbon per 1 g of carbon fraction: NaY type zeolite

<Result of TEM Observation of ZTC Synthesized Using Cellulose>

FIG. 88-1 and FIG. 88-2 present TEM photographs of ZTC samples denoted as cellulose (1.0)-P (1.0 time the amount of cellulose was used) and cellulose (1.8)-P (1.8 time the amount of cellulose was used) respectively. The white bars in the diagrams indicate 20 nm length (FIG. 88-1) or 100 nm length (FIG. 88-2).

The above results suggest the followings.

In the result of the TG measurement, the amount of carbon was increased up to the cellulose amount of 1.8 time, but a peak of face (002) could not be confirmed in the XRD pattern. Thus, TEM observation was performed for the 1.0 time the amount and the 1.8 time the amount of cellulose, but carbon lamination was not confirmed on the particle outer surface of the ZTC in the sample with 1.8 time the amount of cellulose. When TEM observation was carefully performed, some amorphous impurities were observed in the sample with 1.8 time the amount of cellulose. Consequently, the failure to achieve a high surface area in the cellulose system may be due to impurities derived from cellulose.

However, the samples with not less than 1.4 time the amount of cellulose have high structural regularities, and therefore, if an excessive amount of cellulose is used, cellulose can be used in the same manner as for starch, from the viewpoint of synthesizing a high density ZTC.

Example 24

<Result of TG Measurement of NaY/1.0 Time Sugar Mixed Powder>

FIG. 89 to FIG. 91 present results of a TG-DTA simultaneous measurement. In FIG. 89, NaY type zeolite, starch, and cellulose were used. In FIG. 90, NaY type zeolite, starch, and a sample of a mixture of NaY type zeolite and starch (amount of starch: 1.0 time) were used. In FIG. 91, NaY type zeolite, cellulose, and a sample of a mixture of NaY type zeolite and cellulose (amount of cellulose: 1.0 time) were used.

In the result of FIG. 90, the experimental result sufficiently coincides with the fitted result up to around 350°C, which supports the assumption that starch is decomposed and adsorbed to the zeolite at 350°C or lower.

In the result of FIG. 91, the experimental result insufficiently coincide with the fitting, suggesting that cellulose is hardly decomposed into sugar unlike starch.

FIG. 92 presents a result of a nitrogen adsorption/desorption isothermal line measurement of samples obtained by treating a mixture of NaY type zeolite and 1.0 time the amount of S (starch) at 300°C, 350°C, and 400°C, in which the abscissa (X-axis) indicates P/PO and the ordinate (Y-axis) indicates a volume adsorbed (unit: $cm^3$ (STP)/g). As a reference, a result of an Na-Y type zeolite sample is also presented.

From the above results, assuming that no sugar (starch) is adsorbed, a theoretical surface area of the mixed powder calculated from a dry weight of NaY type zeolite, a weight of the mixed powder after heating, and a surface area of NaY type zeolite (703 $m^2/g$) is 491 to 598 $m^2/g$. Since the surface area is actually 50 $m^2/g$ or lower, it is understood that starch is decomposed and adsorbed to NaY type zeolite at 350°C or lower (the cellulose system is presented in FIG. 99).

<Result of Study on ZTC Synthesis Using Starch/Cellulose, and Elucidation for Mechanism of ZTC Formation>

For starch, the following characteristics are found from the above results.

· In the ZTC synthesis using starch, starch is decomposed (presumably into glucose) and adsorbed to the zeolite pores at 350°C or lower.
· The optimum amount of starch used is the same as or substantially equivalent to that of α-D-glucose.
· When starch is used in an amount of 1.0 time, a ZTC having the highest surface area can be obtained.

For cellulose, the following characteristics are found from the above results.

· It is presumed that, in the ZTC synthesis using cellulose, cellulose is decomposed (presumably into glucose) and adsorbed to the zeolite pores at 400°C or lower.
· It is considered that, when cellulose is used in an amount of 1.4 time, the zeolite pores are filled with a necessary carbon source. However, since cellulose-derived degradants are deposited on the surface of the ZTC particle, it can be seen that the use of more than 1.0 time the amount of cellulose may fill up the surface area.

Example 25

<Scaling-Up of ZTC Synthesis Using Sugar>

Sample Synthesis

As sugars, α-D-glucose, β-D- glucose, D-xylose, D-sucrose, and D-fructose were used. The amount of the sugar in a volume equivalent to the total pore volume (0. 32 mL) of the zeolite used was defined as an amount of 1.0 time.
The amount of starch or cellulose in the same weight as the weight of 1.0 time the amount of α-D-glucose was defined as an amount of 1.0 time.
The ZTC was synthesized as follows.

1. The amount of NaY type zeolite was scaled up from about 500 mg to about 15 g to synthesize the ZTC. A comparison was made between the dried NaY type zeolite and the undried NaY type zeolite. When the zeolite was not dried, a dry weight of the zeolite was calculated using a water content in a case of drying the zeolite to synthesize the ZTC.

Surface Area and Pore Volume

A result of a nitrogen adsorption/desorption measurement of each ZTC sample obtained above is presented in Table 21 below.

[Table 21]

Result of Nitrogen Adsorption/Desorption Measurement of ZTC Synthesized with Zeolite in 15 g Scale
Table 21 Result of Nitrogen Adsorption/Desorption Measurement of ZTC Synthesized with Zeolite in 15 g Scale

| Sample | $S_{BET}$[a] ($m^2/g$) | $V_{total}$[b] ($cm^3/g$) | $V_{micro}$[c] ($cm^3/g$) | $V_{meso}$[d] ($cm^3/g$) |
|---|---|---|---|---|
| α-Glu (1.0)-P | 3750 | 1.71 | 1.56 | 0.15 |
| β-Glu (1.0)-P | 3870 | 1.79 | 1.60 | 0.18 |
| Xyl (1.0)-P | 3790 | 1.73 | 1.57 | 0.16 |
| Xyl (1.0)-P (NaY was pre-dried) | 3840 | 1.76 | 1.59 | 0.17 |
| S (1.0)-P | 3610 | 1.65 | 1.51 | 0.15 |
| S (1.0)P (NaY was pre-dried) | 3660 | 1.72 | 1.50 | 0.21 |

(continued)

| Result of Nitrogen Adsorption/Desorption Measurement of ZTC Synthesized with Zeolite in 15 g Scale<br>Table 21 Result of Nitrogen Adsorption/Desorption Measurement of ZTC Synthesized with Zeolite in 15 g Scale | | | | |
|---|---|---|---|---|
| Sample | $S_{BET}{}^{a}$ ($m^2$/g) | $V_{total}{}^{b}$ ($cm^3$/g) | $V_{micro}{}^{c}$ ($cm^3$/g) | $V_{meso}{}^{d}$ ($cm^3$/g) |
| S (1.0)P (NaY and starch were pre-dried) | 3650 | 1.73 | 1.51 | 0.22 |
| [a]calculated from $P/P_0$ = 001 to 0.05<br>[b]calculated from nitrogen adsorption amount at $P/P_0$=0.96<br>[a]calculated from $P/P_0$=0.001 to 0.050 by DR method<br>[d] calculated from $V_{meso}$= $V_{total-}$ $V_{micro}$ | | | | |

FIG. 93 presents a result of an XRD device measurement of ZTC samples obtained varying a drying manner of S (starch) on Na-Y type zeolite, in which the abscissa (X-axis) indicates a diffraction angle 2θ (unit: ° (degree)) of CuKα ray, and the ordinate (Y-axis) indicates an intensity (unit: optional). FIG. 94 is an enlarged graph showing a measurement result with the diffraction angle 2θ of around 6.4° in FIG. 93.

The above results suggest the followings.

- When the amount of starch is scaled up, the structural regularity and the surface area are somewhat decreased.
- There is no significant change even if either one or both of NaY type zeolite and starch are dried in advance.
- Since there is no significant change even if starch does not contain water, starch is not adsorbed to the zeolite after hydrolysis.

<Elucidation for Synthesis Mechanism of ZTC Using Cellulose>

Example 26

<Result of TG Measurement of NaY/1.0 Time Sugar Mixed Powder>

FIG. 95 to FIG. 97 present analysis results of a TG-DTA simultaneous measurement. FIG. 89 to FIG. 91 present results of a TG-DTA simultaneous measurement. In FIG. 95, NaY type zeolite, starch, and cellulose were used. In FIG. 96, NaY type zeolite, starch, and a sample of a mixture of NaY type zeolite and starch (amount of starch: 1.0 time) were used. In FIG. 97, NaY type zeolite, cellulose, or a sample of a mixture of NaY type zeolite and cellulose (amount of cellulose: 1.0 time) were used.

In FIG. 96, the experimental result sufficiently coincides with the fitted result up to around 350°C, which supports the assumption that starch is decomposed and adsorbed to the zeolite at 350°C or lower.

In FIG. 97, the experimental result does not sufficiently coincide with the fitting, suggesting that cellulose is hardly decomposed into sugar unlike starch.

FIG. 98 presents a result of a nitrogen adsorption/desorption isothermal line measurement of samples obtained by treating a mixture of NaY type zeolite and 1.0 time the amount of S (starch) at 300°C, 350°C, and 400°C, in which the abscissa (X-axis) indicates P/PO and the ordinate (Y-axis) indicates a volume adsorbed (unit: $cm^3$ (STP)/g). As a reference, a result of Na-Y type zeolite is also presented.

From the above results, assuming that no sugar is adsorbed, a theoretical surface area of the mixed powder calculated from a dry weight of NaY type zeolite, a weight of the mixed powder after heating, and a surface area of NaY type zeolite (703 $m^2$/g) is 491 to 598 $m^2$/g. Since the surface area is actually 50 $m^2$/g or lower, it is understood that starch is decomposed and adsorbed to NaY type zeolite at 350°C or lower.

<Study on Adsorption of NaY/Cellulose (1.0 Time) to NaY Type Zeolite>

FIG. 99 presents a result of a nitrogen adsorption/desorption isothermal line measurement of samples obtained by treating a mixture of NaY type zeolite and 1.0 time the amount of C (cellulose) at 350°C, 400°C, and 450°C, in which the abscissa (X-axis) indicates P/PO and the ordinate (Y-axis) indicates a volume adsorbed (unit: $cm^3$ (STP)/g). As a reference, a result of Na-Y type zeolite is also presented.

From the result of the TG measurement, it was predicted that the decomposition of cellulose and the adsorption of the produced sugar to the NaY type zeolite occurred at higher than 300°C. Thus, a mixture of 1.0 time the amount of

cellulose and NaY type zeolite was heated at 350 to 450°C and subjected to a nitrogen adsorption/desorption measurement, and, as a result, the sample treated at 400°C showed the lowest surface area value. Consequently, it is considered that the adsorbed sugar is thermally decomposed at higher than 400°C. Since the minimum values of the surface area and the pore volume of the heat-treated powder are higher than those of starch, it is found that cellulose is hardly decomposed compared to starch.

As a result, it is considered that cellulose is thermally decomposed before whole cellulose is decomposed into sugar and adsorbed to NaY type zeolite, and therefore the zeolite pores may be not sufficiently filled with the sugar.

## Claims

1. A method for producing a zeolite-templated carbon material, wherein a sugar is introduced onto a surface of and into pores of a zeolite, the resulting zeolite is heated to carbonize the sugar, and then the zeolite is dissolved and removed.

2. A method for producing a zeolite-templated carbon material, wherein a crosslinkable hydrocarbon is introduced onto a surface of and into pores of a zeolite and polymerized, and then the zeolite is dissolved and removed.

3. The method according to claim 1, wherein the sugar is a monosaccharide, a disaccharide, or a polysaccharide.

4. The method according to claim 1, wherein the sugar is glucose, xylose, fructose, sucrose, cellulose, or starch.

5. The method according to claim 1, wherein the zeolite is Y type zeolite or X type zeolite.

6. The method according to claim 1, wherein the zeolite is dissolved with an acid.

7. The method according to claim 1, wherein the sugar is introduced onto the surface of and into the pores of the zeolite as a template, the resulting zeolite is heated to carbonize the sugar, to which a polymerizable hydrocarbon is introduced to cause vapor phase carbonization of the sugar, and the zeolite is dissolved and removed.

8. The method according to claim 2, wherein a crosslinkable hydrocarbon is introduced onto the surface of and into the pores of the zeolite as a template, to which an unsaturated hydrocarbon is introduced and polymerized, and then the zeolite is dissolved and removed.

9. The method according to claim 1, wherein the zeolite is put into a container and then dried, the sugar is added to the container to introduce the sugar onto the surface of and into the pores of the dried zeolite.

10. The method according to claim 1, wherein the sugar is carbonized by heating the zeolite at 80°C to 200°C.

11. The method according to claim 1, wherein a polymerizable hydrocarbon is introduced to the zeolite having the carbonized sugar to cause vapor phase carbonization of the sugar at 600°C to 900°C.

12. The method according to claim 1, wherein an acid is added to the carbonized sugar and the zeolite as the template to dissolve and remove the zeolite.

13. The method according to claim 1, wherein a polymerizable hydrocarbon is introduced to the zeolite having the carbonized sugar, and an acid is added to the vapor phase-carbonized product and the zeolite as the template to dissolve and remove the zeolite.

14. A pellet containing a zeolite-templated carbon material, which is obtained by a process in which a sugar is introduced onto a surface of and into pores of a zeolite, the resulting zeolite is heated to carbonize the sugar, then the zeolite is dissolved and removed, and the sugar is dried and then pressurized to pelletize the sugar.

15. A method for producing the pellet containing the zeolite-templated carbon material according to claim 14, wherein the sugar is introduced onto the surface of and into the pores of the zeolite, the resulting zeolite is heated to carbonize the sugar, then the zeolite is dissolved and removed, and the sugar is dried and then pressurized to pelletize the sugar.

**Amended claims under Art. 19.1 PCT**

1. (Amended claim) A method for producing the zeolite-templated carbon material reflecting a structural regularity, wherein a zeolite and a sugar are mixed and heated to adsorb the sugar into pores of the zeolite, then the sugar is carbonized, to which a polymerizable hydrocarbon is introduced to cause vapor phase deposition/carbonization of the sugar, and the zeolite is dissolved and removed.

2. (deleted)

3. The method according to claim 1, wherein the sugar is a monosaccharide, a disaccharide, or a polysaccharide.

4. The method according to claim 1, wherein the sugar is glucose, xylose, fructose, sucrose, cellulose, or starch.

5. The method according to claim 1, wherein the zeolite is Y type zeolite or X type zeolite.

6. The method according to claim 1, wherein the zeolite is dissolved with an acid.

7. (deleted)

8. (deleted)

9. (deleted)

10. (Amended claim) The method according to claim 1, wherein the sugar is a monosaccharide or a disaccharide, and the monosaccharide or the disaccharide is adsorbed to the pores of the zeolite by heating at 100°C to 300°C.

11. The method according to claim 1, wherein a polymerizable hydrocarbon is introduced to the zeolite having the carbonized sugar to cause vapor phase carbonization of the sugar at 600°C to 900°C.

12. (deleted)

13. (deleted)

14. (Amended claim) A pellet containing a zeolite-templated carbon material, which is obtained by a process in which a zeolite and a sugar are mixed, the mixture is pressurized to pelletize the mixture, the pelletized mixture is heated to adsorb the sugar in the pelletized mixture into pores of the zeolite, then the sugar is carbonized, to which a polymerizable hydrocarbon is introduced to cause vapor phase deposition/carbonization of the sugar, and the zeolite is dissolved and removed.

15. (Amended claim) A method for producing the pellet containing the zeolite-templated carbon material according to claim 14, wherein a zeolite and a sugar are mixed, the mixture is pressurized to pelletize the mixture, the pelletized mixture is heated to adsorb the sugar in the pelletized mixture into pores of the zeolite, then the sugar is carbonized, to which a polymerizable hydrocarbon is introduced to cause vapor phase deposition/carbonization of the sugar, and the zeolite is dissolved and removed.

16. (Additional claim) The method according to claim 1, wherein the sugar is a cellulose, and the cellulose is decomposed into a sugar by heating at 300°C to 400°C to adsorb the sugar into the pores of the zeolite.

17. (Additional claim) The method according to claim 1, wherein the sugar is a starch, the starch is decomposed into a sugar by heating at 200°C to 350°C to adsorb the sugar into the pores of the zeolite.

18. (Additional claim) The method according to claim 1, wherein the zeolite-templated carbon material has a BET specific surface area of 3600 $m^2/g$ or higher.

FIG. 1

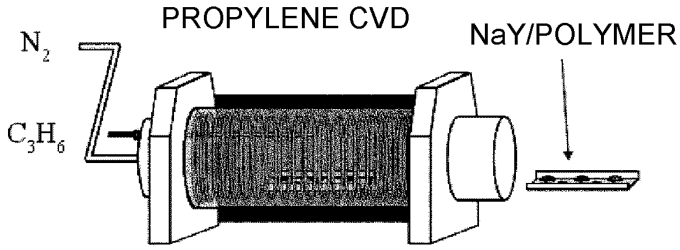


FIG. 2

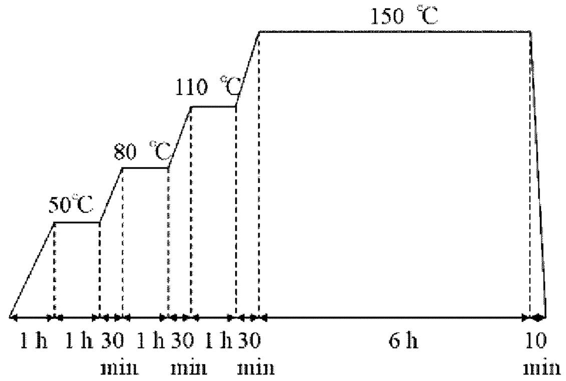


FIG. 3

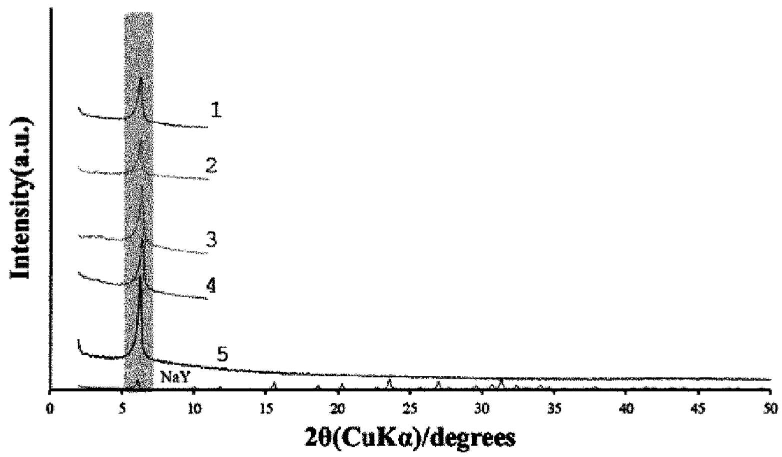

FIG. 4

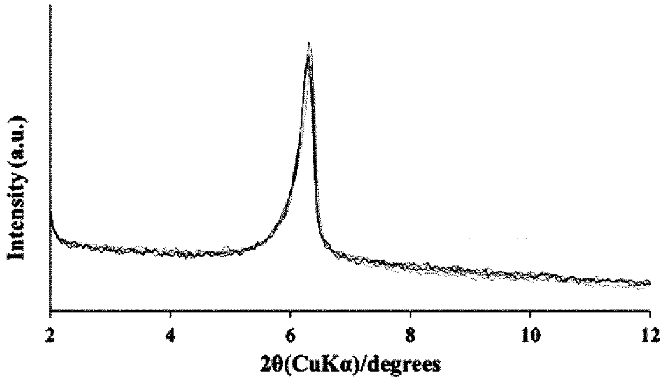


FIG. 5

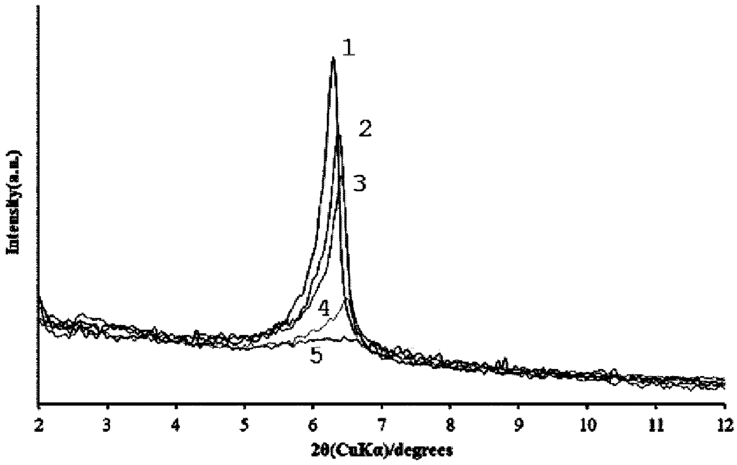


FIG. 6

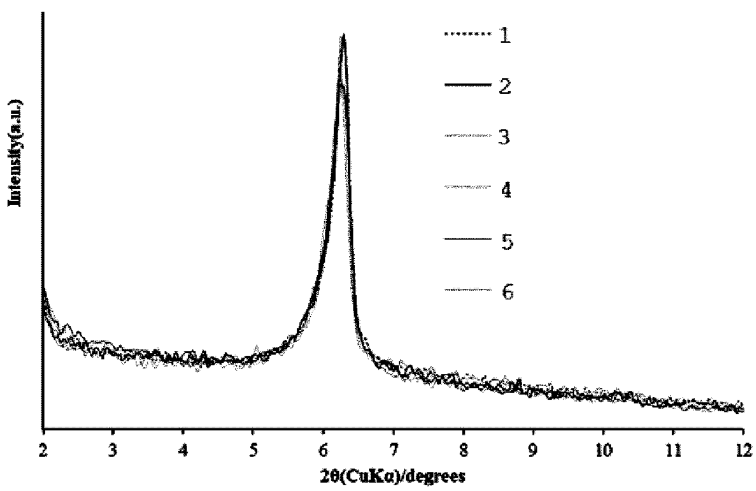

FIG. 7

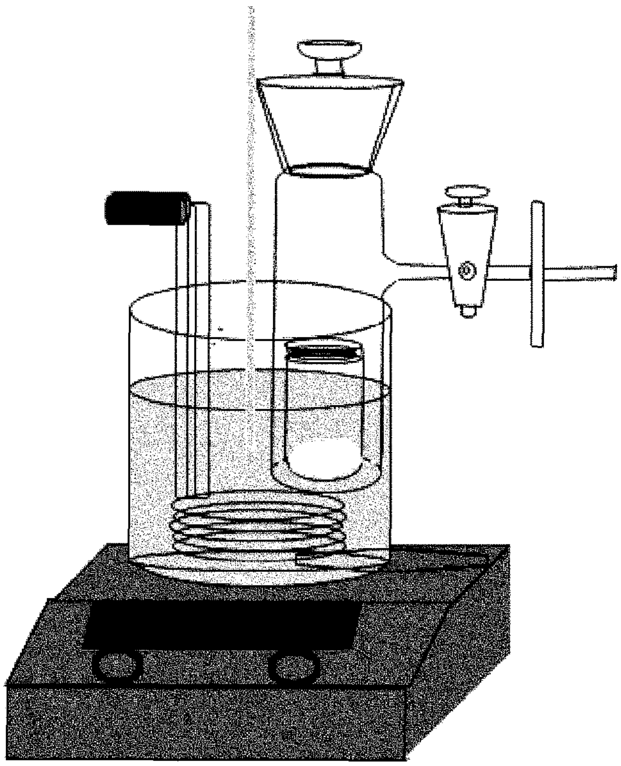

FIG. 8

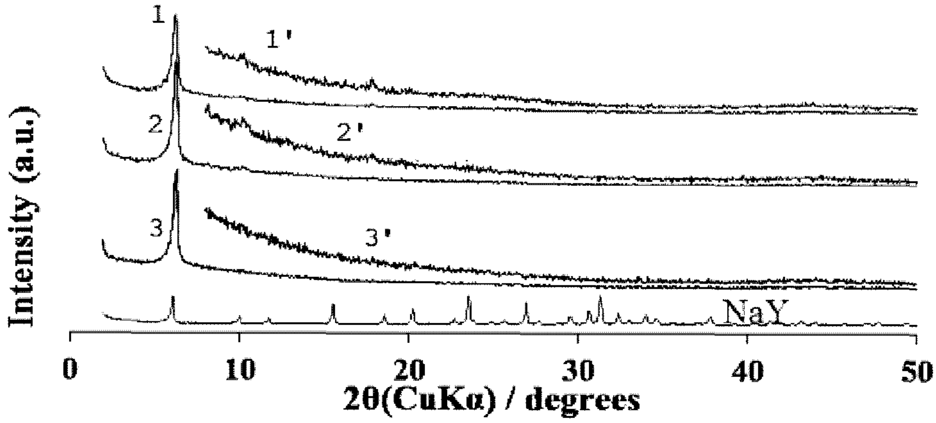

FIG. 9

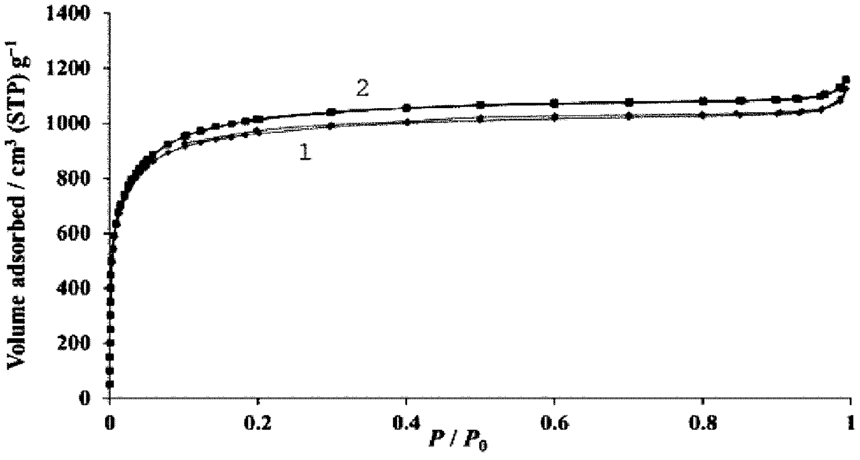


FIG. 10

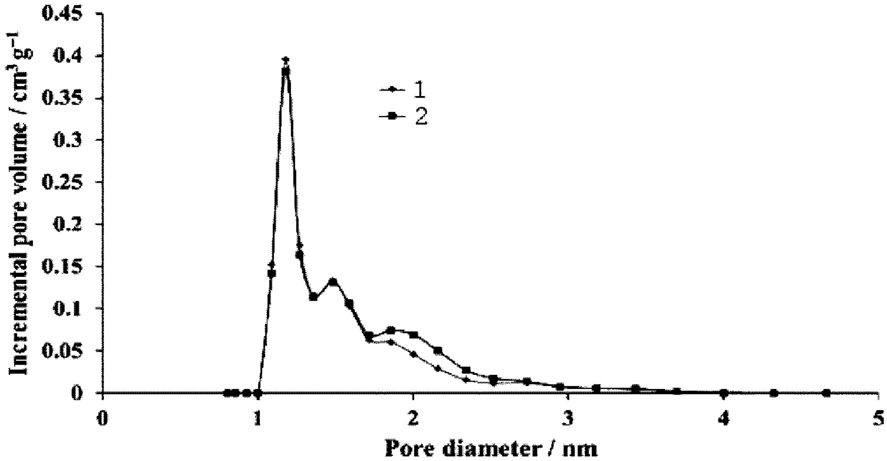


FIG. 11

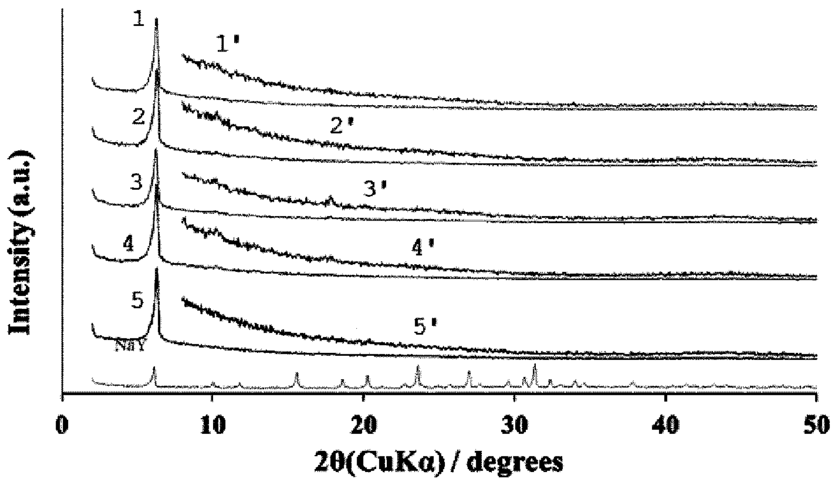

FIG. 12

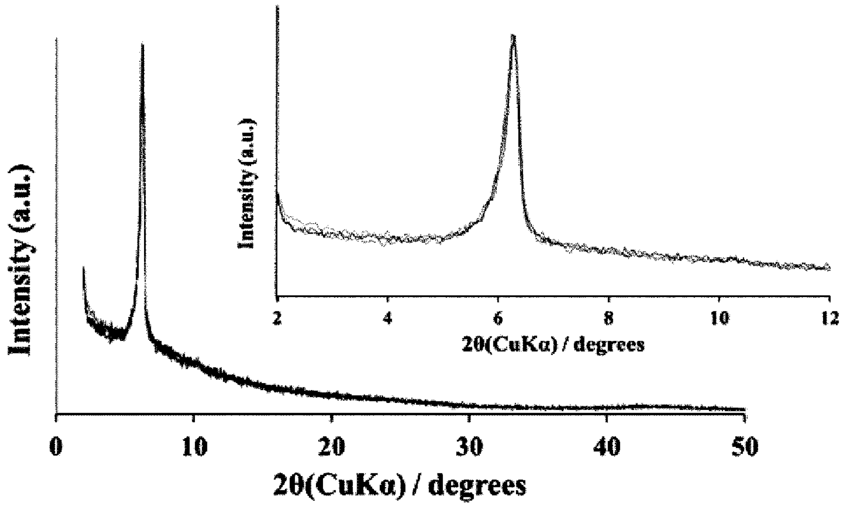


FIG. 13

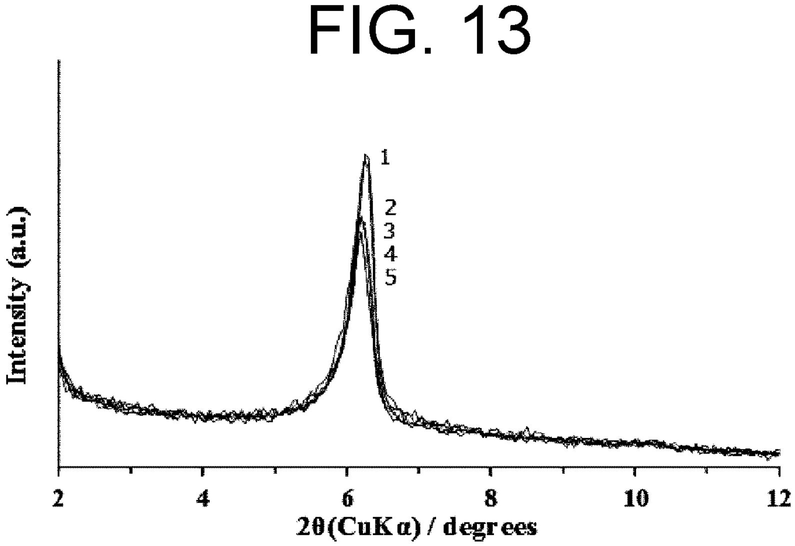


FIG. 14

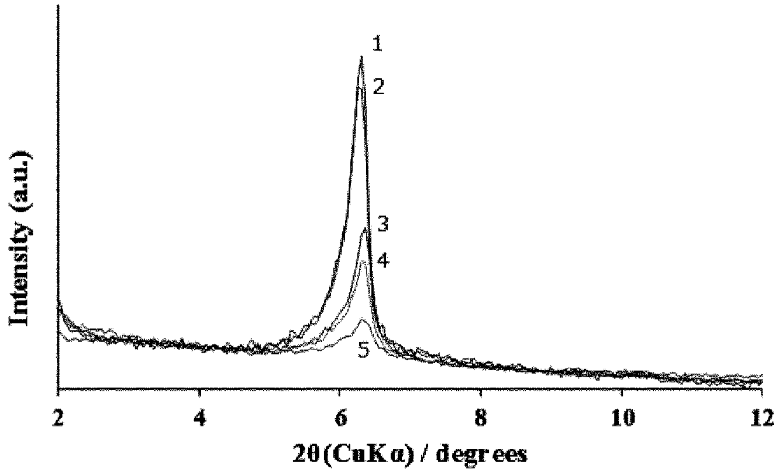

FIG. 15

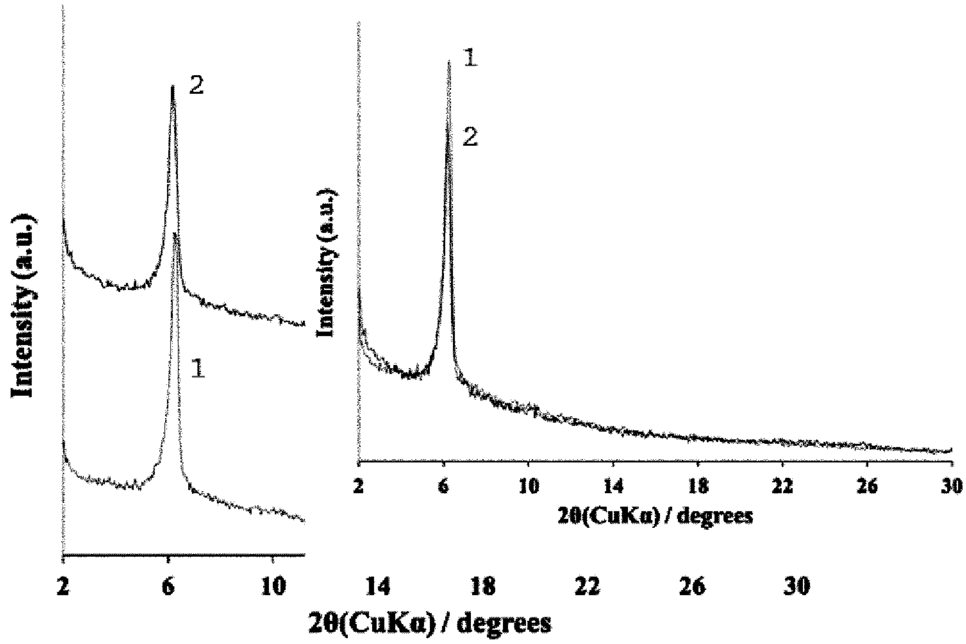
Intensity (a.u.)
2
1
2
6
10
14
18
22
26
30
2θ(CuKα) / degrees
Intensity (a.u.)
1
2
2
6
10
14
18
22
26
30
2θ(CuKα) / degrees

FIG. 16

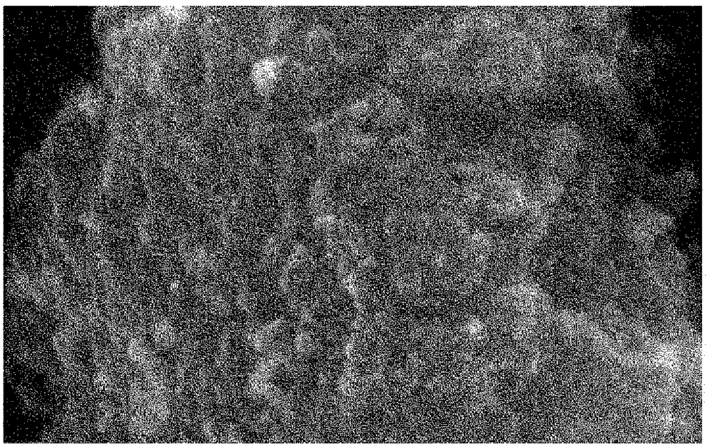

FIG. 17

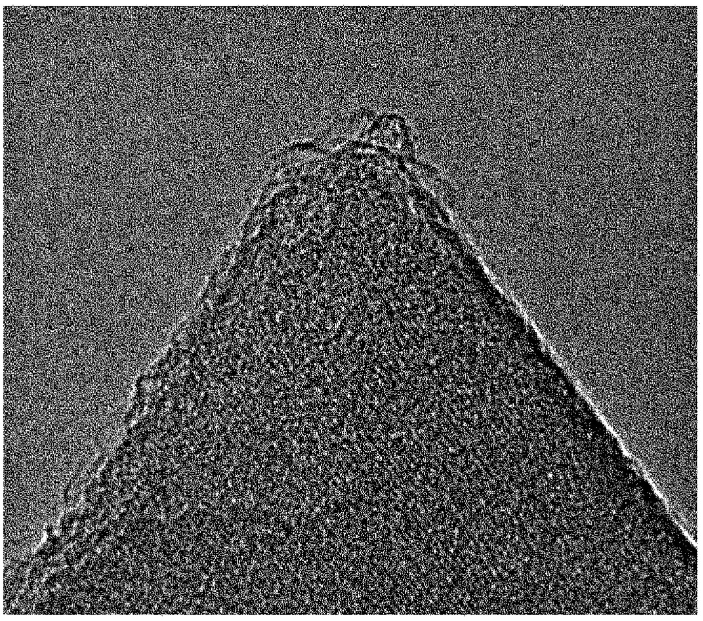

FIG. 18

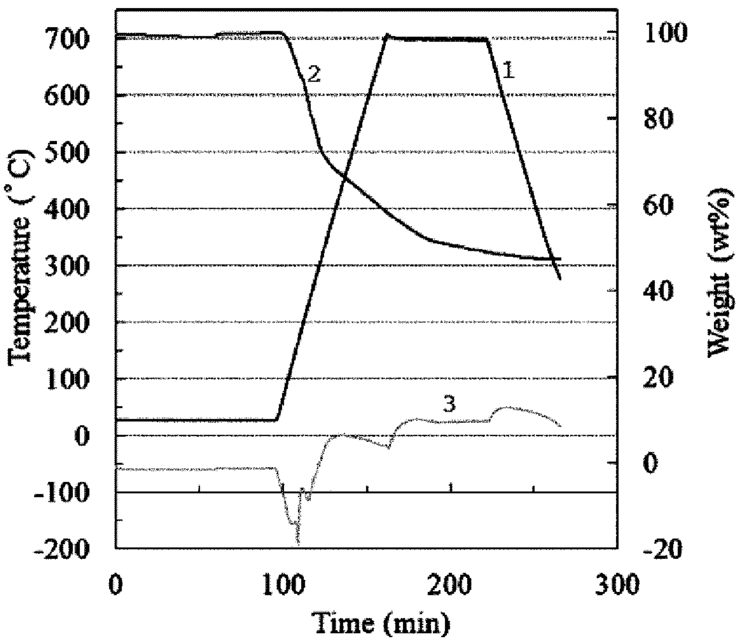
700
600
500
400
300
200
100
0
-100
-200
Temperature (°C)
100
80
60
40
20
0
-20
Weight (wt%)
0
100
200
300
Time (min)
1
2
3

FIG. 19

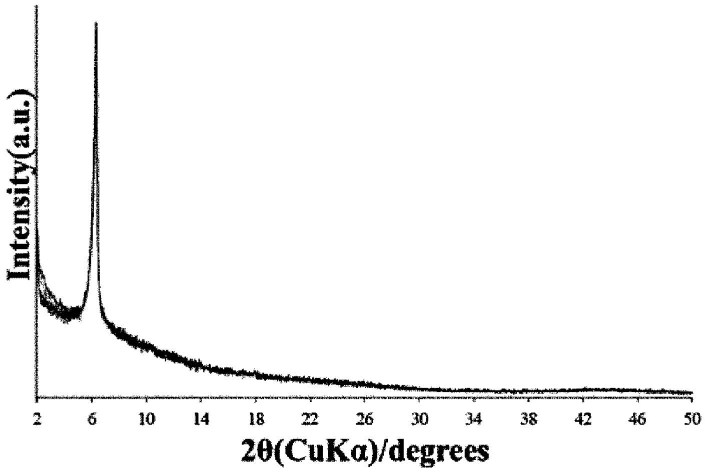


FIG. 20

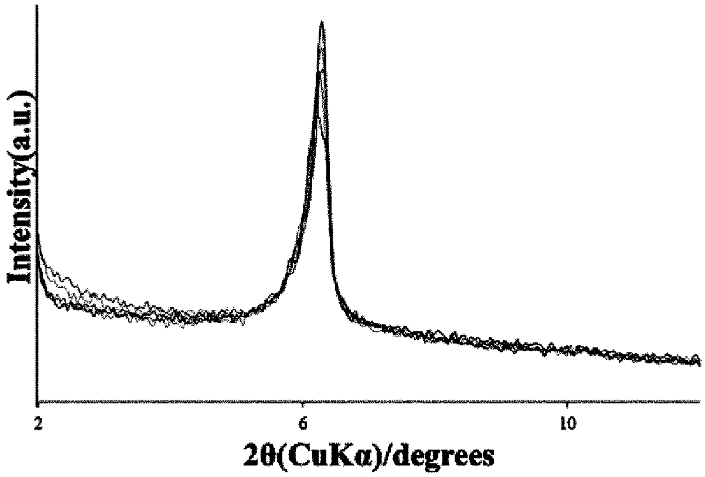


FIG. 21

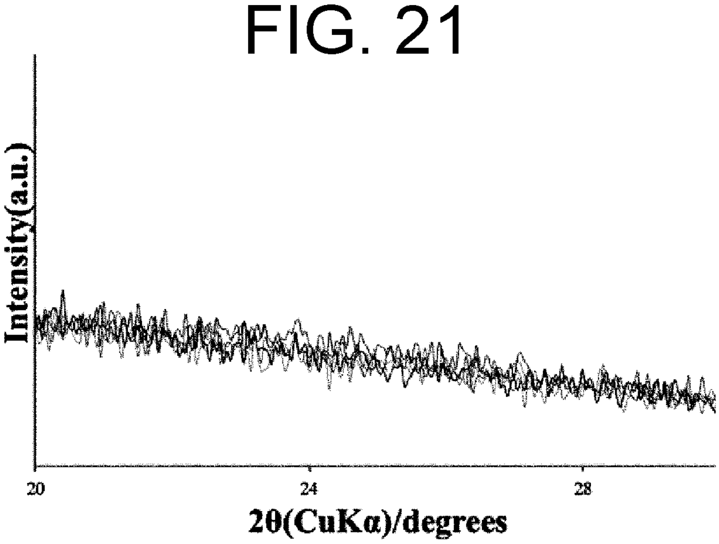

FIG. 22

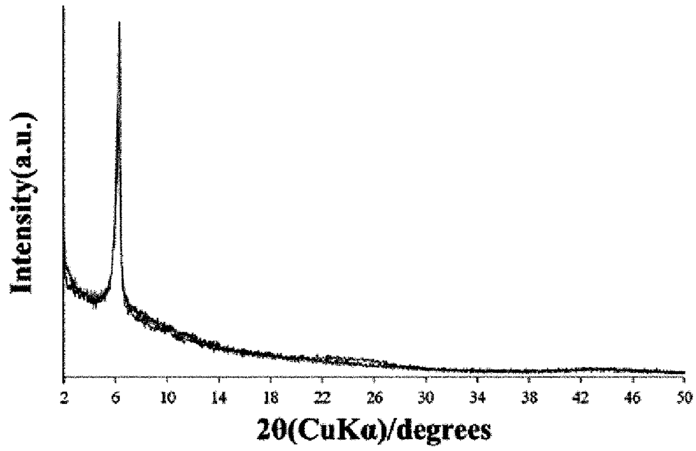


FIG. 23

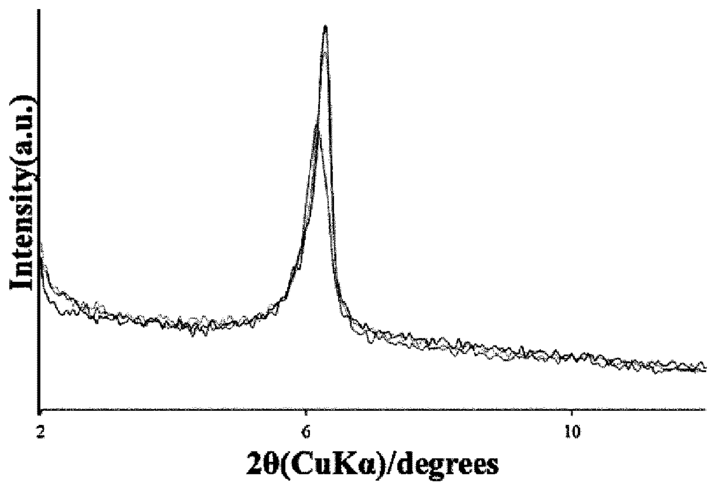


FIG. 24

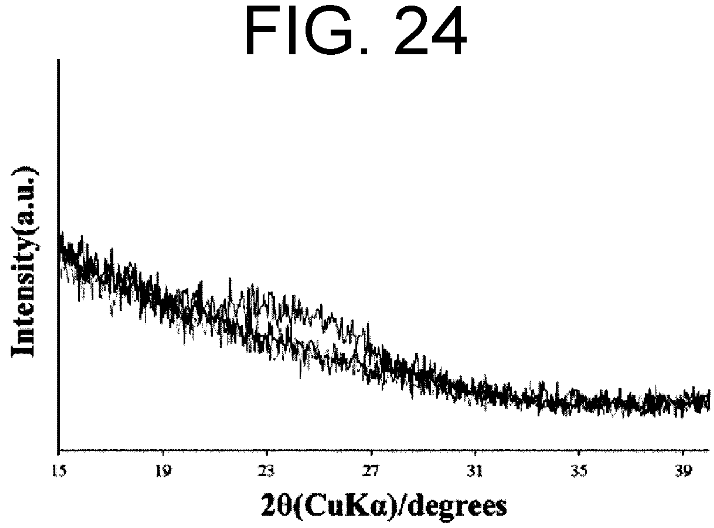

FIG. 25

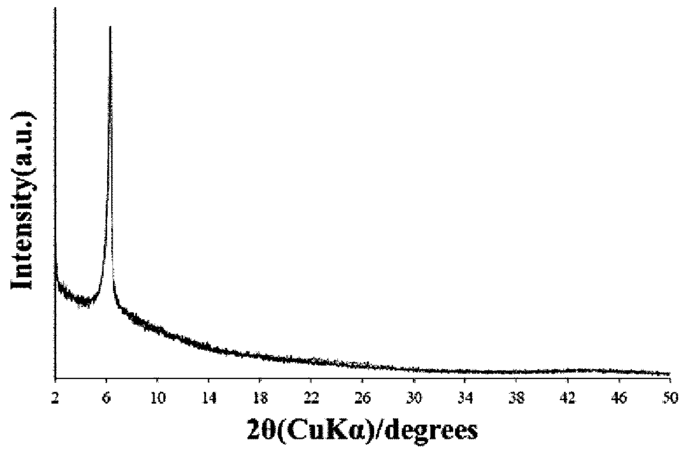


FIG. 26

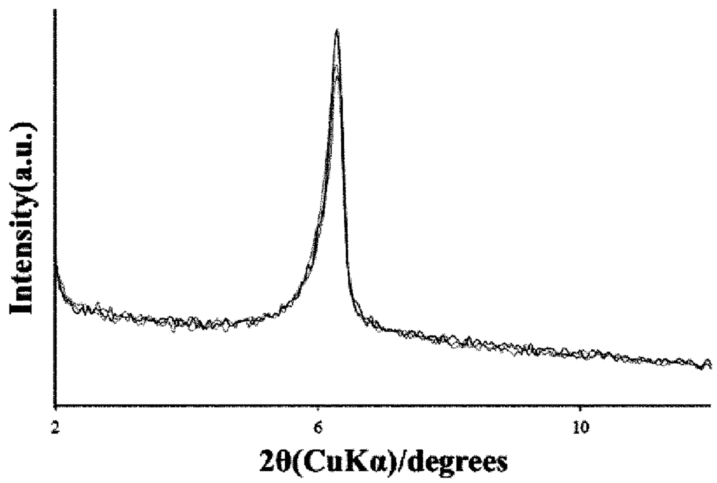


FIG. 27

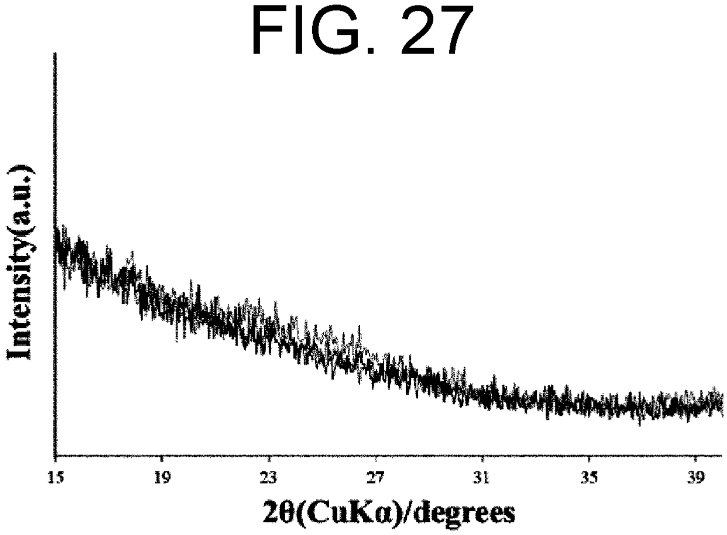

FIG. 28

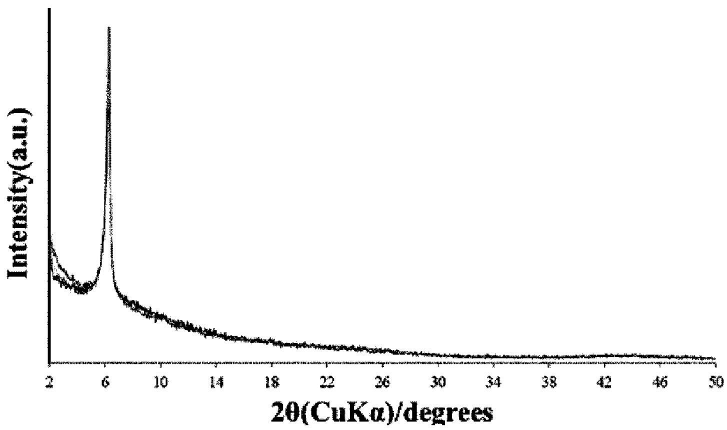


FIG. 29

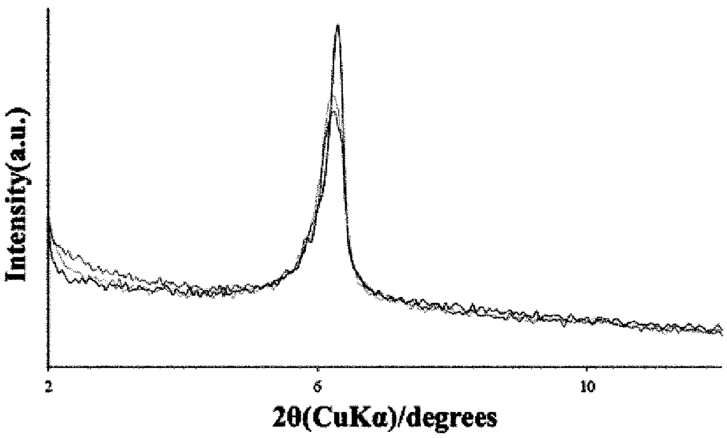


FIG. 30

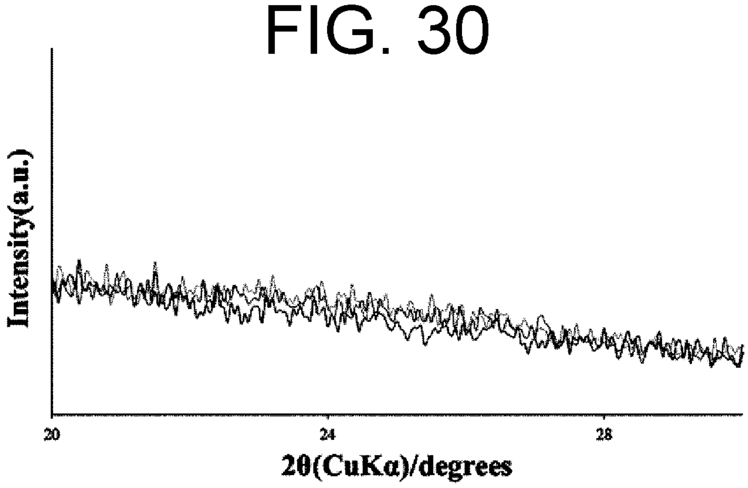

FIG. 31

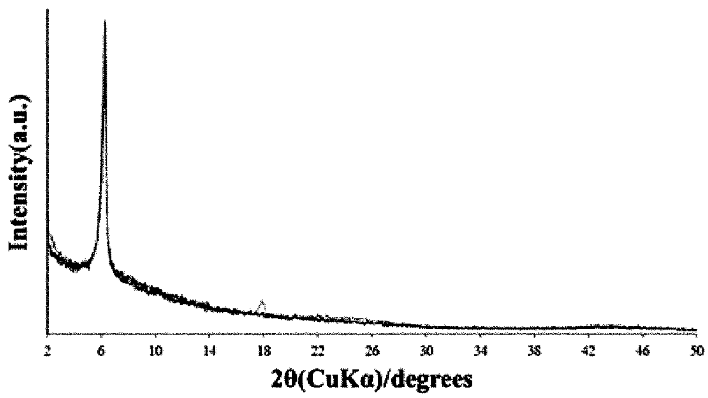


FIG. 32

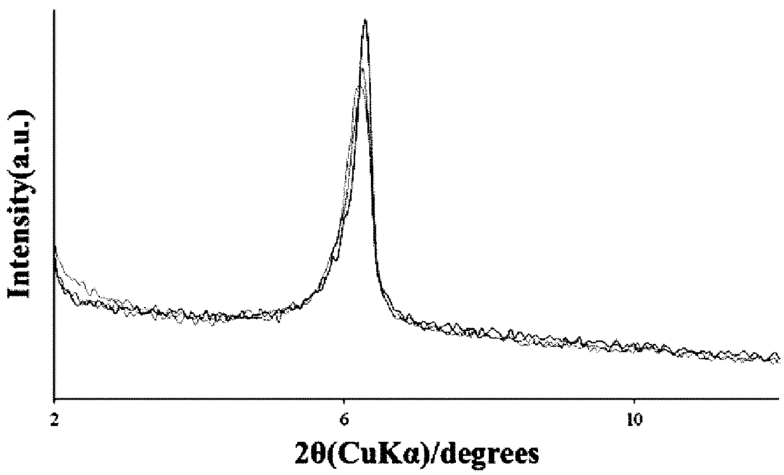


FIG. 33

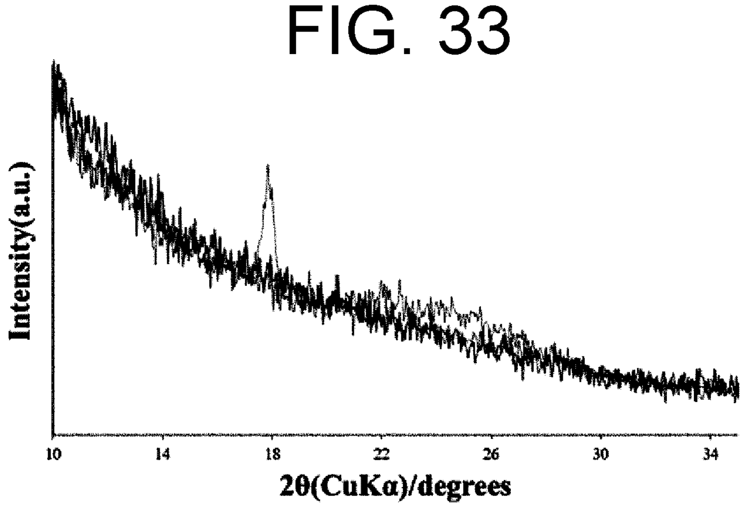

FIG. 34

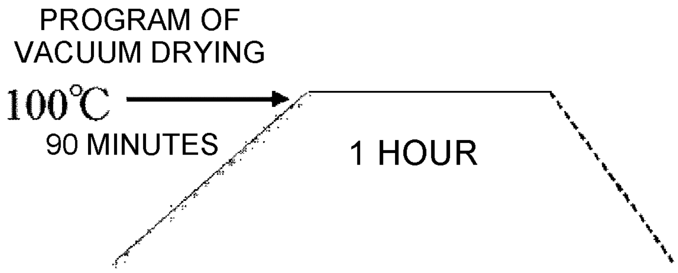


FIG. 35

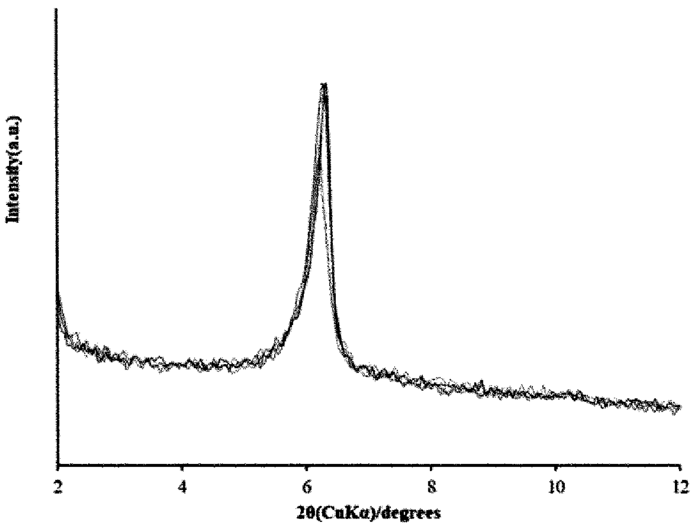


FIG. 36

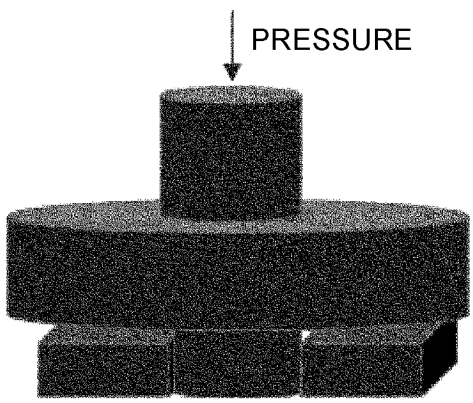

FIG. 37

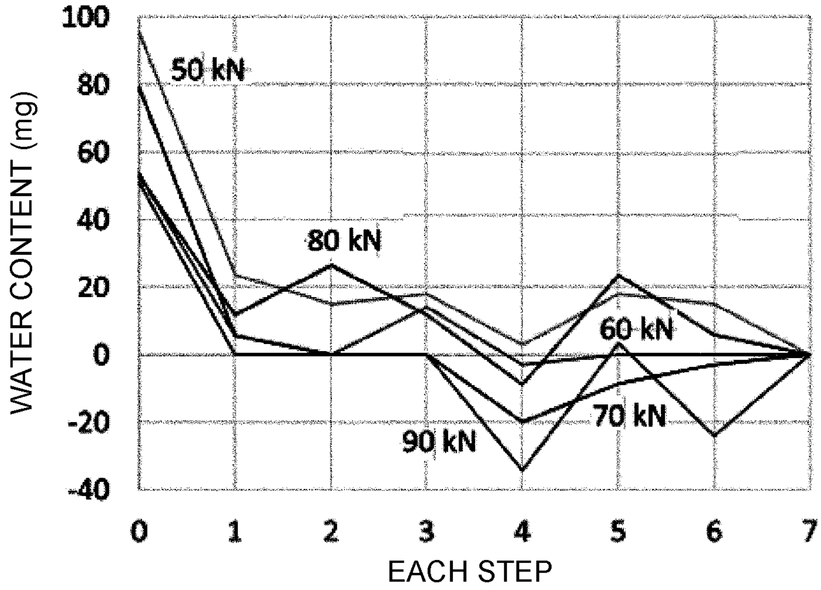


FIG. 38

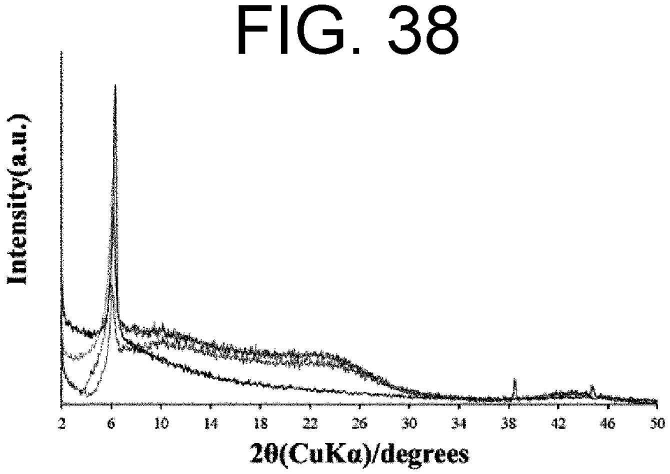


FIG. 39

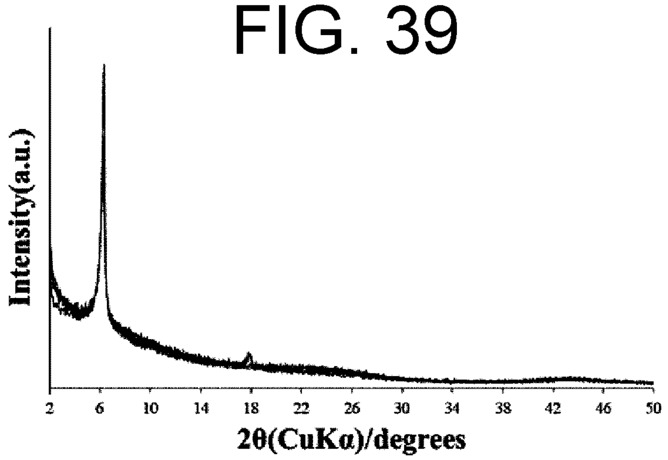

FIG. 40

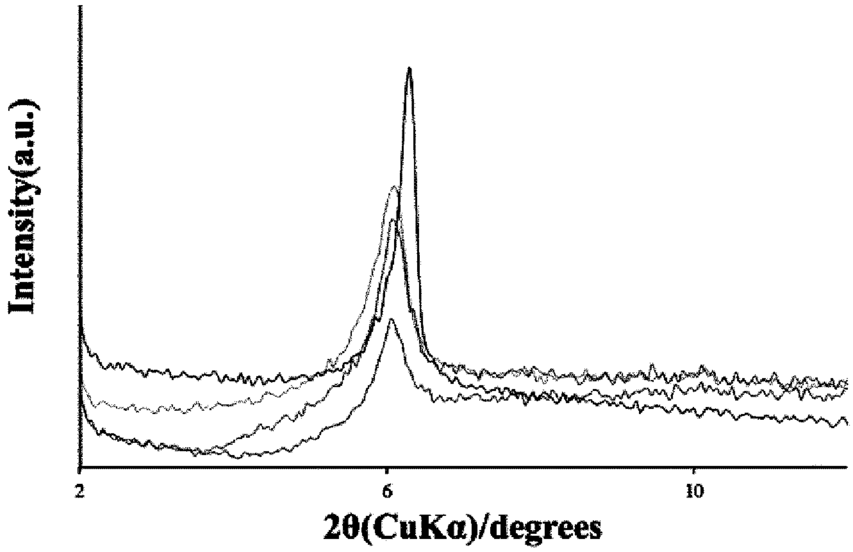
Intensity(a.u.)
2
6
10
2θ(CuKα)/degrees

FIG. 41

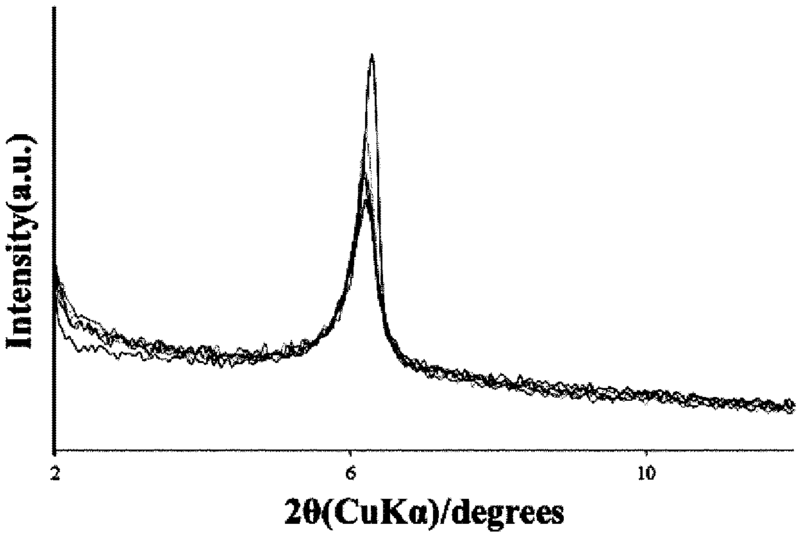
Intensity(a.u.)
2
6
10
2θ(CuKα)/degrees

FIG. 42

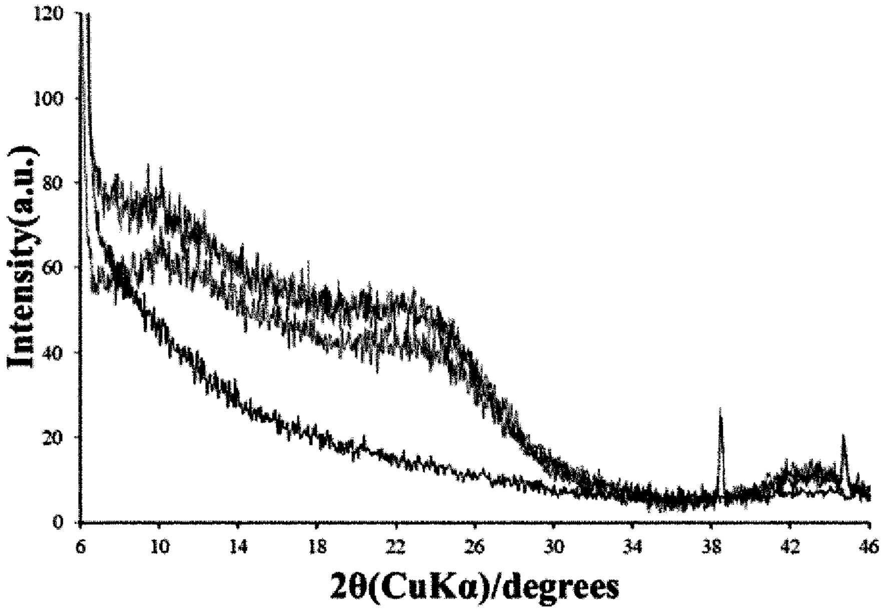
120
100
80
60
40
20
0
Intensity(a.u.)
6
10
14
18
22
26
30
34
38
42
46
2θ(CuKα)/degrees

FIG. 43

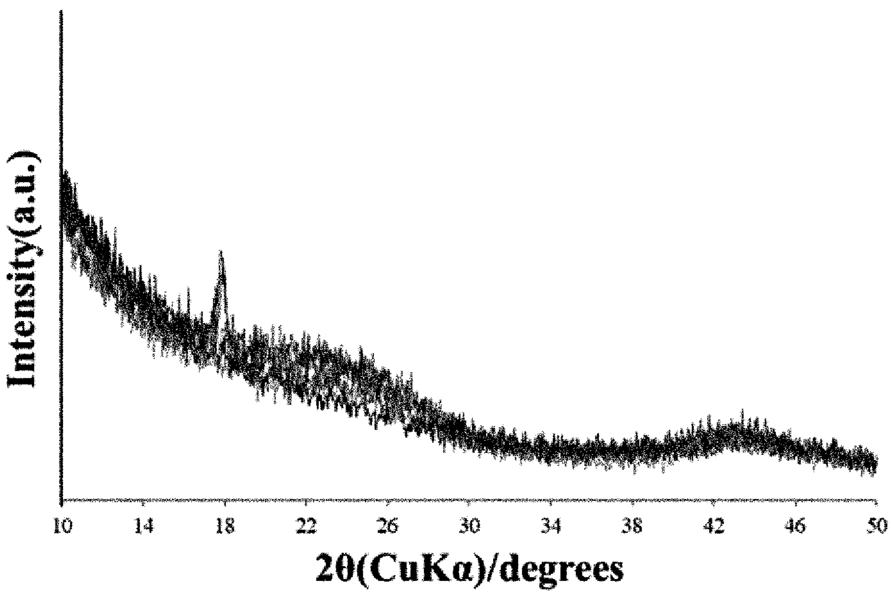
Intensity(a.u.)
10
14
18
22
26
30
34
38
42
46
50
2θ(CuKα)/degrees

FIG. 44

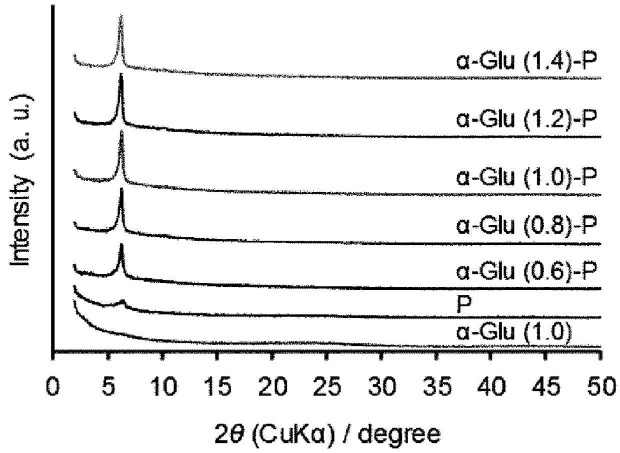


FIG. 45

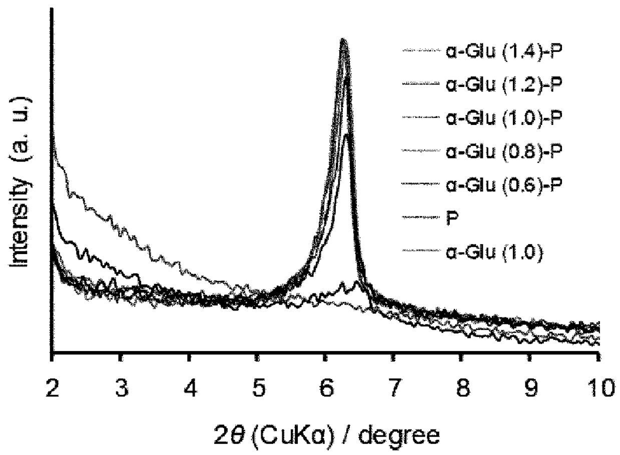


FIG. 46

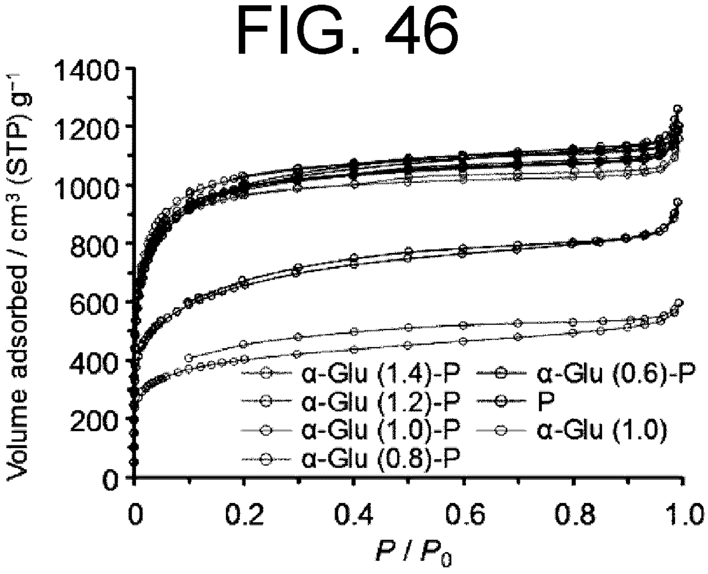

FIG. 47

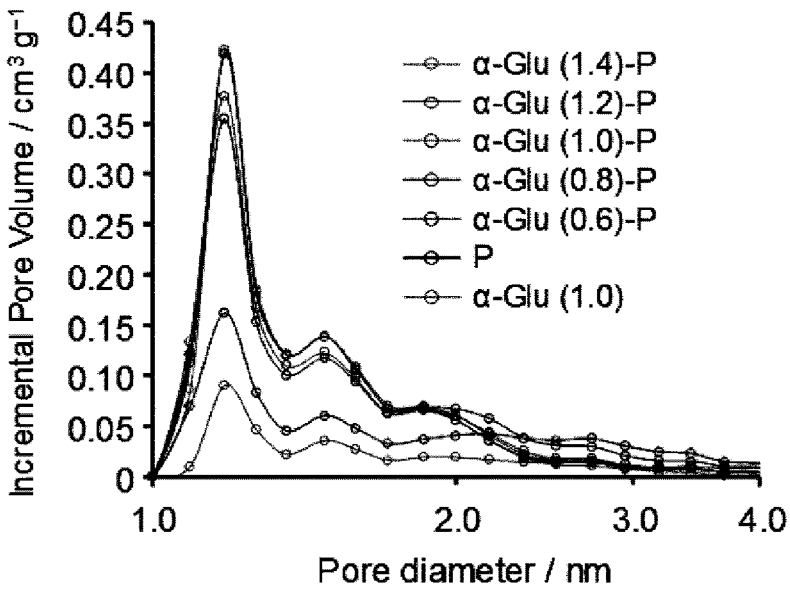
0.45
0.40
0.35
0.30
0.25
0.20
0.15
0.10
0.05
0
Incremental Pore Volume / cm3 g-1
α-Glu (1.4)-P
α-Glu (1.2)-P
α-Glu (1.0)-P
α-Glu (0.8)-P
α-Glu (0.6)-P
P
α-Glu (1.0)
1.0
2.0
3.0
4.0
Pore diameter / nm

FIG. 48

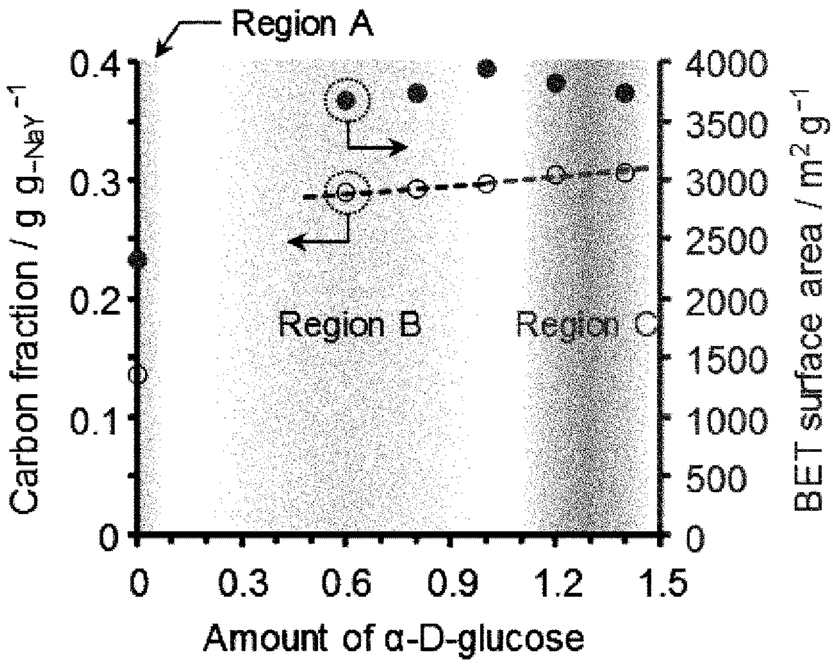
Region A
Region B
Region C
Carbon fraction / g g-NaY-1
0.4
0.3
0.2
0.1
0
BET surface area / m2 g-1
4000
3500
3000
2500
2000
1500
1000
500
0
0
0.3
0.6
0.9
1.2
1.5
Amount of α-D-glucose

FIG. 49-1

α-Glu(1.0)-P

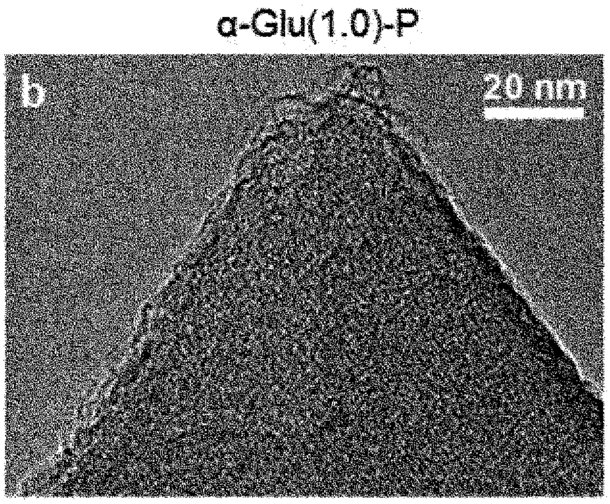


FIG. 49-2

α-Glu(1.4)-P

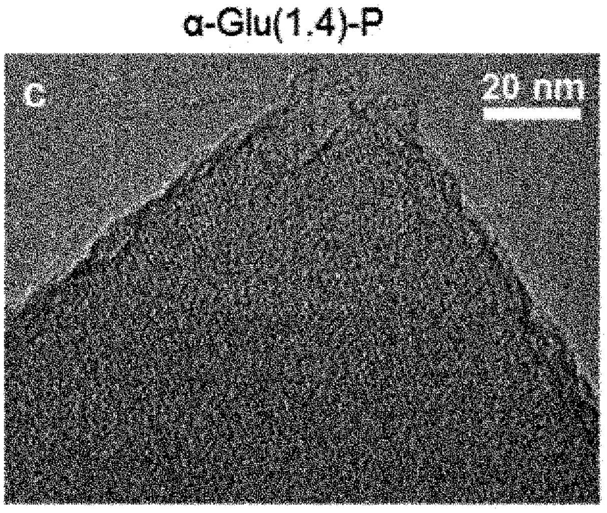

FIG. 50

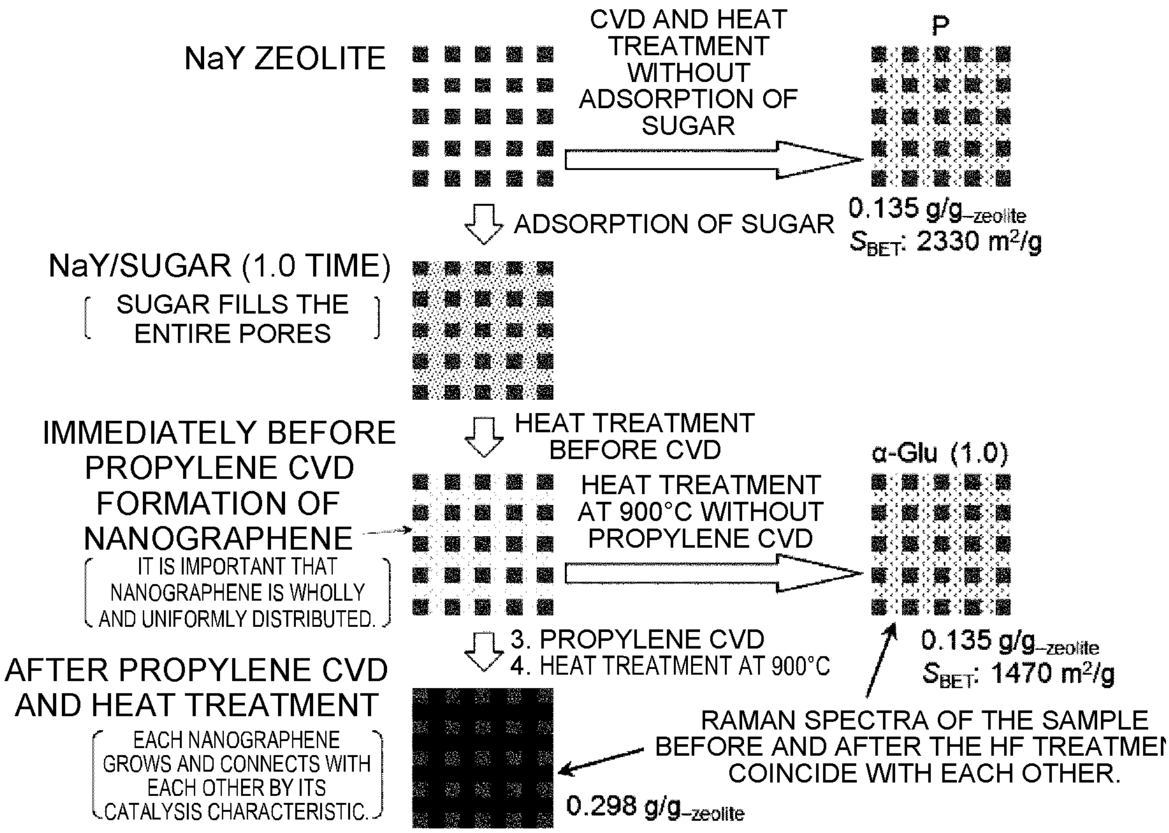
NaY ZEOLITE
CVD AND HEAT TREATMENT WITHOUT ADSORPTION OF SUGAR
P
0.135 g/g-zeolite
$S_{BET}$: 2330 m²/g
ADSORPTION OF SUGAR
NaY/SUGAR (1.0 TIME)
SUGAR FILLS THE ENTIRE PORES
HEAT TREATMENT BEFORE CVD
IMMEDIATELY BEFORE PROPYLENE CVD
FORMATION OF NANOGRAPHENE
IT IS IMPORTANT THAT NANOGRAPHENE IS WHOLLY AND UNIFORMLY DISTRIBUTED.
HEAT TREATMENT AT 900°C WITHOUT PROPYLENE CVD
α-Glu (1.0)
0.135 g/g-zeolite
$S_{BET}$: 1470 m²/g
3. PROPYLENE CVD
4. HEAT TREATMENT AT 900°C
AFTER PROPYLENE CVD AND HEAT TREATMENT
EACH NANOGRAPHENE GROWS AND CONNECTS WITH EACH OTHER BY ITS CATALYSIS CHARACTERISTIC.
RAMAN SPECTRA OF THE SAMPLE BEFORE AND AFTER THE HF TREATMEI
COINCIDE WITH EACH OTHER.
0.298 g/g-zeolite

FIG. 51

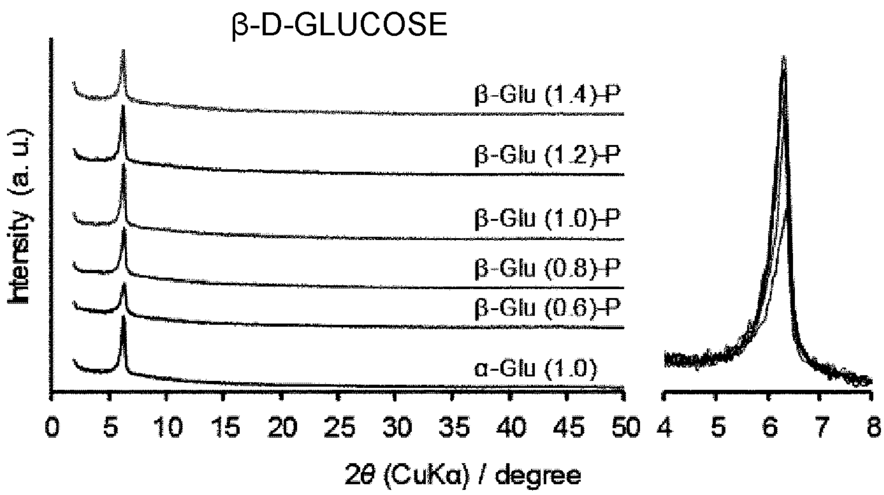
β-D-GLUCOSE
β-Glu (1.4)-P
β-Glu (1.2)-P
β-Glu (1.0)-P
β-Glu (0.8)-P
β-Glu (0.6)-P
α-Glu (1.0)
Intensity (a. u.)
0 5 10 15 20 25 30 35 40 45 50
4 5 6 7 8
2θ (CuKα) / degree

# FIG. 52

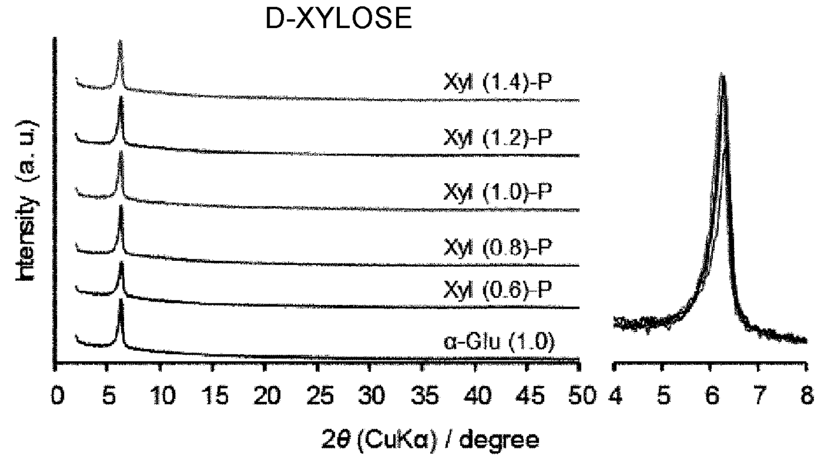


# FIG. 53

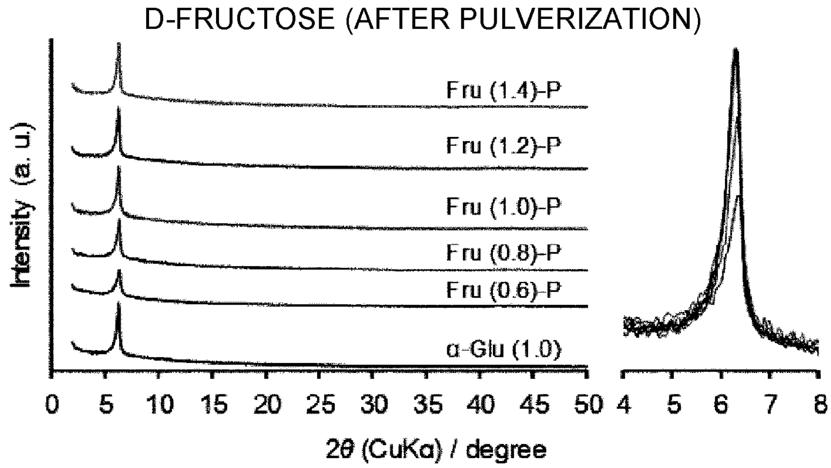


# FIG. 54

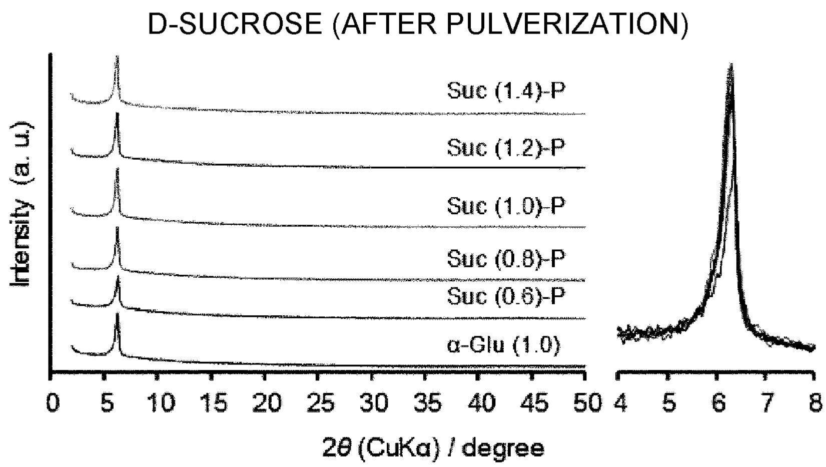

# FIG. 55

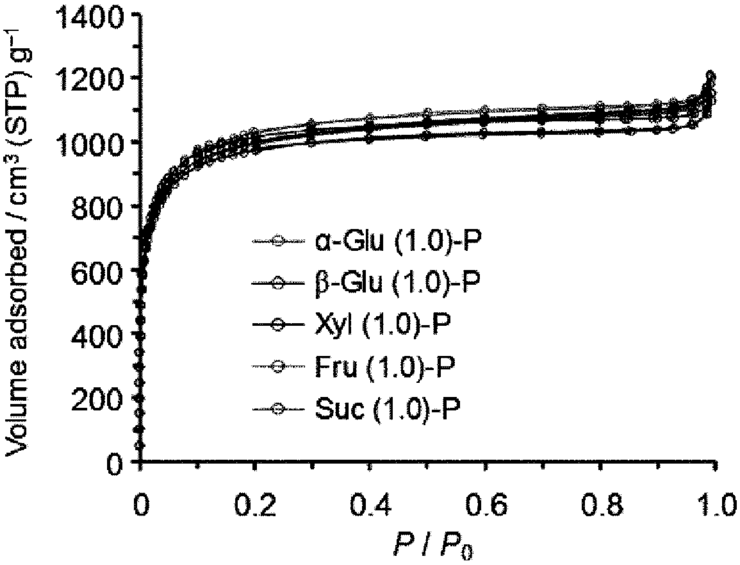

Volume adsorbed / cm³ (STP) g⁻¹
1400
1200
1000
800
600
400
200
0
0
0.2
0.4
0.6
0.8
1.0
P / P0
α-Glu (1.0)-P
β-Glu (1.0)-P
Xyl (1.0)-P
Fru (1.0)-P
Suc (1.0)-P


# FIG. 56

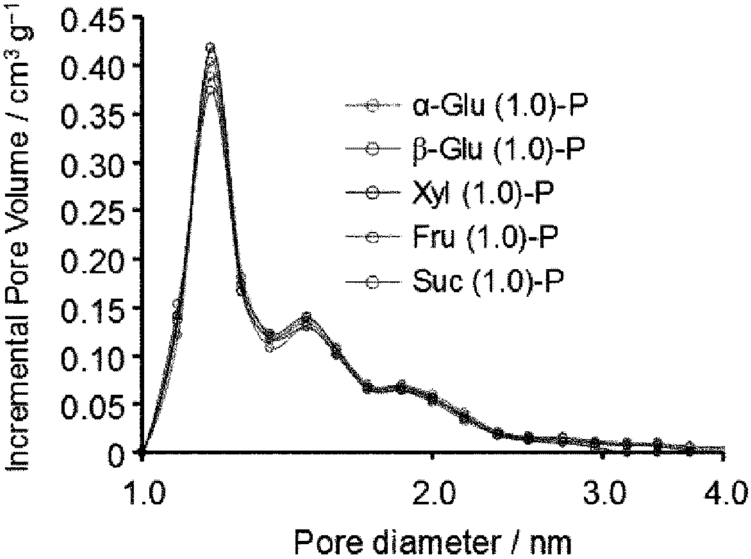

Incremental Pore Volume / cm³ g⁻¹
0.45
0.40
0.35
0.30
0.25
0.20
0.15
0.10
0.05
0
1.0
2.0
3.0
4.0
Pore diameter / nm
α-Glu (1.0)-P
β-Glu (1.0)-P
Xyl (1.0)-P
Fru (1.0)-P
Suc (1.0)-P

FIG. 57-1

α-D-GLUCOSE

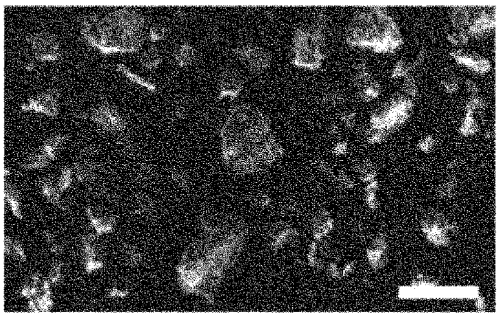

FIG. 57-2

β-D-GLUCOSE

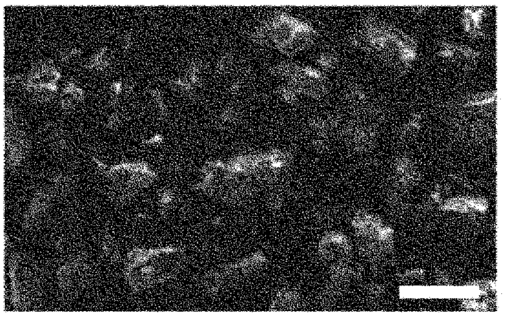

FIG. 57-3

D-XYLOSE

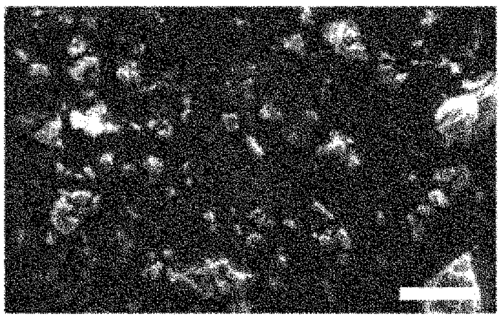

# FIG. 57-4

D-FRUCTOSE

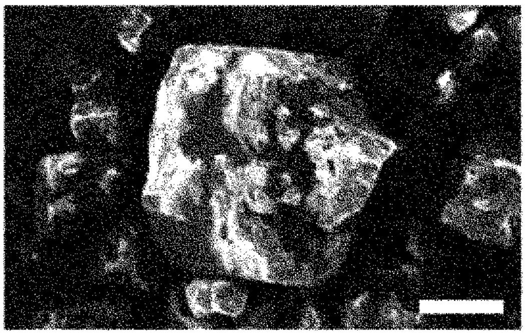

# FIG. 57-5

PULVERIZED D-FRUCTOSE

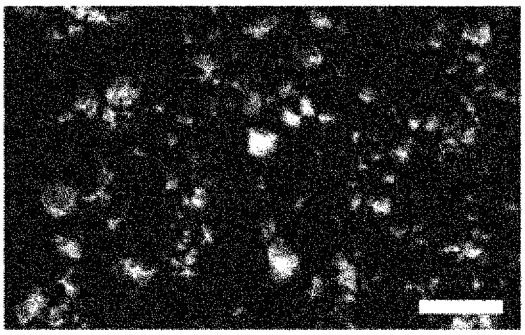

FIG. 57-6

D-SUCROSE

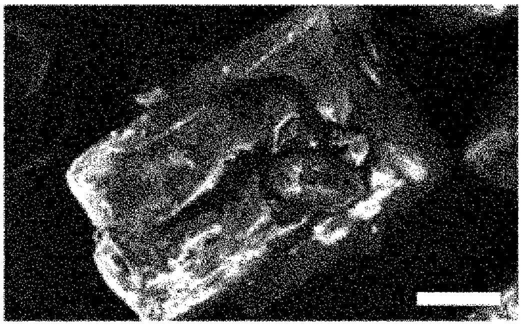

FIG. 57-7

PULVERIZED D-SUCROSE

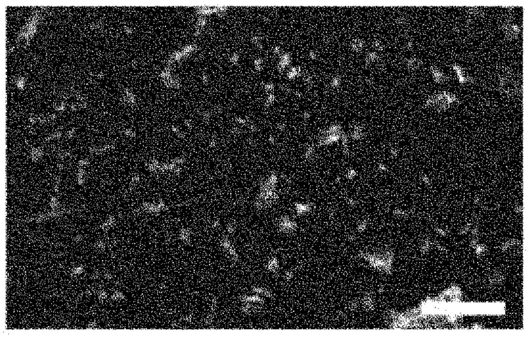

# FIG. 58

α-D-GLUCOSE SYSTEM

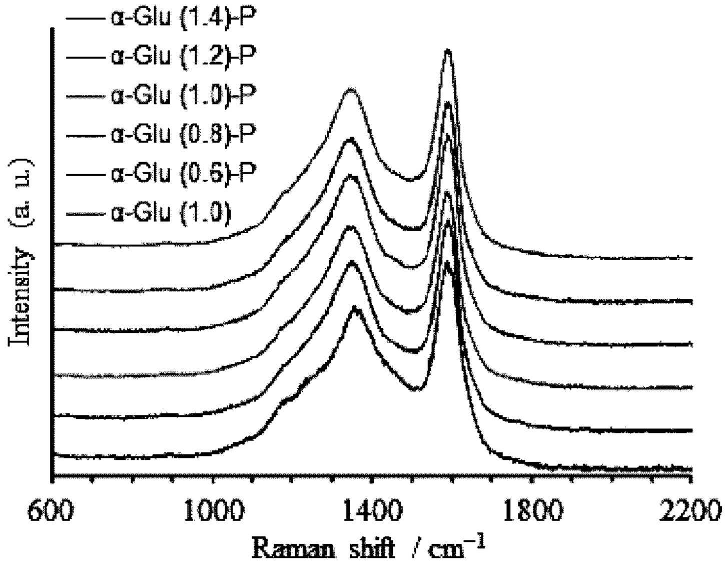


# FIG. 59

1 TIME THE AMOUNT OF SUGAR SYSTEM

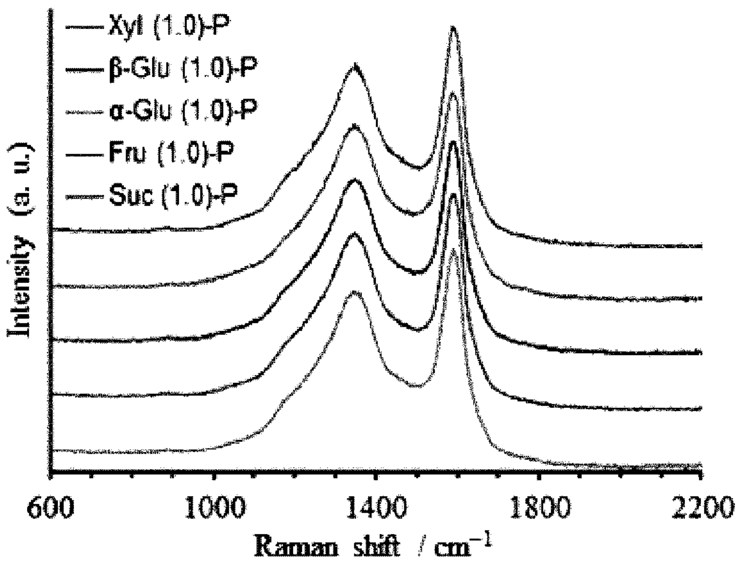

FIG. 60-1

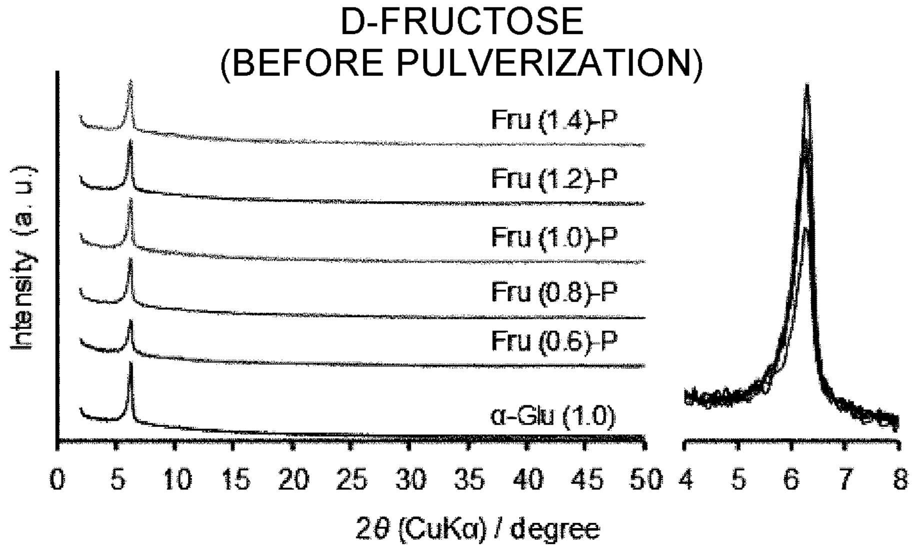


FIG. 60-2

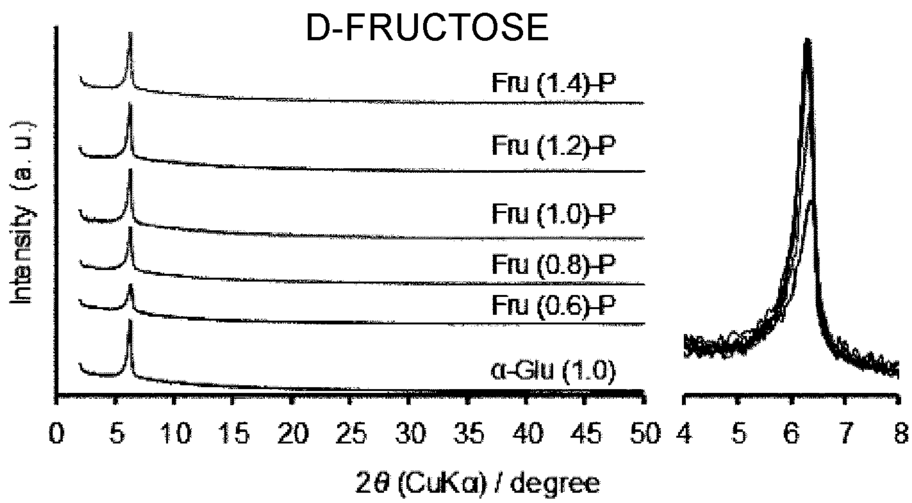

FIG. 61-1

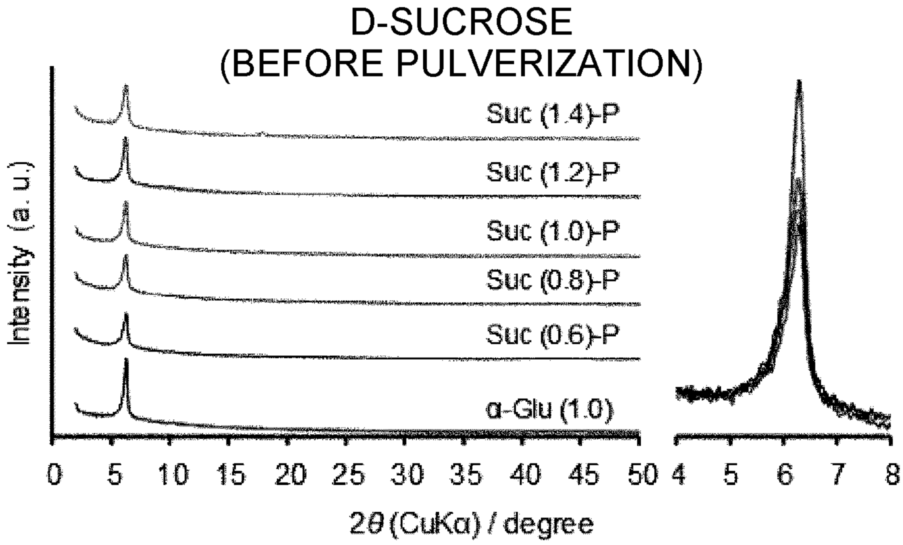


FIG. 61-2

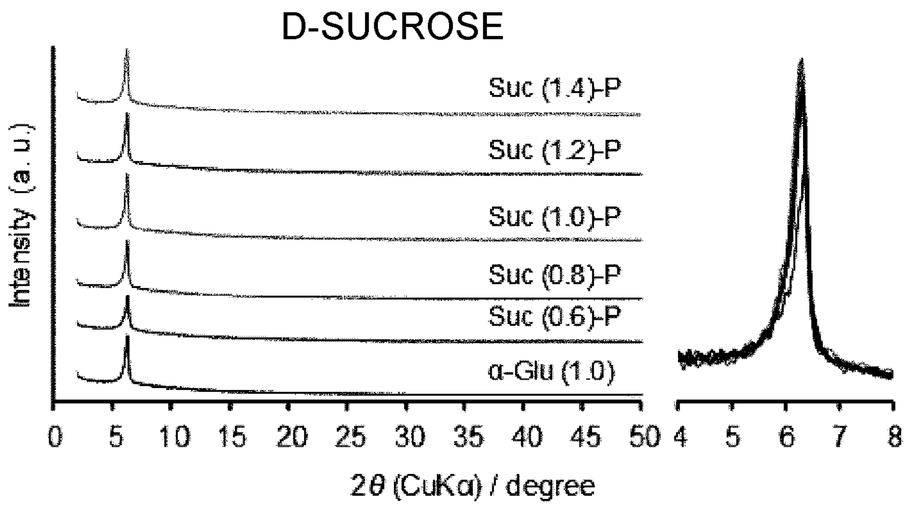

FIG. 62

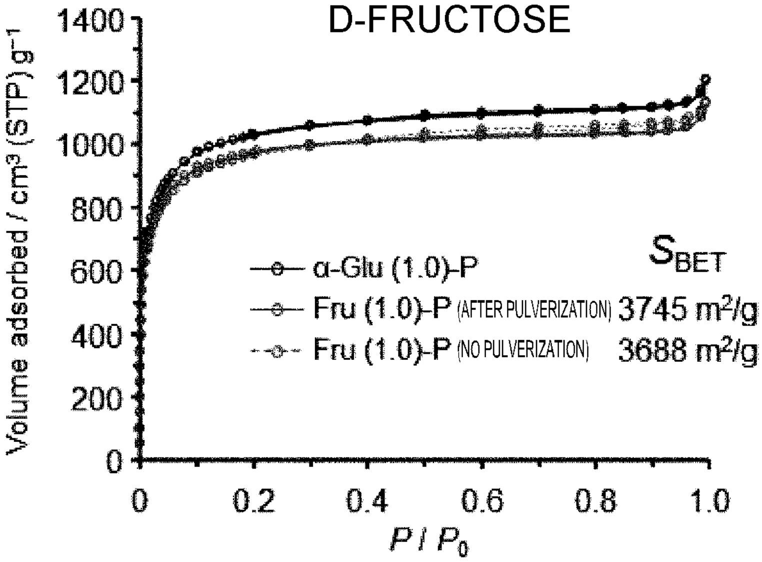


FIG. 63

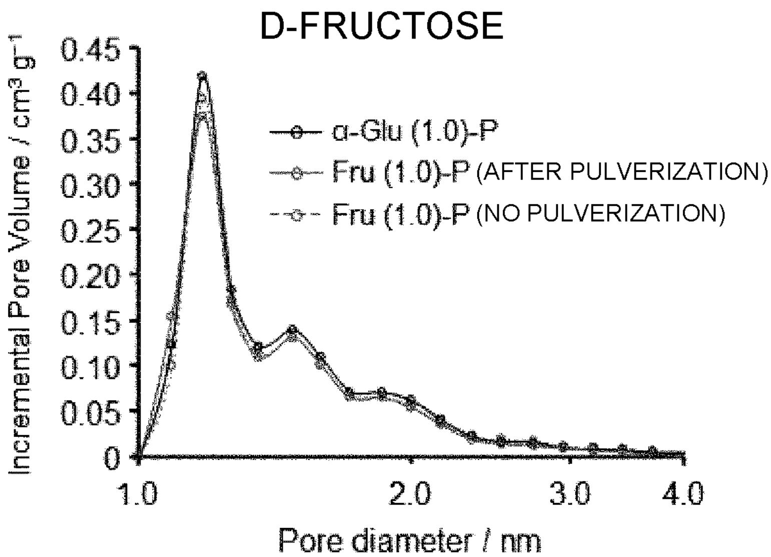


0

FIG. 64

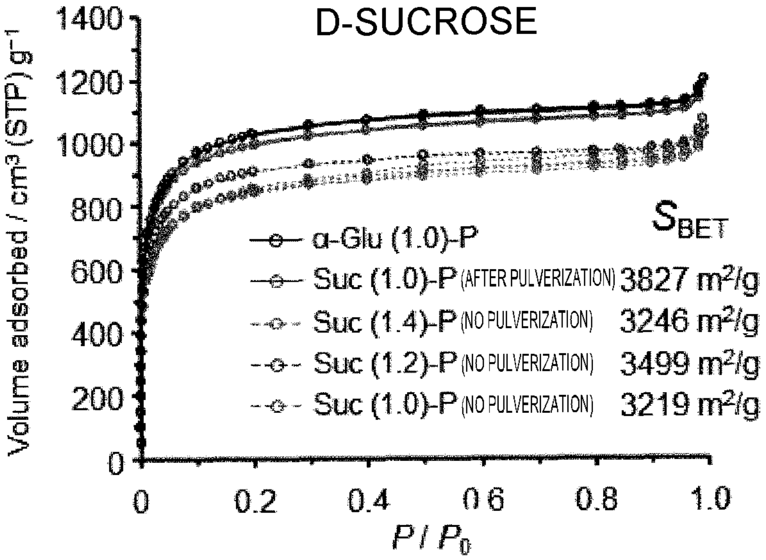
D-SUCROSE
1400
1200
1000
800
600
400
200
0
Volume adsorbed / cm3 (STP) g-1
0
0.2
0.4
0.6
0.8
1.0
P / P0
SBET
α-Glu (1.0)-P
Suc (1.0)-P (AFTER PULVERIZATION) 3827 m2/g
Suc (1.4)-P (NO PULVERIZATION) 3246 m2/g
Suc (1.2)-P (NO PULVERIZATION) 3499 m2/g
Suc (1.0)-P (NO PULVERIZATION) 3219 m2/g

FIG. 65

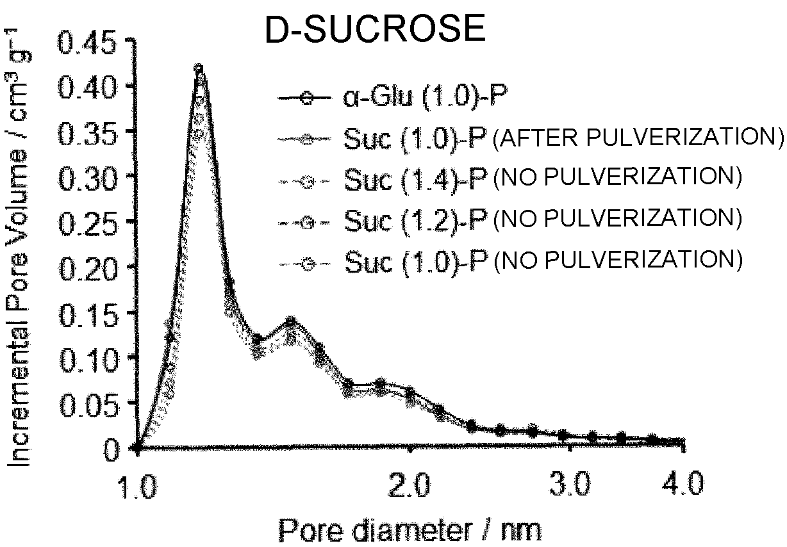
D-SUCROSE
0.45
0.40
0.35
0.30
0.25
0.20
0.15
0.10
0.05
0
Incremental Pore Volume / cm3 g-1
1.0
2.0
3.0
4.0
Pore diameter / nm
α-Glu (1.0)-P
Suc (1.0)-P (AFTER PULVERIZATION)
Suc (1.4)-P (NO PULVERIZATION)
Suc (1.2)-P (NO PULVERIZATION)
Suc (1.0)-P (NO PULVERIZATION)

FIG. 66

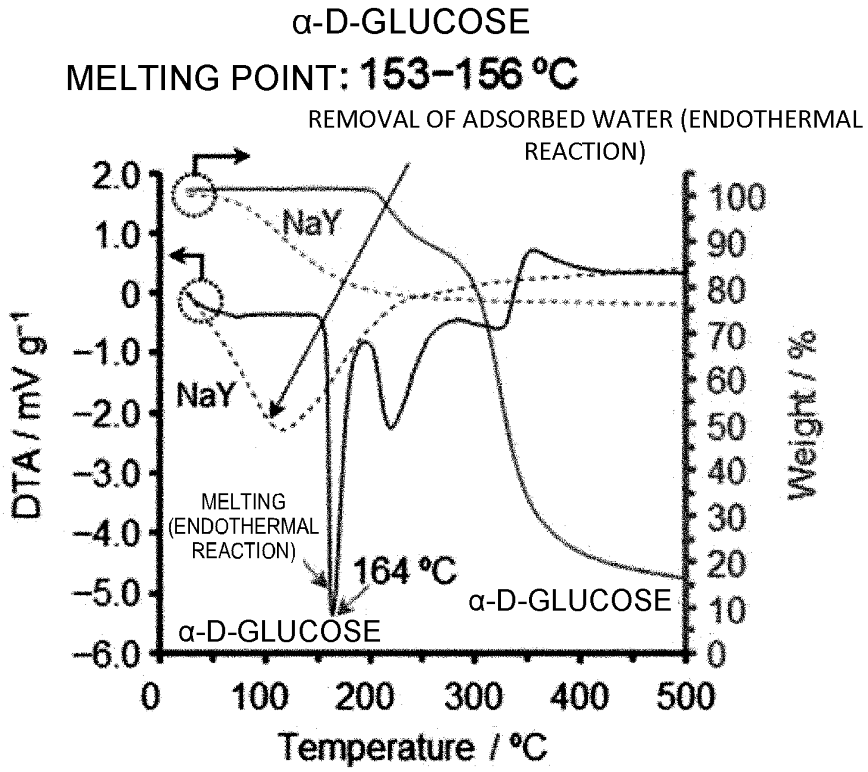
α-D-GLUCOSE
MELTING POINT: 153–156 °C
REMOVAL OF ADSORBED WATER (ENDOTHERMAL REACTION)
NaY
NaY
MELTING (ENDOTHERMAL REACTION)
164 °C
α-D-GLUCOSE
α-D-GLUCOSE
DTA / mV g⁻¹
Weight / %
Temperature / °C
2.0
1.0
0
−1.0
−2.0
−3.0
−4.0
−5.0
−6.0
100
90
80
70
60
50
40
30
20
10
0
0
100
200
300
400
500

FIG. 67

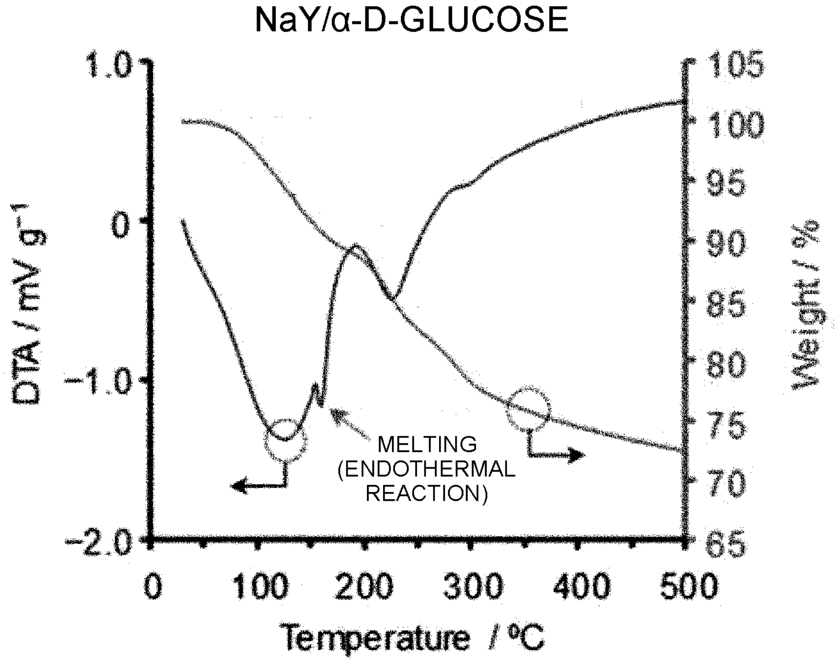
NaY/α-D-GLUCOSE
MELTING (ENDOTHERMAL REACTION)
DTA / mV g⁻¹
Weight / %
Temperature / °C
1.0
0
−1.0
−2.0
105
100
95
90
85
80
75
70
65
0
100
200
300
400
500

FIG. 68

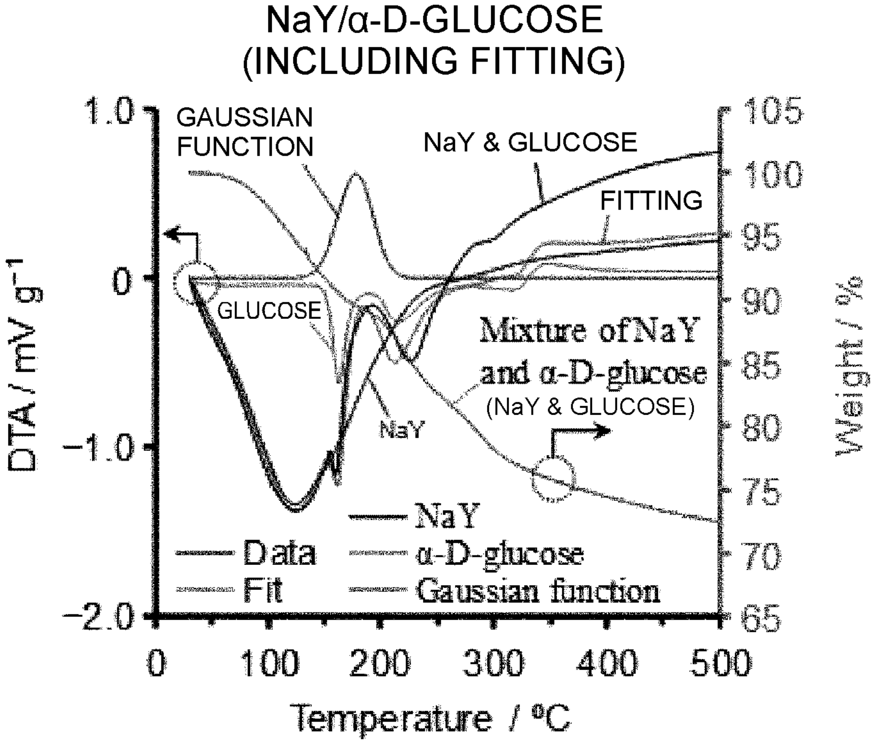
NaY/α-D-GLUCOSE
(INCLUDING FITTING)
GAUSSIAN FUNCTION
NaY & GLUCOSE
FITTING
GLUCOSE
NaY
Mixture of NaY and α-D-glucose
(NaY & GLUCOSE)
NaY
Data
Fit
α-D-glucose
Gaussian function
DTA / mV g−1
Weight / %
Temperature / °C
1.0
0
−1.0
−2.0
105
100
95
90
85
80
75
70
65
0
100
200
300
400
500

FIG. 69

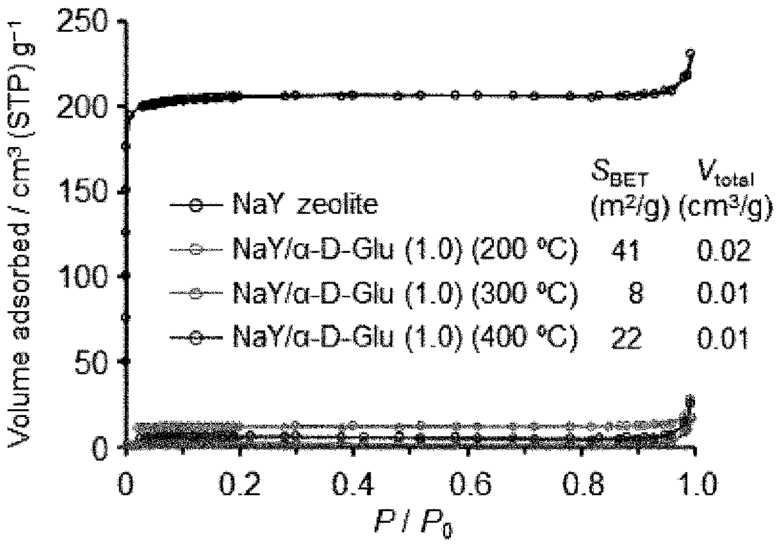
Volume adsorbed / cm3 (STP) g−1
P / P0
SBET (m2/g)
Vtotal (cm3/g)
NaY zeolite
NaY/α-D-Glu (1.0) (200 °C) 41 0.02
NaY/α-D-Glu (1.0) (300 °C) 8 0.01
NaY/α-D-Glu (1.0) (400 °C) 22 0.01
250
200
150
100
50
0
0
0.2
0.4
0.6
0.8
1.0

FIG. 70

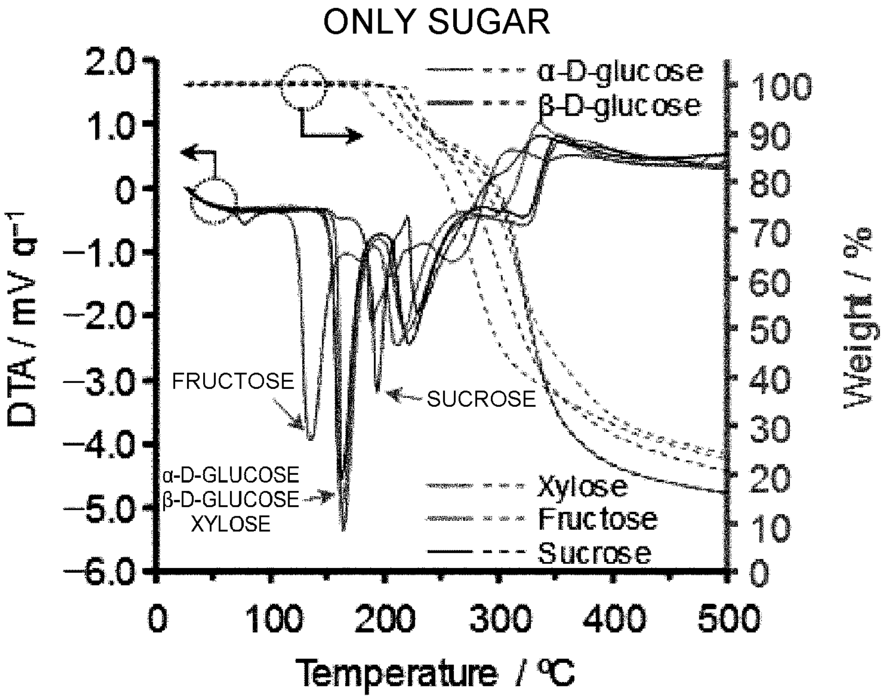
ONLY SUGAR
α-D-glucose
β-D-glucose
FRUCTOSE
SUCROSE
α-D-GLUCOSE
β-D-GLUCOSE
XYLOSE
Xylose
Fructose
Sucrose
DTA / mV g⁻¹
Weight / %
Temperature / °C

FIG. 71

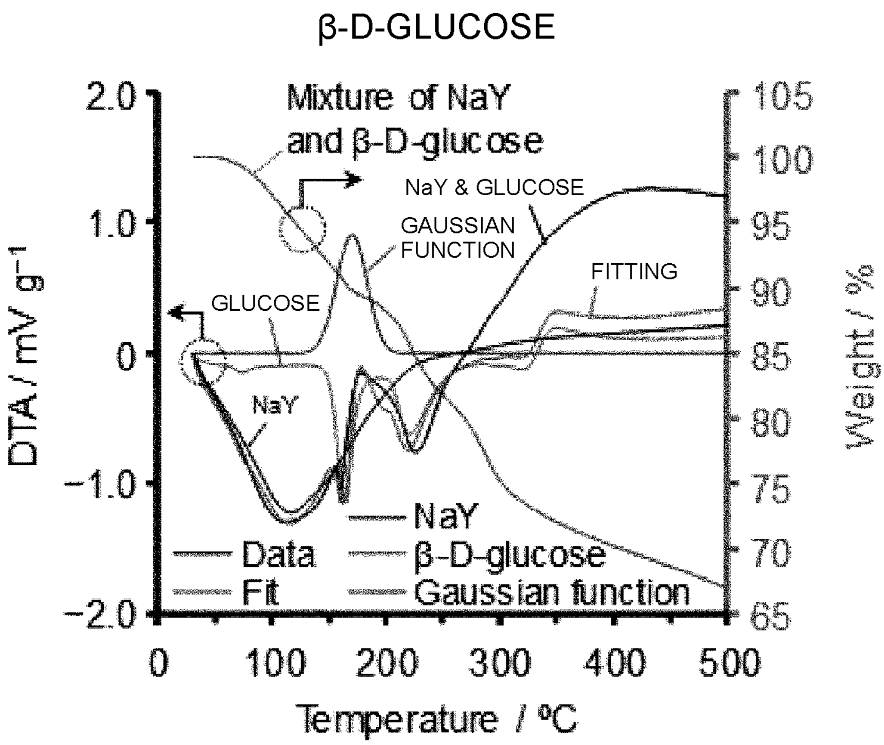
β-D-GLUCOSE
Mixture of NaY and β-D-glucose
NaY & GLUCOSE
GAUSSIAN FUNCTION
FITTING
GLUCOSE
NaY
Data
Fit
NaY
β-D-glucose
Gaussian function
DTA / mV g⁻¹
Weight / %
Temperature / °C

FIG. 72

D-XYLOSE

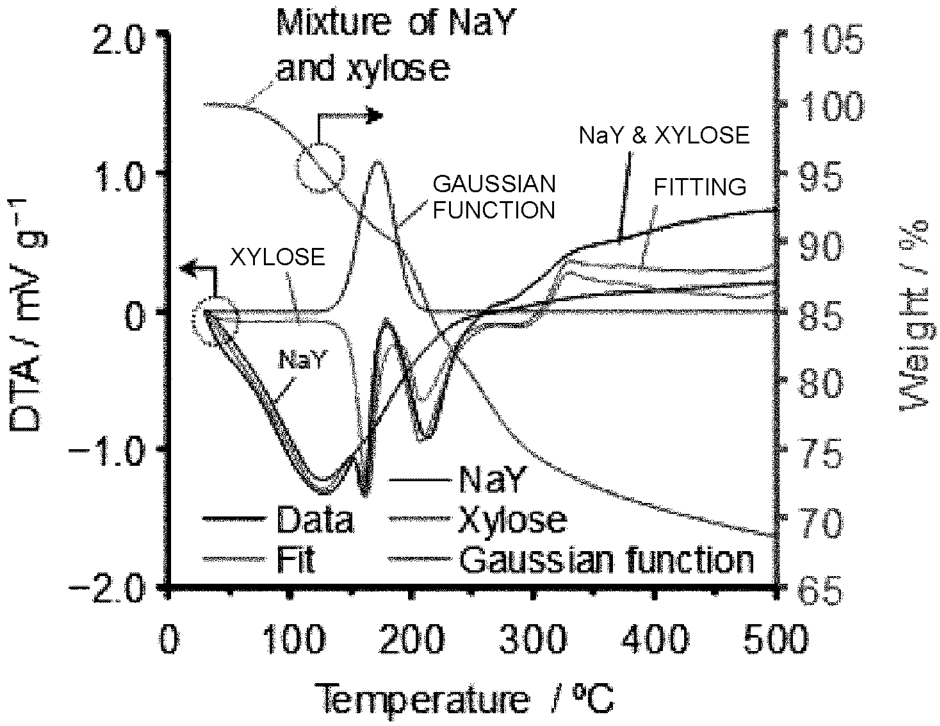

# FIG. 73-1

D-SUCROSE
(BEFORE PULVERIZATION)

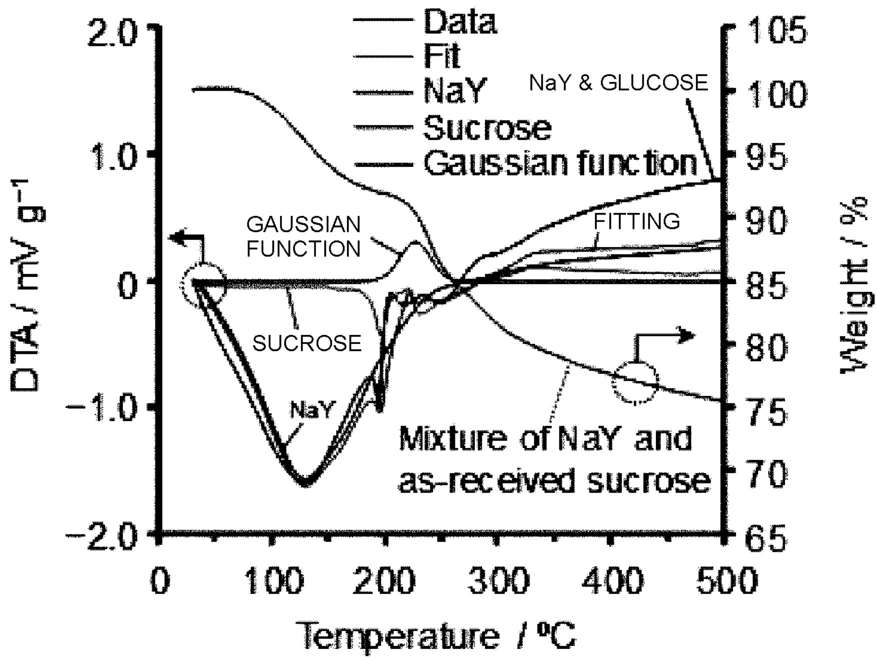


# FIG. 73-2

D-SUCROSE
(AFTER PULVERIZATION)

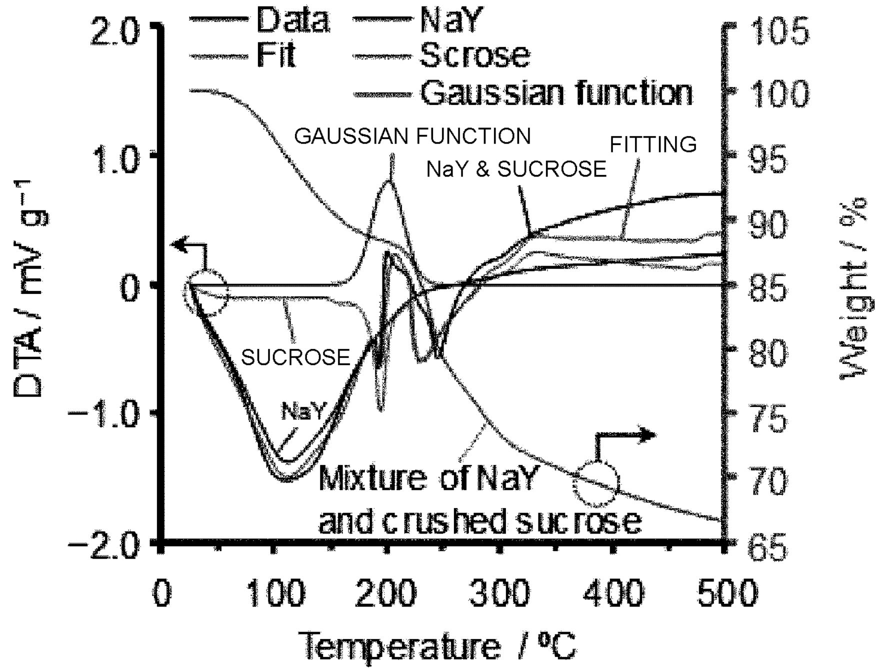

FIG. 74-1

D-FRUCTOSE
(BEFORE PULVERIZATION)

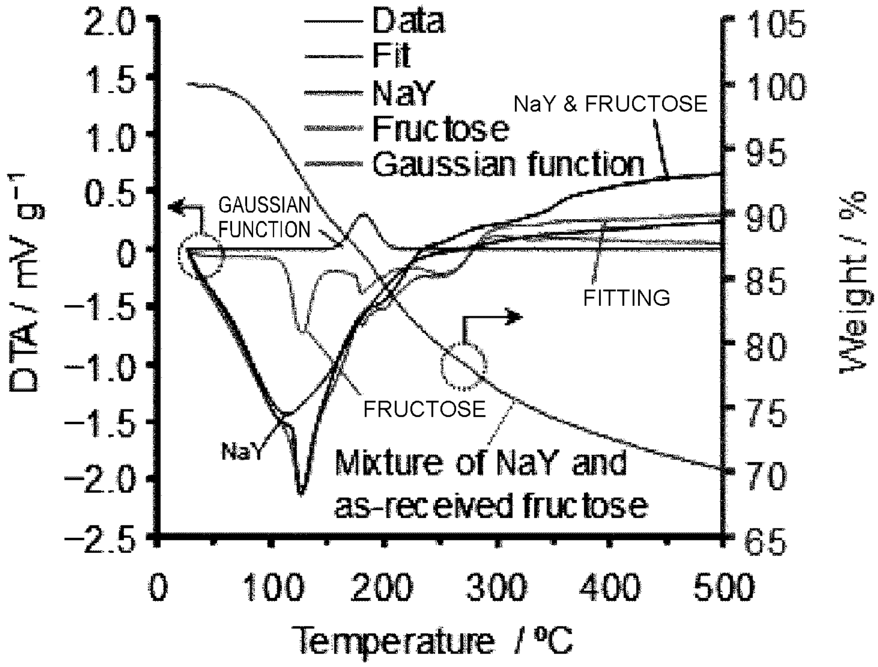


FIG. 74-2

D-FRUCTOSE
(AFTER PULVERIZATION)

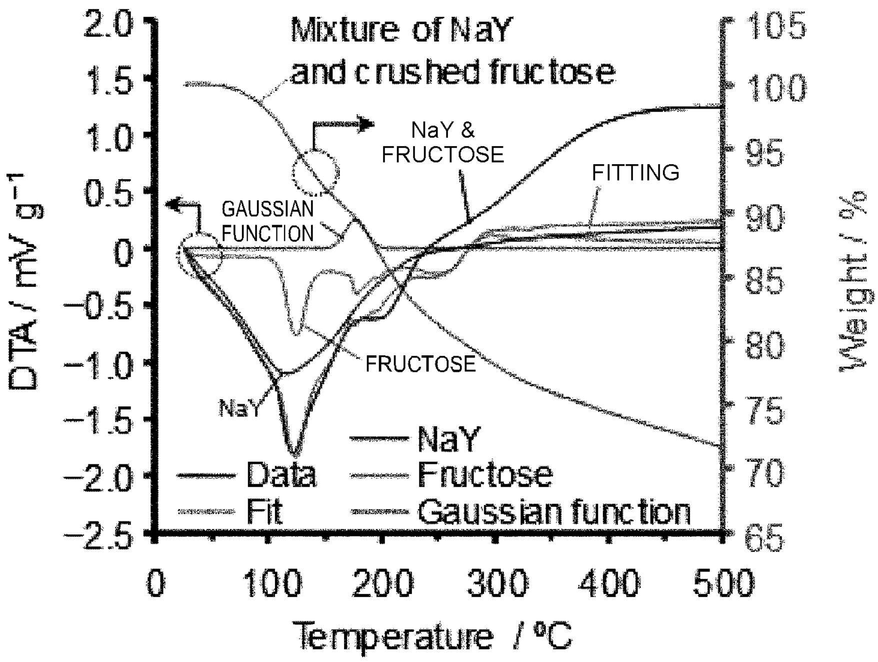

FIG. 75

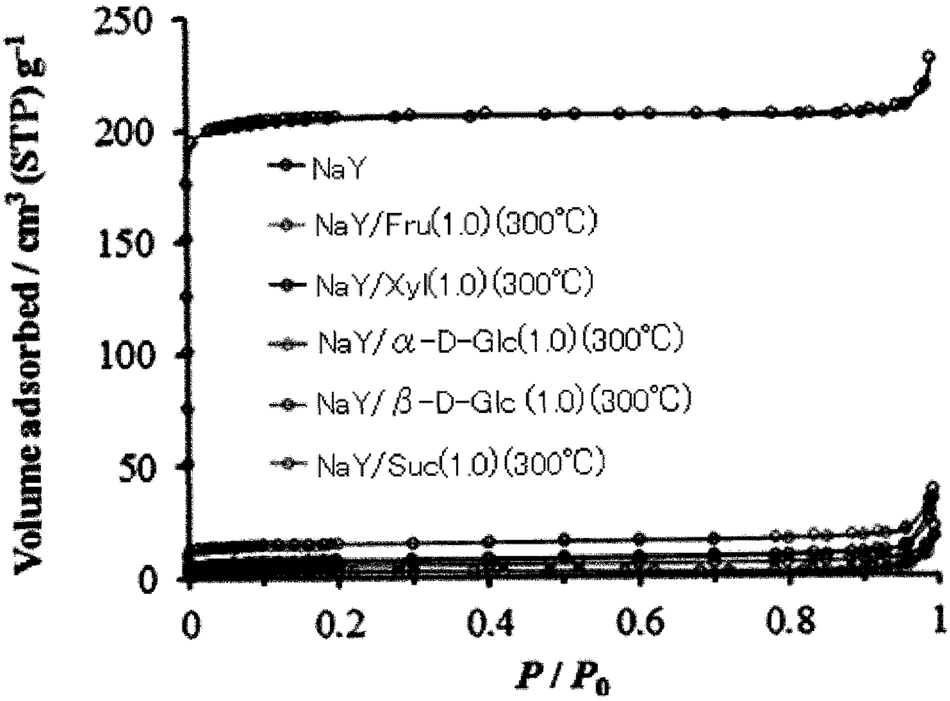
Volume adsorbed / cm$^3$ (STP) g$^{-1}$
250
200
150
100
50
0
0
0.2
0.4
0.6
0.8
1
P / P$_0$
NaY
NaY/Fru(1.0)(300°C)
NaY/Xyl(1.0)(300°C)
NaY/α-D-Glc(1.0)(300°C)
NaY/β-D-Glc (1.0)(300°C)
NaY/Suc(1.0)(300°C)

FIG. 76-1

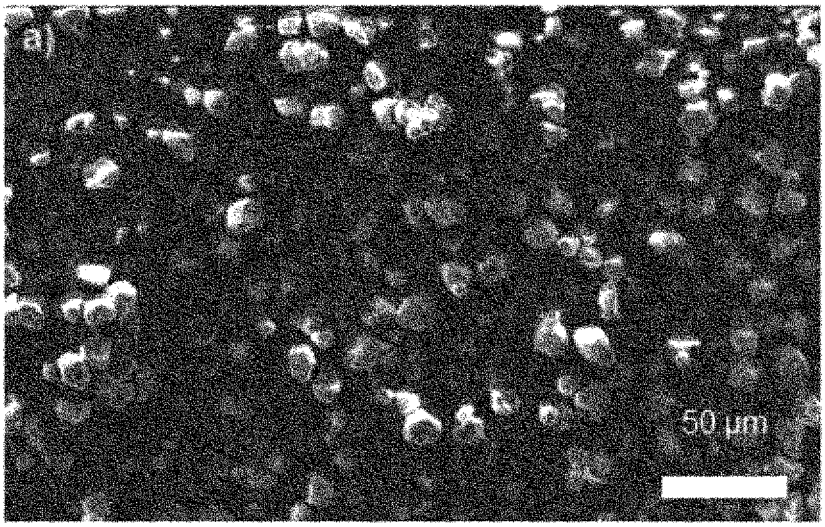


FIG. 76-2

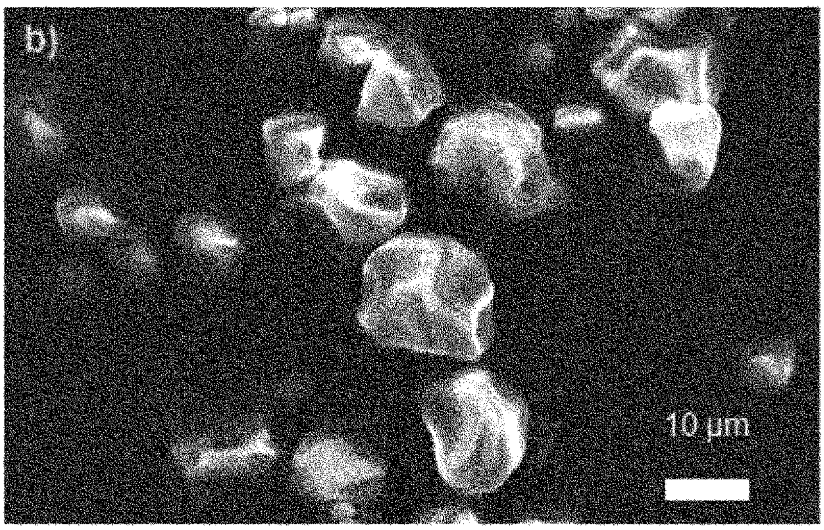

FIG. 77-1

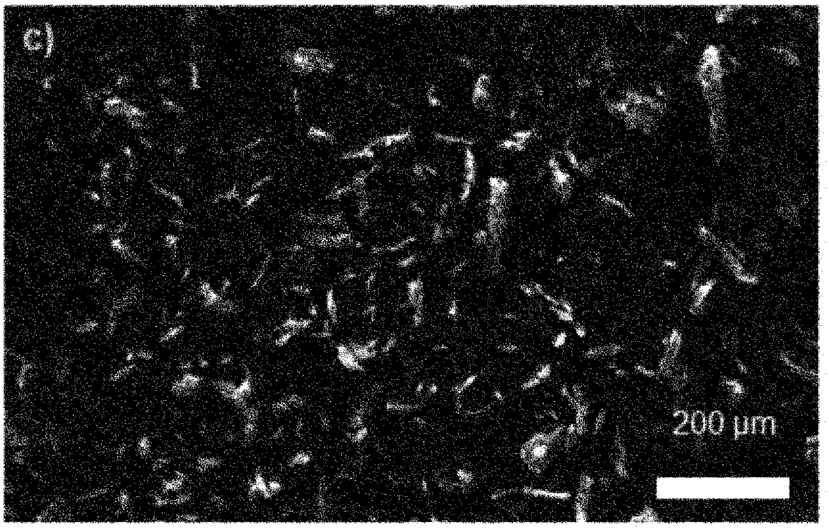


FIG. 77-2

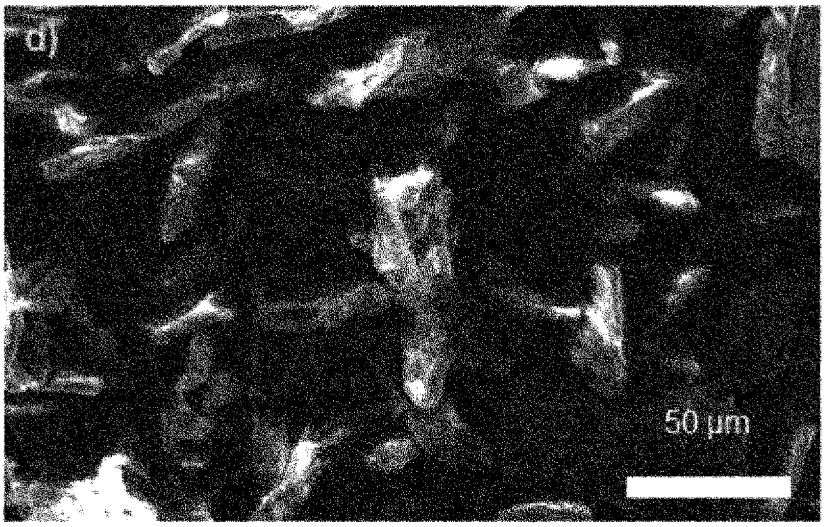

FIG. 78

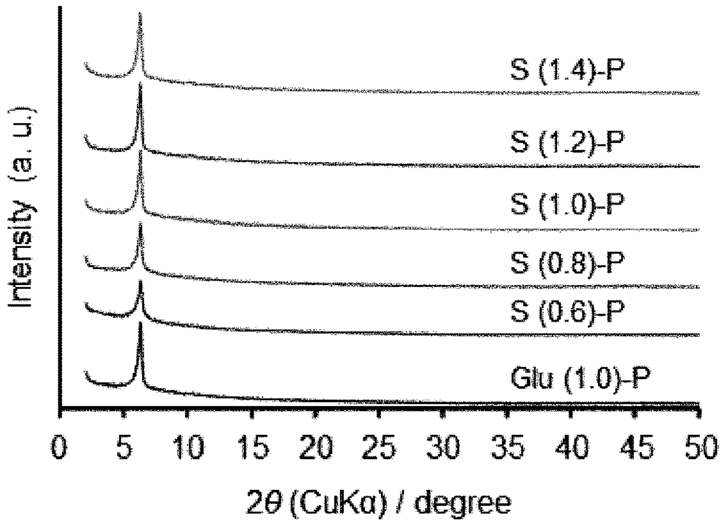
Intensity (a. u.)
S (1.4)-P
S (1.2)-P
S (1.0)-P
S (0.8)-P
S (0.6)-P
Glu (1.0)-P
0 5 10 15 20 25 30 35 40 45 50
2θ (CuKα) / degree

FIG. 79

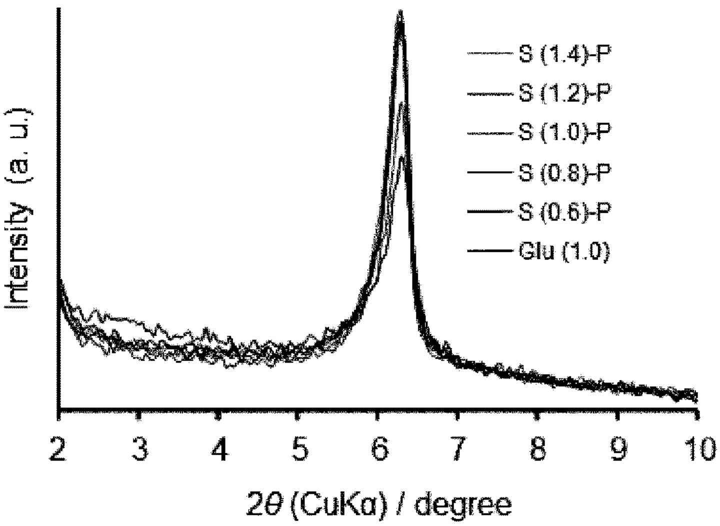
Intensity (a. u.)
S (1.4)-P
S (1.2)-P
S (1.0)-P
S (0.8)-P
S (0.6)-P
Glu (1.0)
2 3 4 5 6 7 8 9 10
2θ (CuKα) / degree

FIG. 80

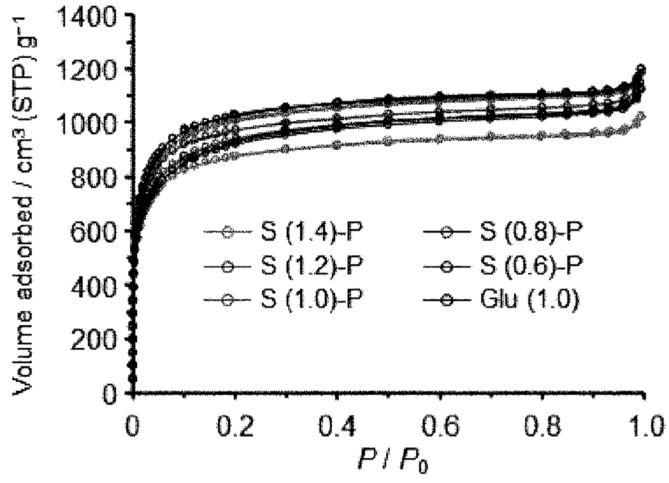


FIG. 81

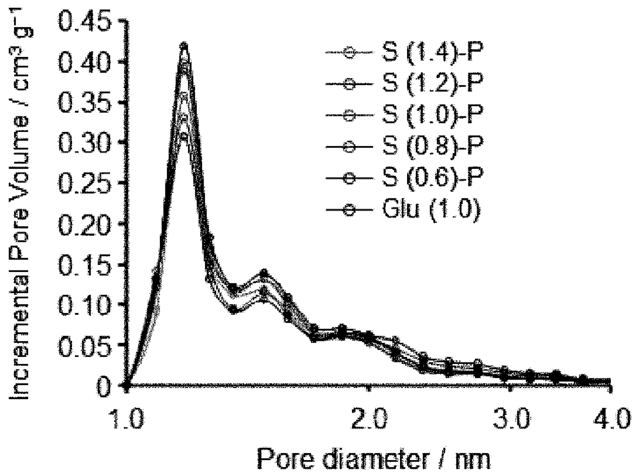


FIG. 82

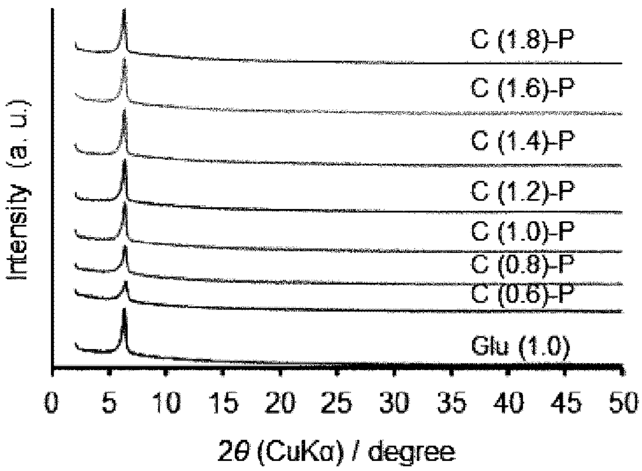

FIG. 83

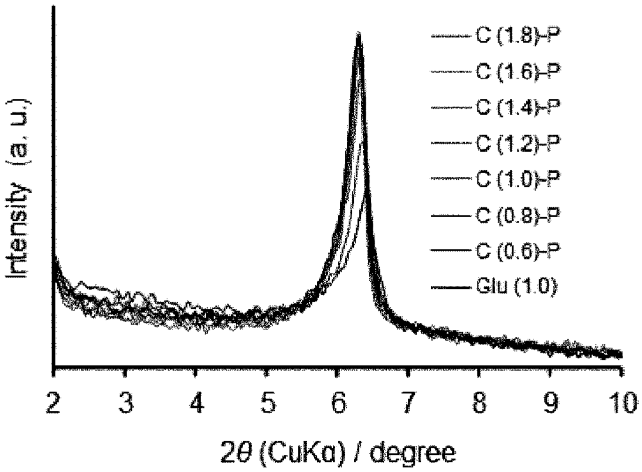


FIG. 84

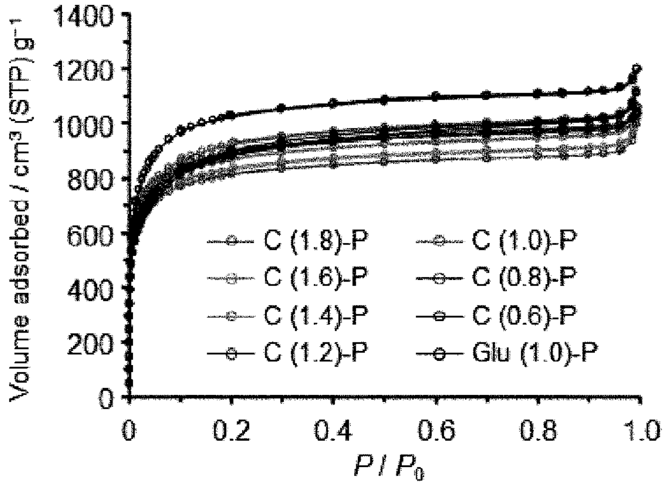


FIG. 85

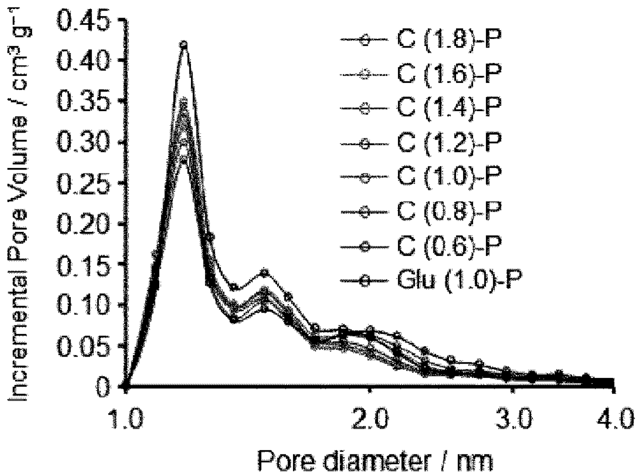

FIG. 86

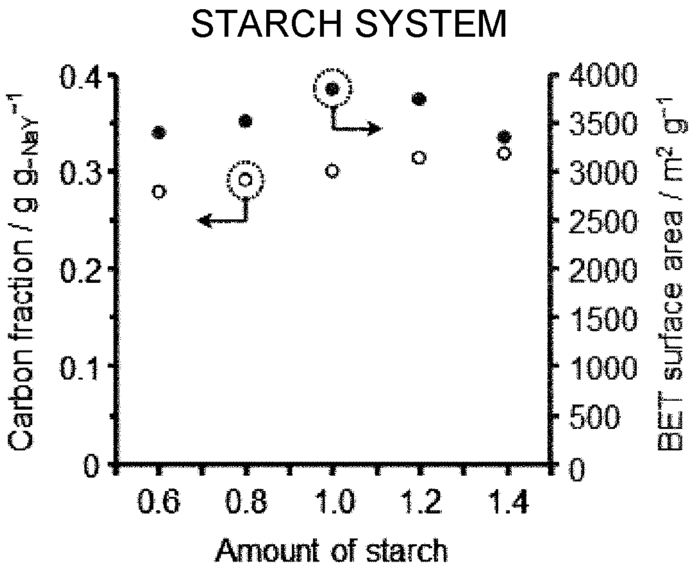
STARCH SYSTEM
Carbon fraction / g g-NaY⁻¹
0.4
0.3
0.2
0.1
0
BET surface area / m² g⁻¹
4000
3500
3000
2500
2000
1500
1000
500
0
0.6
0.8
1.0
1.2
1.4
Amount of starch

FIG. 87

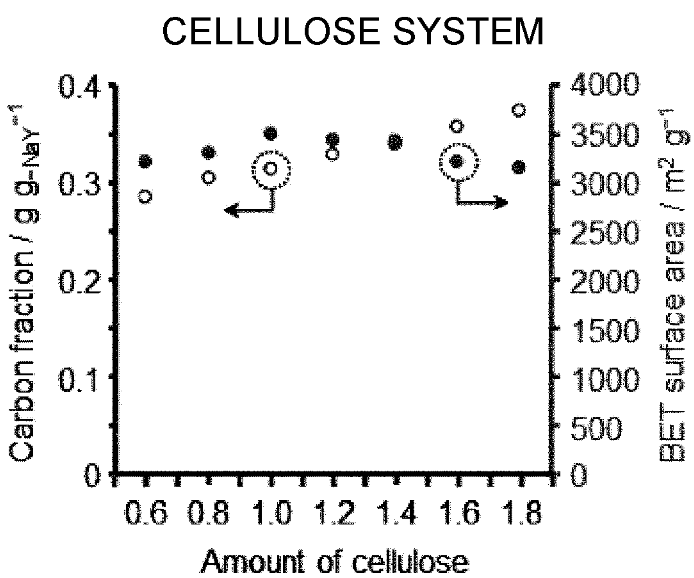
CELLULOSE SYSTEM
Carbon fraction / g g-NaY⁻¹
0.4
0.3
0.2
0.1
0
BET surface area / m² g⁻¹
4000
3500
3000
2500
2000
1500
1000
500
0
0.6
0.8
1.0
1.2
1.4
1.6
1.8
Amount of cellulose

FIG. 88-1

Cel (1.0)-P

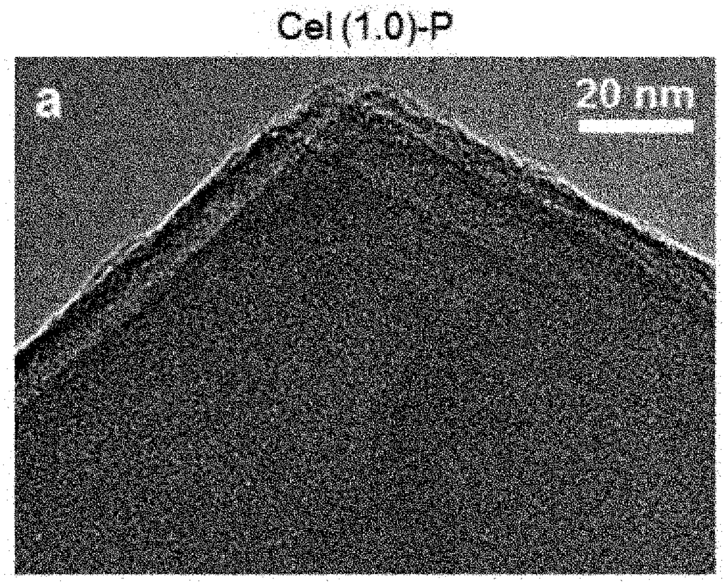


FIG. 88-2

Cel (1.8)-P

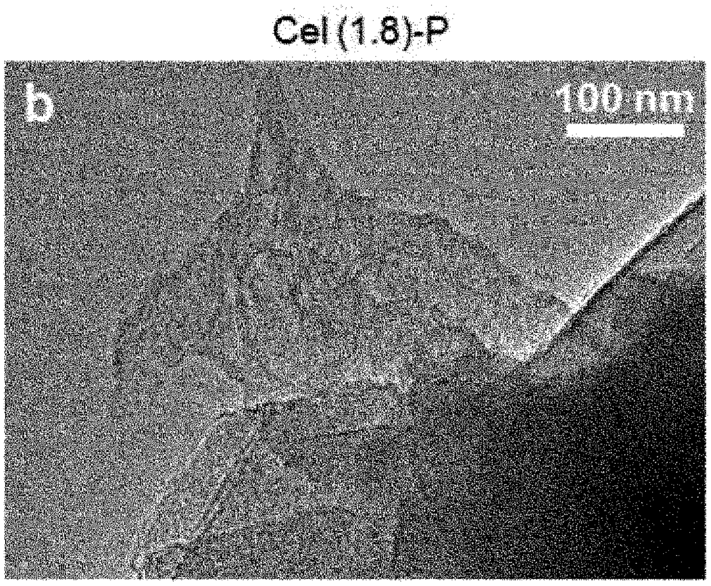

FIG. 89

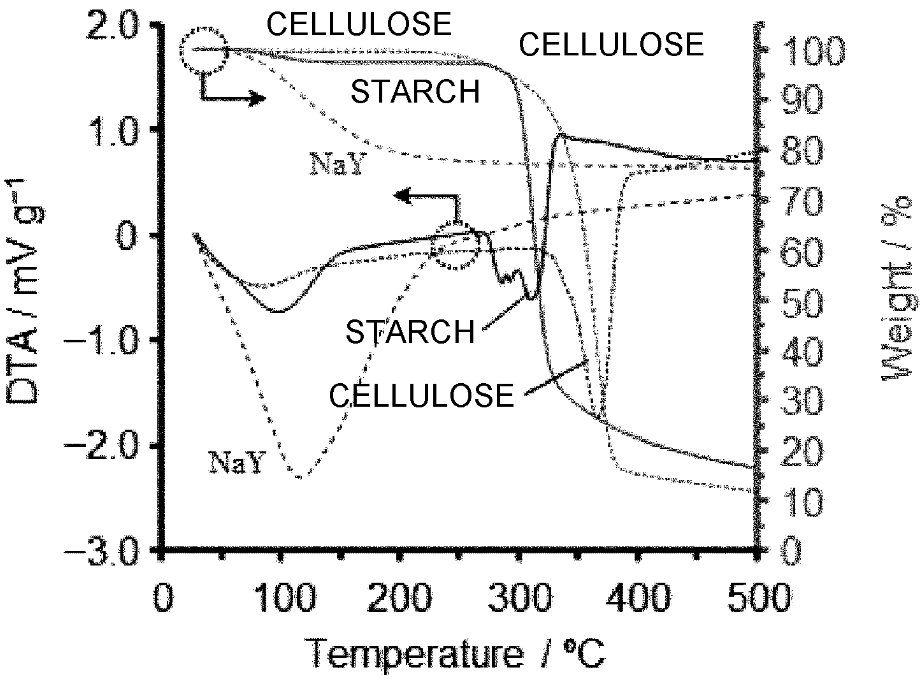
CELLULOSE
CELLULOSE
STARCH
NaY
STARCH
CELLULOSE
NaY
2.0
1.0
0
−1.0
−2.0
−3.0
DTA / mV g⁻¹
100
90
80
70
60
50
40
30
20
10
0
Weight / %
0
100
200
300
400
500
Temperature / °C

FIG. 90

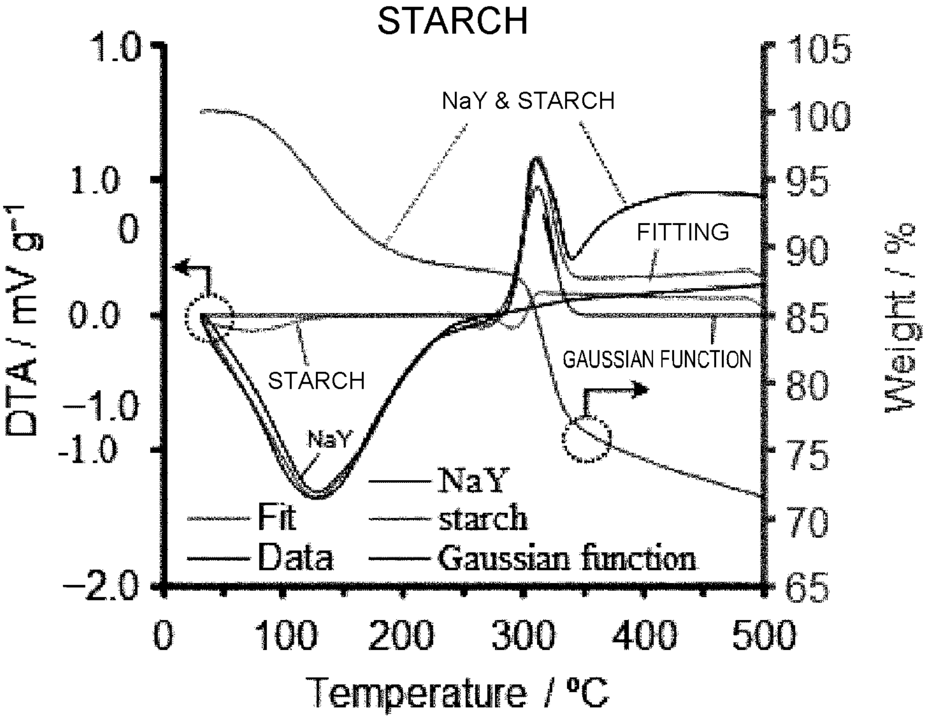
STARCH
NaY & STARCH
FITTING
GAUSSIAN FUNCTION
STARCH
NaY
NaY
Fit
starch
Data
Gaussian function
1.0
1.0
0
0.0
−1.0
-1.0
−2.0
DTA / mV g⁻¹
105
100
95
90
85
80
75
70
65
Weight / %
0
100
200
300
400
500
Temperature / °C

# FIG. 91

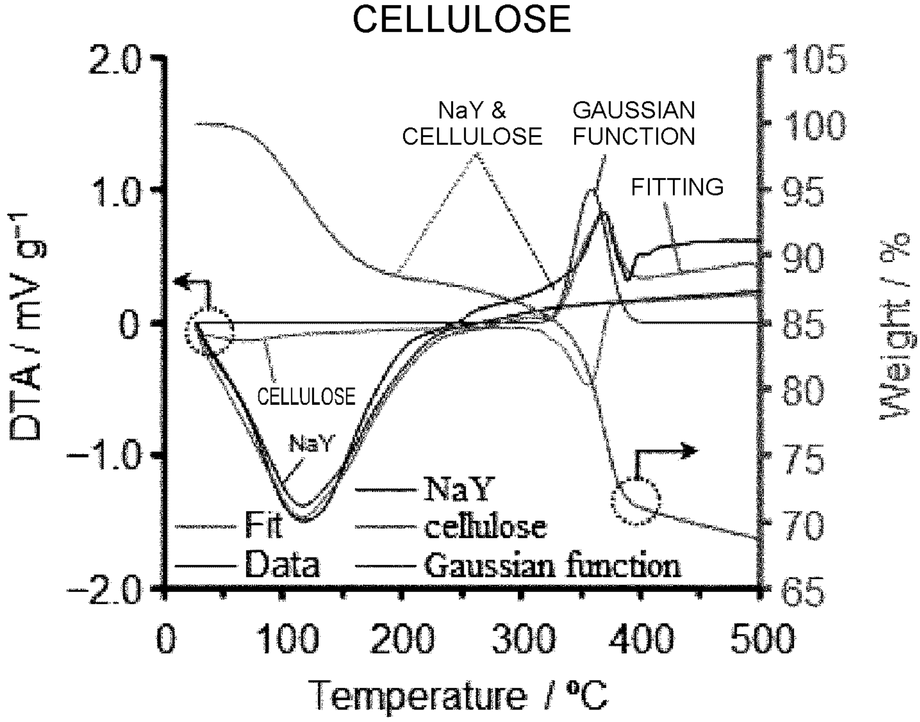
CELLULOSE
2.0
1.0
0
−1.0
−2.0
DTA / mV g⁻¹
105
100
95
90
85
80
75
70
65
Weight / %
NaY &
CELLULOSE
GAUSSIAN
FUNCTION
FITTING
CELLULOSE
NaY
NaY
Fit
cellulose
Data
Gaussian function
0
100
200
300
400
500
Temperature / °C

# FIG. 92

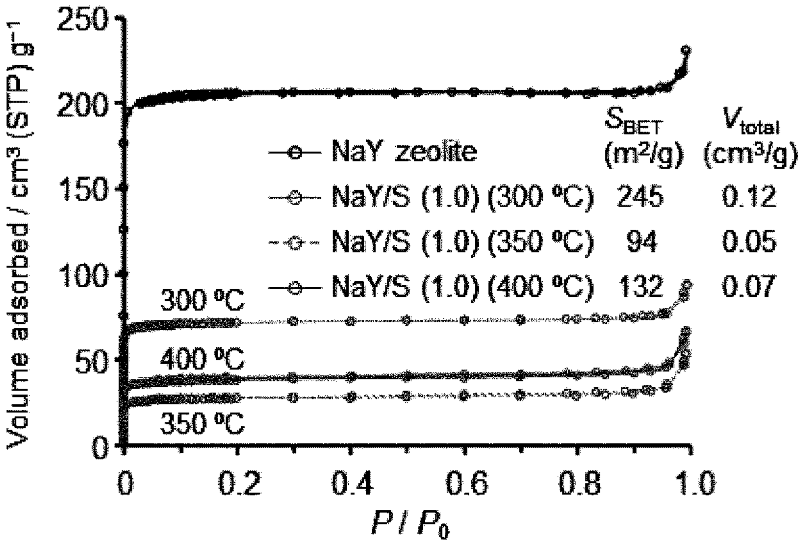
250
200
150
100
50
0
Volume adsorbed / cm³ (STP) g⁻¹
NaY zeolite
NaY/S (1.0) (300 °C)
NaY/S (1.0) (350 °C)
NaY/S (1.0) (400 °C)
S_BET (m²/g)
245
94
132
V_total (cm³/g)
0.12
0.05
0.07
300 °C
400 °C
350 °C
0
0.2
0.4
0.6
0.8
1.0
P / P0

FIG. 93

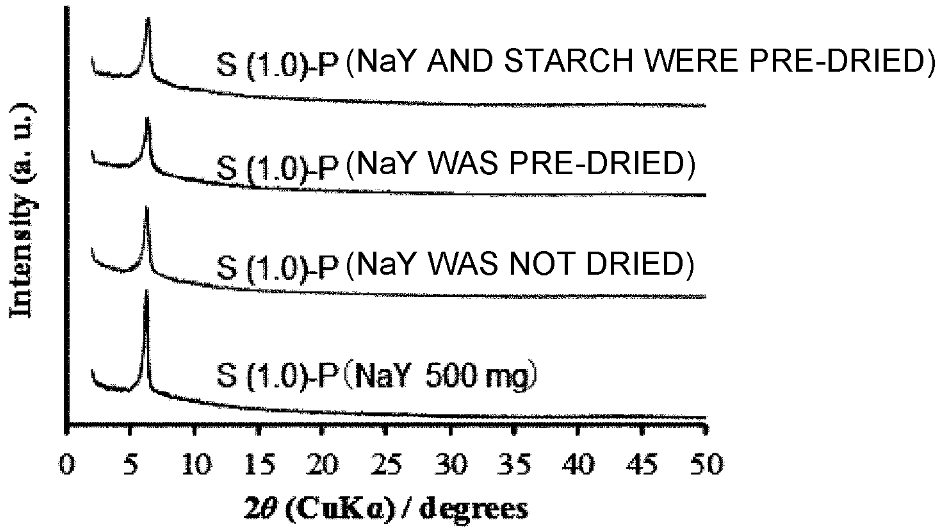
S (1.0)-P (NaY AND STARCH WERE PRE-DRIED)
S (1.0)-P (NaY WAS PRE-DRIED)
S (1.0)-P (NaY WAS NOT DRIED)
S (1.0)-P (NaY 500 mg)
Intensity (a. u.)
0 5 10 15 20 25 30 35 40 45 50
2θ (CuKα) / degrees

FIG. 94

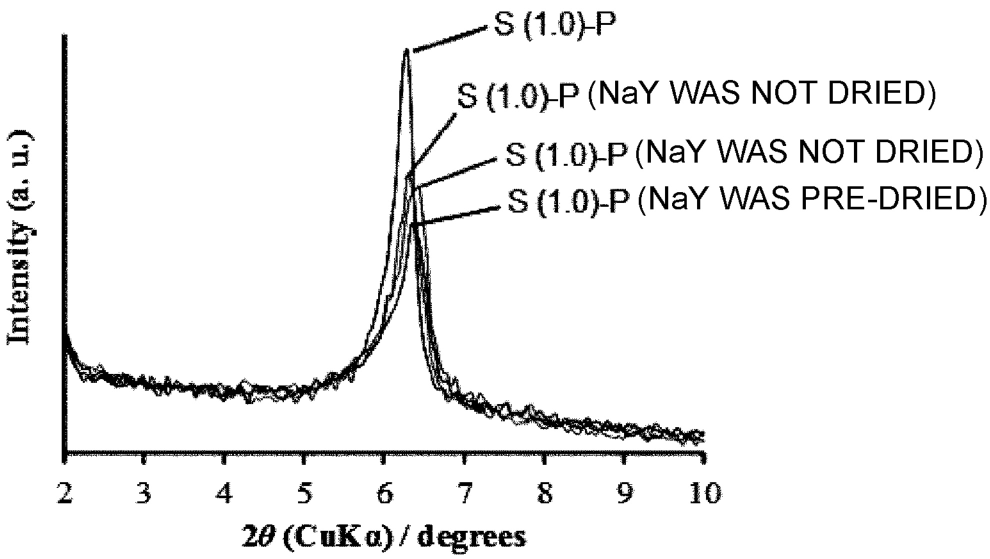
S (1.0)-P
S (1.0)-P (NaY WAS NOT DRIED)
S (1.0)-P (NaY WAS NOT DRIED)
S (1.0)-P (NaY WAS PRE-DRIED)
Intensity (a. u.)
2 3 4 5 6 7 8 9 10
2θ (CuKα) / degrees

FIG. 95

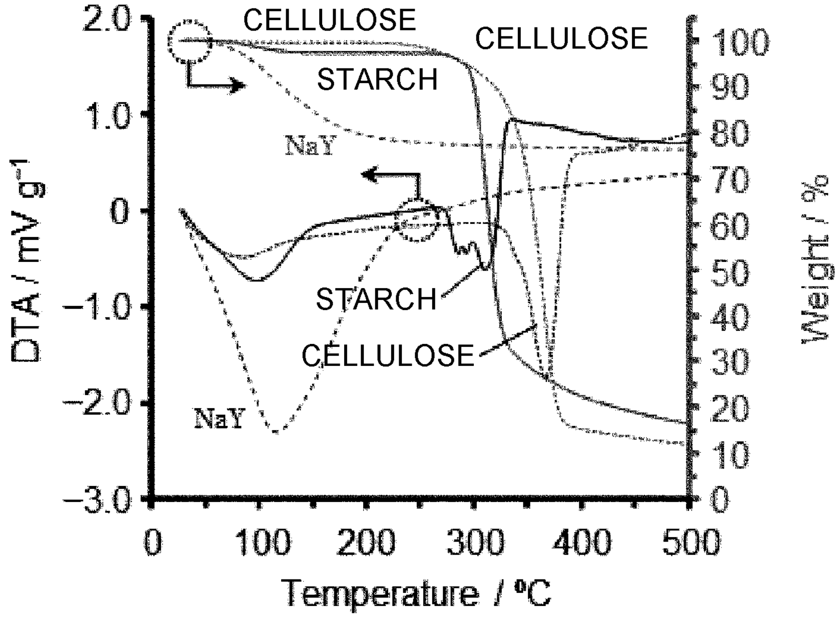
CELLULOSE
CELLULOSE
STARCH
NaY
STARCH
CELLULOSE
NaY
DTA / mV g⁻¹
Weight / %
Temperature / °C
2.0
1.0
0
−1.0
−2.0
−3.0
100
90
80
70
60
50
40
30
20
10
0
0
100
200
300
400
500

FIG. 96

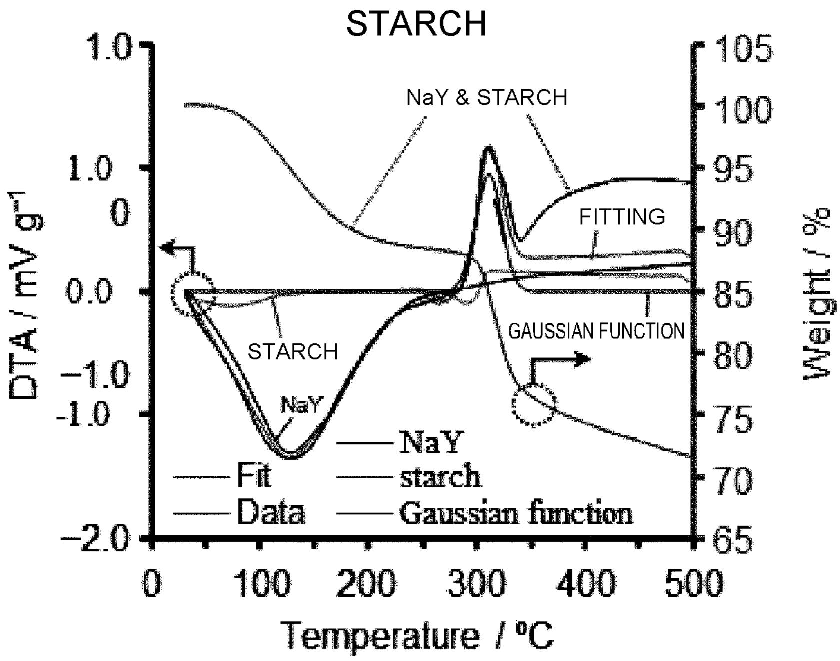
STARCH
NaY & STARCH
FITTING
GAUSSIAN FUNCTION
STARCH
NaY
Fit
Data
NaY
starch
Gaussian function
DTA / mV g⁻¹
Weight / %
Temperature / °C
1.0
1.0
0
0.0
−1.0
-1.0
−2.0
105
100
95
90
85
80
75
70
65
0
100
200
300
400
500

# FIG. 97

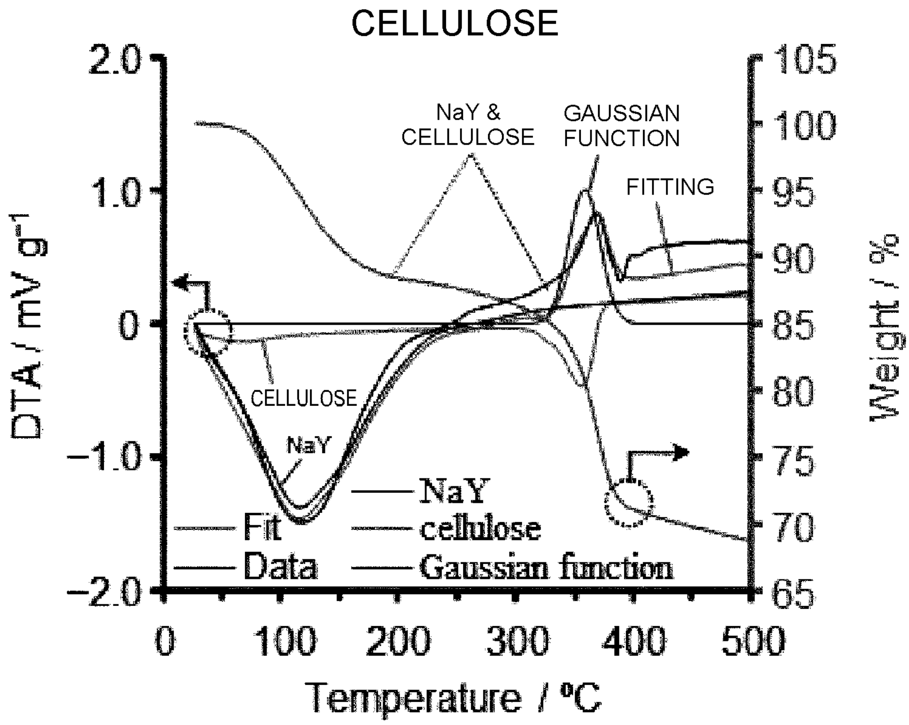
CELLULOSE
NaY & CELLULOSE
GAUSSIAN FUNCTION
FITTING
CELLULOSE
NaY
NaY
Fit
cellulose
Data
Gaussian function
DTA / mV g⁻¹
Weight / %
Temperature / °C
2.0
1.0
0
−1.0
−2.0
105
100
95
90
85
80
75
70
65
0
100
200
300
400
500

# FIG. 98

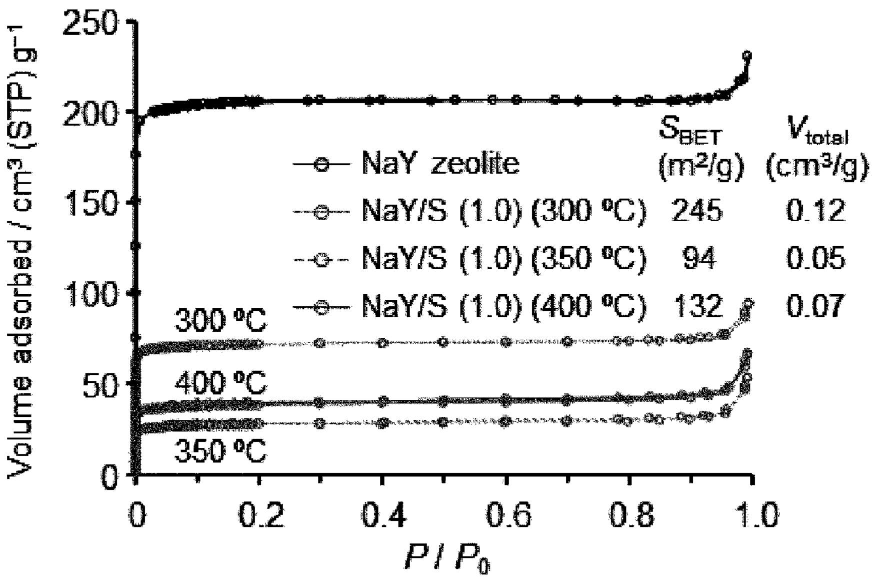
NaY zeolite
NaY/S (1.0) (300 °C)
NaY/S (1.0) (350 °C)
NaY/S (1.0) (400 °C)
S_BET (m²/g)
V_total (cm³/g)
245
0.12
94
0.05
132
0.07
300 °C
400 °C
350 °C
Volume adsorbed / cm³ (STP) g⁻¹
P / P₀
250
200
150
100
50
0
0
0.2
0.4
0.6
0.8
1.0

FIG. 99

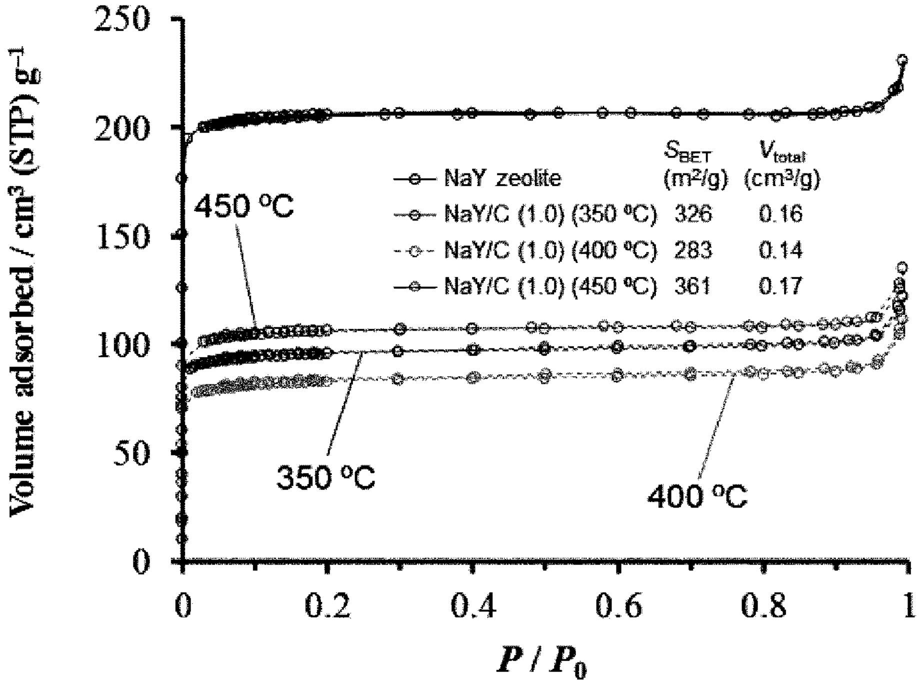
Volume adsorbed / cm³ (STP) g⁻¹
P / P0
450 °C
350 °C
400 °C
NaY zeolite
NaY/C (1.0) (350 °C) 326 0.16
NaY/C (1.0) (400 °C) 283 0.14
NaY/C (1.0) (450 °C) 361 0.17
SBET (m²/g)
Vtotal (cm³/g)
0
50
100
150
200
250
0.2
0.4
0.6
0.8
1

## INTERNATIONAL SEARCH REPORT

International application No.
**PCT/JP2022/023764**

**A. CLASSIFICATION OF SUBJECT MATTER**

***C01B 32/05***(2017.01)i
FI: C01B32/05

According to International Patent Classification (IPC) or to both national classification and IPC

**B. FIELDS SEARCHED**

Minimum documentation searched (classification system followed by classification symbols)

C01B32/00-32/991

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

JSTPlus/JMEDPlus/JST7580 (JDreamIII); JSTChina (JDreamIII)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2009-126766 A (TOYOTA CENTRAL R&D LABS., INC.) 11 June 2009 (2009-06-11) claims, paragraphs [0001], [0009], [0011], [0018]-[0023], [0039]-[0046] | 1, 3-10, 12-15<br>2, 11 |
| X | JP 2015-182939 A (NISSAN MOTOR CO., LTD.) 22 October 2015 (2015-10-22) claims, paragraphs [0001]-[0002], [0029]-[0032], [0052]-[0064], [0090] | 1-15 |
| X | JP 2010-115636 A (NISSAN MOTOR CO., LTD.) 27 May 2010 (2010-05-27) claims, paragraphs [0001], [0022]-[0035], [0044] | 1-15 |
| X | JP 2014-55110 A (NISSAN MOTOR CO., LTD.) 27 March 2014 (2014-03-27) claims, paragraphs [0022]-[0034], [0042], [0080] | 1-15 |
| X | JP 2013-173623 A (NISSAN MOTOR CO., LTD.) 05 September 2013 (2013-09-05) claims, paragraphs [0001]-[0002], [0041]-[0051], [0094] | 1-15 |

☐ Further documents are listed in the continuation of Box C.
☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 August 2022** | **23 August 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**
**Information on patent family members**

International application No.
**PCT/JP2022/023764**

| Patent document cited in search report | Publication date (day/month/year) | Patent family member(s) | Publication date (day/month/year) |
|---|---|---|---|
| JP 2009-126766 A | 11 June 2009 | (Family: none) | |
| JP 2015-182939 A | 22 October 2015 | (Family: none) | |
| JP 2010-115636 A | 27 May 2010 | US 2011-0052486 A1<br>claims, paragraphs [0001], [0022]-[0035], [0044]<br>EP 002256086 A1<br>claims, paragraphs [0001], [0022]-[0035], [0044] | |
| JP 2014-55110 A | 27 March 2014 | US 2011-0052486 A1<br>claims, paragraphs [0022]-[0034], [0042], [0088]<br>EP 0022560086 A1<br>claims, paragraphs [0022]-[0034], [0042], [0088] | |
| JP 2013-173623 A | 05 September 2013 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4263268 A
- JP 2003206112 A


### Non-patent literature cited in the description


- **TAKASHI KYOTANI et al.** Synthesis of Nano-Carbons by Using the Template Method. *TANSO,* 2008, vol. 2351, 307-315